# EUROPEAN PATENT APPLICATION

(11) **EP 4 626 206 A1**
(43) Date of publication of application: **01.10.2025**
(21) Application number: 23912669.1
(22) Date of filing: 12.12.2023
(51) Int. Cl.: H10K 85/60, C09K 11/06

(54) **ORGANIC ELECTRIC ELEMENT USING COMPOUND FOR ORGANIC ELECTRIC ELEMENT, AND ELECTRONIC DEVICE THEREOF**

(30) Priority: 28.12.2022 KR 20220187036
(71) Applicant: Duk San Neolux Co., Ltd., Chungcheongnam-do 31027 (KR)
(72) Inventor: LEE, Hyung Dong, Cheonan-si Chungcheongnam-do 31027 (KR); PARK, Jung Hwan, Cheonan-si Chungcheongnam-do 31027 (KR)
(74) Representative: Prüfer & Partner mbB Patentanwälte · Rechtsanwälte
(86) International application number: PCT/KR2023/020395
(87) International publication number: WO 2024/143994

(57) **Abstract**

The present invention provides an organic electronic device comprising a first electrode, a second electrode, and an organic layer between the first and second electrodes, and an electronic apparatus comprising the same. By using a mixture of the compounds of Formula 1 to Formula 3 of the present invention as a mixed-host in the organic layer, the driving voltage of an organic electronic device can be reduced, and the luminous efficiency and lifespan of an organic electronic device can be improved.

## Description

### Technical Field

The present invention relates to an organic electronic device using a compound for an organic electronic device and an electronic apparatus thereof, and more particularly, to an organic electronic device and an electronic apparatus thereof, in which a mixture containing three or more compounds is used as a host material in the emission layer.

### Background Art

In general, organic electroluminescence refers to a phenomenon in which electrical energy is converted into light energy by an organic material. An organic electronic device utilizing organic electroluminescence typically includes an anode, a cathode, and an organic layer interposed therebetween. In many cases, the organic layer has a multi-layered structure comprising different materials, respectively, in order to improve the efficiency and stability of an organic electronic device. For example, the organic layer may comprise a hole injection layer, a hole transport layer, an emission layer, an electron transport layer, and an electron injection layer.

The materials used in the organic layer of an organic electronic device may be classified, according to their functions, into an emission material and charge-transporting materials such as a hole-injecting material, a hole-transporting material, an electron-transporting material, and an electron-injecting material. Further, the emission material may be classified into a high molecular weight type and a low molecular weight type according to molecular weight, and may also be classified into a fluorescent material, which emits light from an excited singlet state, and a phosphorescent material, which emits light from an excited triplet state, according to its light-emission mechanism. Further, the emission material may be classified, according to its emission color, into blue, green, and red emission materials, and yellow and orange emission materials, which are required for improved natural color reproduction.

Meanwhile, when a single material is used as an emission material, problems may occur, such as a shift in the maximum emission wavelength toward a longer wavelength due to intermolecular interactions, a deterioration in color purity, or a reduction in luminous efficiency, thereby resulting in decreased efficiency of the corresponding device. Accordingly, a host/dopant system may be employed as the emission material in order to enhance color purity and improve luminous efficiency through energy transfer. This is based on the principle that, when a small amount of a dopant having a smaller energy band gap than that of a host forming the emission layer is mixed into the emission layer, excitons generated in the emission layer are transferred to the dopant, thereby enabling light emission with high efficiency. Here, since the emission wavelength of the host is shifted to the wavelength region of the dopant, light having a desired wavelength can be obtained depending on the type of the dopant.

Currently, the portable display market is expanding with the adoption of large-area displays, which require greater power consumption than conventional portable displays. Accordingly, power consumption has become a critical factor for portable displays that operate with limited battery power, and issues related to efficiency and lifespan must also be addressed.

Efficiency, lifespan, driving voltage, and the like are interrelated. An increase in efficiency may lead to a decrease in driving voltage, which in turn may reduce the crystallization of organic materials caused by Joule heating generated during device operation. As a result, the lifespan of the device may be extended. However, efficiency cannot be maximized solely by improving the organic layer. This is because both long lifespan and high efficiency can be simultaneously achieved only when an optimal combination is established among the energy levels, T₁ values, and intrinsic material properties (e.g., charge mobility, interfacial characteristics, etc.) of the respective layers constituting the organic layer.

Therefore, it is necessary to develop an emitting material that exhibits high thermal stability and can efficiently achieve charge balance in the emission layer. That is, in order to fully realize the excellent characteristics of an organic electronic device, the materials constituting the organic layer-such as hole-injecting materials, hole-transporting materials, emission materials, electron-transporting materials, and electron-injecting materials-must be based on materials that are both stable and efficient. In particular, it is necessary to develop a material for the emission layer.

### Detailed Description of the Invention

### Technical Challenge

An object of the present invention is to provide an organic electronic device and an electronic apparatus comprising the same, which can reduce the driving voltage of the device and improve the emission efficiency and lifetime of the device.

### Means of Solving Problems

In one aspect, the present invention provides an organic electronic device and an electronic apparatus comprising the same, in which a compound represented by Formula 1, a compound represented by Formula 2, and a compound represented by Formula 3 are comprised in an emission layer.

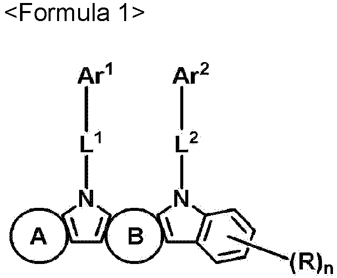

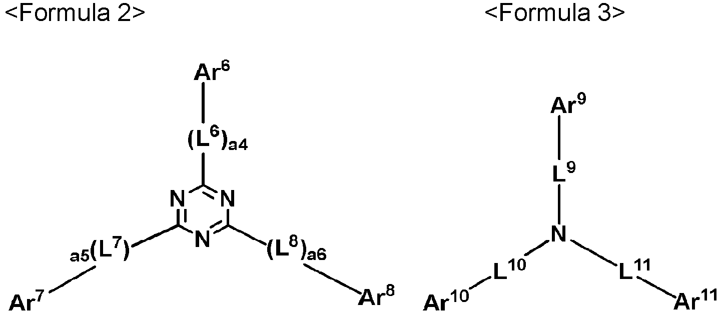

### Effect of Invention

According to the present invention, by including each of the compounds represented by Formulae 1 to 3 in an emission layer, the driving voltage of a device can be reduced, and the emission efficiency and lifetime of a device can be improved.

### BRIEF DESCRIPTION OF THE DRAWINGS

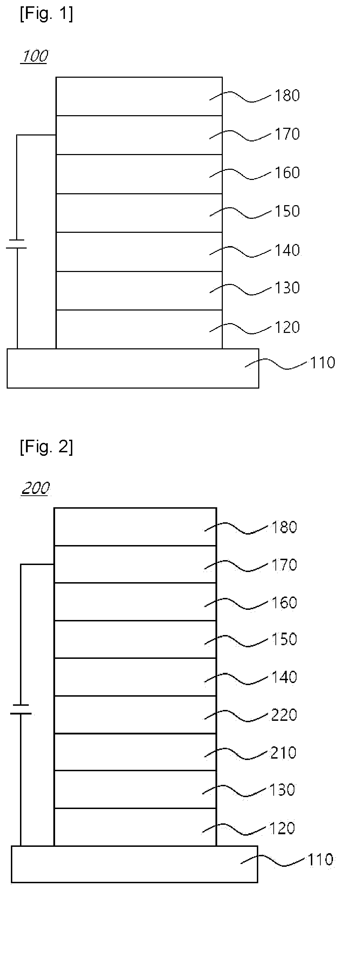

Figures 1 to 3 illustrate an example of organic electroluminescent device according to the present invention.

**[Description of Reference Numerals]**

| | | | |
|---|---|---|---|
| 100, 200, 300: | organic electronic device | 110: | first electrode |
| 120: | hole injection layer | 130: | hole transport layer |
| 140: | emission layer | 150: | electron transport layer |
| 160: | electron injection layer | 170: | second electrode |
| 180: | layer for improving light efficiency | 210: | buffer layer |
| 220: | emission-auxiliary layer | 320: | first hole injection layer |
| 330: | first hole transport layer | 340: | first emission layer |
| 350: | first electron transport layer | 360: | first charge-generation layer |
| 361: | second charge-generation layer | 420: | second hole injection layer |
| 430: | second hole transport layer | 440: | second emission layer |
| 450: | second electron transport layer | CGL: | charge generation layer |
| ST1: | first stack | ST2: | second stack |

### DETAILED DESCRIPTION

Unless otherwise stated, the term "aryl group" or "arylene group" as used herein refers to a group having 6 to 60 carbon atoms, but is not limited thereto. The aryl group or arylene group in the present invention may comprise a monocyclic ring, ring assemblies, a fused polycyclic system, a spiro compound, and the like.

As used herein, the term "fluorenyl group" refers to a fluorenyl moiety that may be substituted or unsubstituted, and the term "fluorenylene group" refers to a fluorenylene moiety that may be substituted or unsubstituted. The fluorenyl group or fluorenylene group employed in the present invention may comprise a spiro compound in which R and R' are bonded to each other in the structure shown below, and may also comprise compounds in which adjacent R" groups are linked together. The terms "substituted fluorenyl group" and "substituted fluorenylene group" mean that at least one of R, R', or R" in the following structure is a substituent other than hydrogen. In the following structure, the number of R" groups may range from 1 to 8. Throughout this specification, the fluorenyl group and fluorenylene group may collectively be referred to as a "fluorene group" or "fluorene," regardless of their valence.

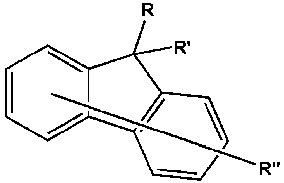

As used herein, the term "spiro compound" refers to a compound having a spiro linkage, which is a structure in which two rings are connected through a single common atom. The atom shared by the two rings is referred to as a "spiro atom," and the compound may be classified as a monospiro, dispiro, or trispiro compound depending on the number of spiro atoms present in the molecule.

As used herein, the term "heterocyclic group" comprises both aromatic rings, such as a "heteroaryl group" or a "heteroarylene group," and non-aromatic rings. Unless otherwise specified, the "heterocyclic group" refers to a ring structure containing one or more heteroatoms and having from 2 to 60 carbon atoms, but is not limited thereto. The term "heteroatom," as used herein, refers to atoms such as nitrogen (N), oxygen (O), sulfur (S), phosphorus (P), or silicon (Si), and may also include heteroatomic groups such as SO₂, P=O, and the like, which can replace a carbon atom in the ring structure as shown in the following compound. The "heterocyclic group" may comprise monocyclic ring, ring assemblies, fused polycyclic system, a spiro compound, and the like.

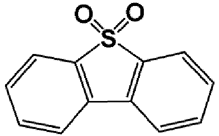

As used herein, the term "aliphatic ring group" refers to a cyclic hydrocarbon excluding aromatic hydrocarbons, and comprises, but is not limited to, monocyclic rings, ring assemblies, fused polycyclic systems, spiro compounds, and the like. Unless otherwise specified, the aliphatic ring group may comprise a ring having from 3 to 60 carbon atoms. For example, a fused ring system composed of benzene, which is an aromatic ring, and cyclohexane, which is a non-aromatic ring, corresponds to an aliphatic ring group.

**The** terms "alkyl halide," "halogen alkyl group," or "halo alkyl group," as used in the present invention refer to an alkyl group substituted with a halogen, unless otherwise specified. For example, it refers to an alkyl group in which some or all of the hydrogen atoms are replaced with halogen atoms.

**In** this specification, the 'group name' corresponding to an aryl group, an arylene group, a heterocyclic group, and the like, exemplified for each symbol and its substituent, may be expressed either as 'a functional group name reflecting the valence' or as 'the name of a parent compound'. For example, in the case of 'phenanthrene,' which is a type of aryl group, it may be described as 'phenanthryl' when referring to a monovalent group, and as 'phenanthrylene' when referring to a divalent group. Alternatively, it may also be described by its parent compound name 'phenanthrene,' regardless of valence. Similarly, in the case of pyrimidine, it may be referred to as 'pyrimidine' regardless of its valence. Alternatively, it may be described by the name of the corresponding functional group, such as 'pyrimidinyl' for a monovalent group and 'pyrimidinylene' for a divalent group.

In addition, in the present specification, numerical and alphabetical indicators of positions may be omitted when describing the name of a compound or a substituent. For example, compounds such as pyrido[4,3-d]pyrimidine, benzofuro[2,3-d]pyrimidine, and 9,9-dimethyl-9H-fluorene may be described in a simplified manner as pyridopyrimidine, benzofurropyrimidine, and dimethylfluorene, respectively. Accordingly, both benzo[g]quinoxaline and benzo[f]quinoxaline may be generally referred to as benzoquinoxaline.

In addition, unless otherwise specified, when any compound according to the present invention is represented by the following formula, each substituent corresponding to the respective index is defined as described below.

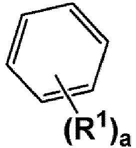

In the above formula, when a is zero, the substituent R¹ is absent, meaning that hydrogen atoms are bonded to all carbon atoms constituting the benzene ring. Here, chemical structures or compounds may be represented without explicitly indicating hydrogen atoms bonded to carbon atoms. In addition, when a is an integer of 1, one substituent R¹ is bonded to one of the carbon atoms constituting the benzene ring. When a is 2 or 3, the substituents may be bonded as exemplified below. In the case where a is an integer from 4 to 6, the substituents are similarly bonded to the carbon atoms of the benzene ring. Further, when a is greater than or equal to 2, the substituents R¹ may be identical or different from each other.

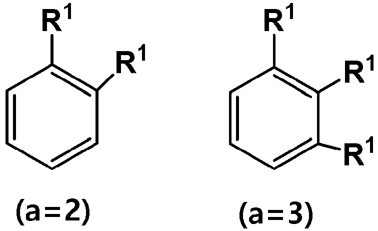

In addition, unless otherwise specified in the specification, the term 'ring' refers to an aryl ring, heteroaryl ring, fluorene ring, aliphatic ring, etc., and a numbermembered(atom) ring may refer to the shape of a ring. For example, naphthalene corresponds to a two-fused(condensed) ring, anthracene to a three-fused(condensed) ring, thiophene or furan corresponds to a five-membered ring, and benzene or pyridine corresponds to a six-membered ring.

In addition, unless otherwise specified in the present specification, when adjacent groups are linked to each other to form a ring, the ring may be selected from the group consisting of a C₆-C₆₀ aromatic ring group, a fluorenyl group, a C₂-C₆₀ heterocyclic group containing at least one heteroatom selected from O, N, S, Si, and P, and a C₃-C₆₀ aliphatic ring group. Here, the aromatic ring group may comprise an aryl ring, and the heterocyclic group may comprise a heteroaryl ring.

Unless otherwise specified, the term 'adjacent groups,' as used herein, comprises not only the relationships such as R₁ and R₂, R₂ and R₃, R₃ and R₄, and R₅ and R₆ but also R₇ and R₈ sharing a common carbon atom. It may further comprise cases substituents attached to different ring-forming atoms (e.g., carbon or nitrogen), such as R₁ and R₇, R₁ and R₈, or R₄ and R₅. That is, even when substituents are not directly adjacent on the same atom, one substituent may be considered adjacent to another substituent attached to a neighboring ring-forming atom. Additionally, substituents bonded to the same carbon atom forming the ring may also be regarded as adjacent groups. In the following Formula, when substituents such as R₇ and R₈, which are bonded to the same carbon atom, are connected to form a ring, a compound containing a spiro moiety may be generated.

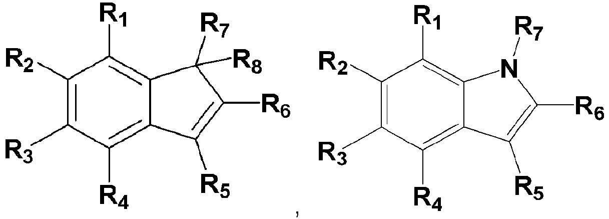

In addition, in the present specification, the expression 'adjacent groups may be linked to each other to form a ring' is used in the same sense as 'adjacent groups are selectively linked to each other to form a ring,' and refers to a case where at least one pair of adjacent groups may be bonded to form a ring structure.

In addition, unless otherwise specified in the present specification, substituents such as an aryl group, an arylene group, a fluorenyl group, a fluorenylene group, a heterocyclic group, an aliphatic ring group, an alkyl group, an alkenyl group, an alkynyl group, an alkoxyl group, an aryloxyl group, alkylthio group, arylthio group, etc., and a ring formed by adjacent groups may be each optionally substituted with one or more substituents selected from the group consisting of deuterium, halogen, a cyano group, a nitro group, siloxane group, a C₆-C₃₀ aryl group, a fluorenyl group, a C₂-C₃₀ heterocyclic group containing at least one heteroatom of O, N, S, Si and P, a C₃-C₃₀ aliphatic ring group, a C₁-C₂₀ alkyl group, a C₂-C₂₀ alkenyl group, a C₂-C₂₀ alkynyl group, a C₁-C₂₀ alkoxyl group, a C₆-C₂₀ aryloxy group, a C₁-C₂₀ alkylthio group, a C₆-C₂₀ arylthio group, a silane group unsubstituted or substituted with a C₁-C₂₀ alkyl group or a C₆-C₂₀ aryl group, and a phosphine oxide group unsubstituted or substituted with a C₁-C₂₀ alkyl group or a C₆-C₂₀ aryl group.

Hereinafter, with reference to Figures 1 to 3, the laminated structure of an organic electronic device comprising the compound according to the present invention will be described.

In the designation of reference numerals for components in the respective drawings, it should be understood that the same elements are denoted by the same reference numerals, even if they appear in different drawings. Furthermore, in the following description of the present invention, detailed explanations of well-known functions and configurations will be omitted where they may unnecessarily obscure the essence of the invention.

Terms such as "first," "second," "A," "B," "(a)," "(b)," and the like may be used to describe various components of the present invention. These terms are merely intended to distinguish one component from another and do not imply any particular order, importance, or essential characteristics. Furthermore, it should be understood that when a component is described as being "connected," "coupled," or "joined" to another component, this may include both direct connections as well as indirect connections through one or more intervening components.

Additionally, it is to be understood that when an element such as a layer, film, region, or substrate is described as being "on" or "over" another element, it may be positioned directly on the other element or with one or more intervening layers therebetween. In contrast, the expression "directly on" indicates that no intervening elements are present between the two elements.

Figures 1 to 3 respectively illustrate examples of an organic electronic device according to embodiments of the present invention.

Referring to FIG. 1, an organic electronic device 100 according to an embodiment of the present invention comprises a first electrode 110, a second electrode 170, and an organic layer disposed between the first electrode 110 and the second electrode 170 on a substrate (not shown). **In** some embodiments, an inorganic layer may also be interposed between the first electrode 110 and the second electrode 170.

For example, the first electrode 110 may function as an anode (positive electrode), and the second electrode 170 may function as a cathode (negative electrode). In an inverted organic electronic device, however, the first electrode may serve as a cathode, while the second electrode may serve as an anode.

The organic layer refers to a layer comprising at least one organic material. For example, the organic layer may include a hole injection layer 120, a hole transport layer 130, an emission layer 140, an electron transport layer 150, and an electron injection layer 160. In certain embodiments, the electron injection layer 160 may be an inorganic layer that does not contain any organic material.

Specifically, a hole injection layer 120, a hole transport layer 130, an emission layer 140, an electron transport layer 150, and an electron injection layer 160 may be sequentially formed on the first electrode 110.

Preferably, a layer for improving the luminous efficiency 180 may be formed on one side of the first electrode 110 or the second electrode 170, wherein the one side does not face the organic layer or inorganic layer. When the layer for improving the luminous efficiency 180 is formed, the luminous efficiency of the organic electronic device can be enhanced.

For example, the layer for improving the luminous efficiency 180 may be formed on the second electrode 170. As a result, in the case of a top-emission organic light emitting device, optical energy loss due to surface plasmon polaritons (SPPs) at the second electrode 170 may be reduced. In the case of a bottom-emission organic light emitting device, the layer for improving the luminous efficiency 180 may function as a buffer layer for the second electrode 170.

A buffer layer 210 or an emission-auxiliary layer 220 may additionally be formed between the hole transport layer 130 and the emission layer 140, as will be described with reference to FIG. 2.

Referring to FIG. 2, an organic electronic device 200 according to another embodiment of the present invention may sequentially include a hole injection layer 120, a hole transport layer 130, a buffer layer 210, an emission-auxiliary layer 220, an emission layer 140, an electron transport layer 150, an electron injection layer 160, and a second electrode 170 on a first electrode 110, and a layer for improving the luminous efficiency 180 may be formed on the second electrode.

Although not illustrated in FIG. 2, an electron transport auxiliary layer may additionally be formed between the emission layer 140 and the electron transport layer 150.

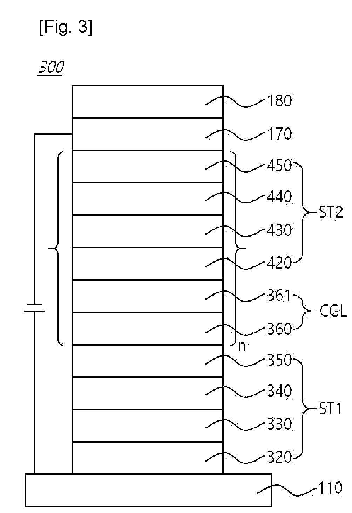

In addition, according to another embodiment of the present invention, the organic layer may be in the form of multiple stacks, each of which includes a hole transport layer, an emission layer, and an electron transport layer. This will be described with reference to FIG. 3.

Referring to FIG. 3, in an organic electronic device 300 according to another embodiment of the present invention, two or more stacks of organic layers, ST1 and ST2, may be formed between the first electrode 110 and the second electrode 170. Each stack may include multiple organic layers, and a charge generation layer (CGL) may be formed between the stacks.

Specifically, the organic electronic device according to the embodiment of the present invention may comprise a first electrode 110, a first stack ST1, a charge generation layer CGL, a second stack ST2, and a second electrode 170 and a layer for improving light efficiency 180.

The first stack ST1 is an organic layer formed on the first electrode 110, and may comprise a first hole injection layer 320, a first hole transport layer 330, a first emission layer 340, and a first electron transport layer 350. The second stack ST2 may comprise a second hole injection layer 420, a second hole transport layer 430, a second emission layer 440, and a second electron transport layer 450. As such, the first stack and the second stack may have the same or different stacked structures of organic layers.

The charge generation layer CGL may be formed between the first stack ST1 and the second stack ST2. The charge generation layer CGL may comprise a first charge generation layer 360 and a second charge generation layer 361. It is positioned between the first emission layer 340 and the second emission layer 440 to enhance the current efficiency of each emission layer and facilitate charge distribution.

The first emission layer 340 may comprise an emission material that comprises a blue host doped with a blue fluorescent dopant, and the second emission layer 440 may comprise an emission material that comprises a green host doped with both a greenishyellow dopant and a red dopant. However, the materials of the first emission layer 340 and the second emission layer 440 according to an embodiment of the present invention are not limited thereto.

In FIG. 3, n may be an integer from 1 to 5, and when n is 2, a charge generation layer (CGL) and a third stack may be additionally formed on the second stack ST2.

When a plurality of emission layers are formed in a multi-layer stack structure as shown in FIG. 3, it is possible to manufacture an organic electroluminescent element that emits not only white light but also various colors, where the white light is produced by the mixing of light emitted from each emission layer.

Compound(s) represented by Formulae 1 to 3 of the present invention may be included in an organic layer. For example, the compounds represented by Formula 1 to 3 of the present invention can be used as a material for a hole injection layer 120, 320, 420, a hole transport layer 130, 330, 430, a buffer layer 210, an emission-auxiliary layer 220, an electron transport layer 150, 350, 450, an emission layer 140, 340, 440, and/or a light efficiency improving layer 180. More preferably, they may be used as a host material in the emission layers 140, 340, or 440.

Even if the cores of the compounds are identical or similar, their band gaps, electronic properties, and interfacial characteristics may vary depending on which substituents are bonded and at which positions. Therefore, it is necessary to study the selection of the core structure and the combination with sub-substituents attached to the core. In particular, a long lifespan and high efficiency can be achieved simultaneously when the optimal combination of energy levels, T1 values, and intrinsic material properties (such as mobility and interfacial characteristics) is realized among the layers of the organic structure.

Therefore, by using each compound represented by Formulae 1 to 3 as a material for the emission layers 140, 340, and 440, it is possible to optimize the energy levels and T1 values, intrinsic material properties (such as mobility and interfacial characteristics) between the respective layers of the organic layer, as a result, the lifetime and efficiency of an organic electronic device can be simultaneously improved.

The organic electronic device according to an embodiment of the present invention may be fabricated using various deposition methods, comprising physical vapor deposition (PVD) or chemical vapor deposition (CVD). For example, the organic electronic device may be manufactured by forming the anode 110 on the substrate by depositing a metal, a conductive metal oxide, or a mixture thereof, then forming an organic layer comprising the hole injection layer 120, the hole transport layer 130, the emission layer 140, the electron transport layer 150, and the electron injection layer 160 thereon, and finally depositing a material that can be used as the cathode 170. In addition, an emission-auxiliary layer 220 may be formed between the hole transport layer 130 and the emission layer 140, an electron transport auxiliary layer (not shown) may additionally be formed between the emission layer 140 and the electron transport layer 150, and as described above, these layers may constitute a stacked structure.

In addition, the organic layer may be manufactured with fewer layers by using various polymer materials through a solution process or solvent-based process, such as spin coating, nozzle printing, inkjet printing, slot coating, dip coating, roll-to-roll, doctor blading, screen printing, or thermal transfer, instead of deposition. Since the organic layer according to the present invention may be formed in various ways, the scope of protection of the present invention is not limited by the method of forming the organic layer.

The organic electronic device according to an embodiment of the present invention may be a top-emission type, a bottom-emission type, or a dual-emission type, depending on the materials used.

In addition, the organic electronic device according to an embodiment of the present invention may be selected from the group consisting of an organic electroluminescent device, an organic solar cell, an organic photoconductor, an organic transistor, a monochromatic illumination device, and a quantum dot display device.

Another embodiment of the present invention provides an electronic apparatus comprising a display device including the above-described organic electronic device and a control unit for controlling the display device. The electronic apparatus may be a wired or wireless communication terminal currently in use or to be developed in the future, and comprises all types of electronic devices, such as mobile communication terminals (e.g., cellular phones), navigation units, game players, various types of TVs, and computers.

Hereinafter, an organic electronic device according to one aspect of the present invention will be described.

An organic electronic device according to one aspect of the present invention comprises a first electrode, a second electrode, and an organic layer formed between the first electrode and the second electrode, wherein the organic layer comprises an emission layer, and the emission layer comprises compound represented by Formula 1, compound represented by Formula 2 and compound represented by Formula 3.

Preferably, host of an emission layer may comprise compounds represented by Formulae 1 to 3. For example, a first host may be a compound of Formula 1, a second host may be a compound of Formula 2, and a third host may be a compound of Formula 3, and host may comprise three or more types of compounds.

Hereinafter, Formula 1 to Formula 3 will be described.

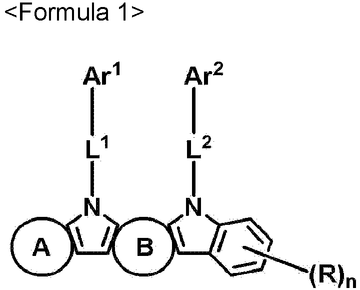

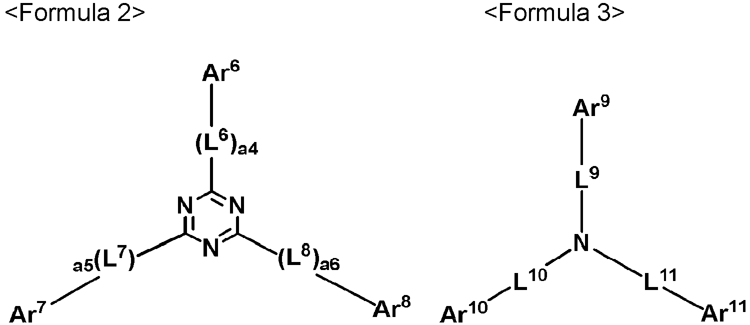

In Formula 1 to Formula 3, each of symbols may be defined as follows.

Ring A and ring B are each independently a C₆-C₂₀ aryl ring, wherein at least one of ring A and ring B is a C₁₀ or greater aryl ring, and ring A and ring B may each be substituted with one or more R₁.

For example, the ring A and ring B may be a C₆-C₂₀, a C₆-C₁₈, a C₆-C₁₆, a C₆-C₁₄, a C₆-C₁₀, a C₆, a C₁₀, a C₁₂, a C₁₄, a C₁₆, or a C₁₈ aryl ring, specifically, benzene, naphthalene, anthracen, phenanthrene, triphenylene, etc.

R and R¹ are each independently selected from the group consisting of hydrogen, deuterium, halogen, a cyano group, a nitro group, a C₆-C₆₀ aryl group, a fluorenyl group, a C₂-C₆₀ heterocyclic group containing at least one heteroatom of O, N, S, Si and P, a C₃-C₆₀ aliphatic ring group, a C₁-C₂₀ alkyl group, a C₂-C₂₀ alkenyl group, a C₂-C₂₀ alkynyl group, a C₁-C₂₀ alkoxyl group, and a C₆-C₆₀ aryloxy group, and adjacent groups may be bonded to each other to form a ring.

n is an integer from 0 to 4, and when n is integer of 2 or more, each of the plurality of R may be the same as or different from one another.

When adjacent groups, for example, adjacent R groups are bonded to each other to form a ring, the ring selected from the group consisting of a C₆-C₆₀ aromatic ring group, a fluorenylene group, a C₃-C₆₀ heterocyclic group containing at least one heteroatom of O, N, S, Si, P and Se, and a C₆-C₆₀ aliphatic ring.

When adjacent R groups are bonded to each other to form an aromatic ring, the aromatic ring may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, or a C₁₈ aromatic ring, specifically, an aryl ring such as benzene, naphthalene, anthracene, phenanthrene, pyrene, etc.

Ar¹ and Ar² each independently selected from the group consisting of a C₆-C₆₀ aryl group, a fluorenyl group, a C₃-C₆₀ aliphatic ring group, and a C₂-C₆₀ heterocyclic group containing at least one heteroatom of O, N, S, Si and P.

L¹ and L² are each independently selected from the group consisting of a single bond, a C₆-C₆₀ arylene group, a fluorenylene group, a C₃-C₆₀ aliphatic ring group, and a C₂-C₃₀ heterocyclic group containing at least one heteroatom of O, N, S, Si and P.

Ar⁶ to Ar⁸ are each independently a C₆-C₆₀ aryl group.

L⁶ to L⁸ are each independently a single bond or a C₆-C₆₀ arylene group.

a4 to a6 are each independently integers from 0 to 3, and when any of them is an integer of 2 or more, each of the plurality of L⁶, each of the plurality of L⁷, and each of the plurality of L⁸ may be the same as or different from one another.

Ar⁹ to Ar¹¹ are each independently selected from the group consisting of a C₆-C₆₀ aryl group, a fluorenyl group, a C₃-C₆₀ aliphatic ring group, a C₂-C₆₀ heterocyclic group containing at least one heteroatom of O, N, S, Si and P, a C₁-C₂₀ alkyl group, and -L¹²-N(Ar^{a})(Ar^{b}).

L⁹ to L¹² are each independently selected from the group consisting of a single bond, a C₆-C₆₀ arylene group, a fluorenylene group, a C₃-C₆₀ aliphatic ring group, and a C₂-C₆₀ heterocyclic group containing at least one heteroatom of O, N, S, Si and P.

Ar^{a} and Ar^{b} are each independently selected from the group consisting of a C₆-C₆₀ aryl group, a fluorenyl group, a C₃-C₆₀ aliphatic ring group, and a C₂-C₆₀ heterocyclic group containing at least one heteroatom of O, N, S, Si and P.

When at least one of Ar¹, Ar², Ar⁶ to Ar¹¹, R, R₁, Ar^{a}, Ar^{b} is an aryl group, the aryl group may be, for example, a C₆-C₃₀, a C₆-C₂₉, a C₆-C₂₈, a C₆-C₂₇, a C₆-C₂₆, a C₆-C₂₅, a C₆-C₂₄, a C₆-C₂₃, a C₆-C₂₂, a C₆-C₂₁, a C₆-C₂₀, a C₆-C₁₉, a C₆-C₁₈, a C₆-C₁₇, a C₆-C₁₆, a C₆-C₁₅, a C₆-C₁₄, a C₆-C₁₃, a C₆-C₁₂, a C₆-C₁₁, a C₆-C₁₀, a C₆, a C₁₀, a C₁₂, a C₁₃, a C₁₄, a C₁₅, a C₁₆, a C₁₇, or a C₁₈ aryl group, specifically, phenyl, biphenyl, naphthyl, terphenyl, phenanthrene, triphenylene, or the like.

When at least one of L¹, L², L⁶ to L¹² is an arylene group, the arylene group may be, for example, a C₆-C₃₀, a C₆-C₂₉, a C₆-C₂₈, a C₆-C₂₇, a C₆-C₂₆, a C₆-C₂₅, a C₆-C₂₄, a C₆-C₂₃, a C₆-C₂₂, a C₆-C₂₁, a C₆-C₂₀, a C₆-C₁₉, a C₆-C₁₈, a C₆-C₁₇, a C₆-C₁₆, a C₆-C₁₅, a C₆-C₁₄, a C₆-C₁₃, a C₆-C₁₂, a C₆-C₁₁, a C₆-C₁₀, a C₆, a C₁₀, a C₁₂, a C₁₃, a C₁₄, a C₁₅, a C₁₆, a C₁₇, or a C₁₈ arylene group, specifically, phenylene, biphenyl, naphthylene, terphenyl, phenanthrene, triphenylene, or the like.

When at least one of Ar¹, Ar², Ar⁹ to Ar¹¹, Ar^{a}, Ar^{b}, R, R₁, L¹, L², L⁹ to L¹² is a heterocyclic group, the heterocyclic group may be, for example, a C₂-C₃₀, a C₂-C₂₉, a C₂-C₂₈, a C₂-C₂₇, a C₂-C₂₆, a C₂-C₂₅, a C₂-C₂₄, a C₂-C₂₃, a C₂-C₂₂, a C₂-C₂₁, a C₂-C₂₀, a C₂-C₁₉, a C₂-C₁₈, a C₂-C₁₇, a C₂-C₁₆, a C₂-C₁₅, a C₂-C₁₄, a C₂-C₁₃, a C₂-C₁₂, a C₂-C₁₁, a C₂-C₁₀, a C₂-C₉, a C₂-C₈, a C₂-C₇, a C₂-C₆, a C₂-C₅, a C₂-C₄, a C₂-C₃, a C₂, a C₃, a C₄, a C₅, a C₆, a C₇, a C₈, a C₉, a C₁₀, a C₁₁, a C₁₂, a C₁₃, a C₁₄, a C₁₅, a C₁₆, a C₁₇, a C₁₈, a C₁₉, a C₂₀, a C₂₁, a C₂₂, a C₂₃, a C₂₄, a C₂₅, a C₂₆, a C₂₇, a C₂₈, or a C₂₉ heterocyclic group, specifically, pyridine, pyrimidine, pyrazine, pyridazine, triazine, furan, pyrrole, indene, indole, phenyl-indole, benzoindole, phenyl-benzoindole, pyrazinoindol, quinoline, isoquinoline, benzoquinoline, pyridoquinoline, quinazoline, benzoquinazoline, dibenzoquinazoline, phenanthroquinazoline, quinoxaline, benzoquinoxaline, dibenzoquinoxaline, benzofuran, naphthobenzofuran, dibenzofuran, dinaphthofuran, thiophene, benzothiophene, dibenzothiophene, naphthobenzothiophene, dinaphthothiophene, carbazole, phenyl-carbazole, benzocarbazole, phenylbenzocarbazole, naphthyl-benzocarbazole, dibenzocarbazole, indolocarbazole, benzofuropyridine, benzothienopyridine, benzothienopyrimidine, benzofuropyrimidine, benzothienopyrazine, benzofuropyrazine, benzoimidazole, benzothiazole, benzooxazole, benzosiloe, phenanthroline, dihydro-phenylphenazine, 10-phenyl-10H-phenoxazine, phenoxazine, phenothiazine, dibenzodioxin, benzodibenzodioxin, thianthrene, 9,9-dimethyl-9H-xanthene, 9,9-dimethyl-9H-thioxanthene, dihydrodimethylphenylacridine, spiro[fluorene-9,9'-xanthene], dibenzoselenophene, benzophosphindole and the like.

When at least one of Ar¹, Ar², Ar⁹ to Ar¹¹, Ar^{a}, Ar^{b}, R, R₁, L¹, L², L⁹ to L¹² is an aliphatic ring group, the aliphatic ring group, may be, for example, a C₃-C₃₀, a C₃-C₂₉, a C₃-C₂₈, a C₃-C₂₇, a C₃-C₂₆, a C₃-C₂₅, a C₃-C₂₄, a C₃-C₂₃, a C₃-C₂₂, a C₃-C₂₁, a C₃-C₂₀, a C₃-C₁₉, a C₃-C₁₈, a C₃-C₁₇, a C₃-C₁₆, a C₃-C₁₅, a C₃-C₁₄, a C₃-C₁₃, a C₃-C₁₂, a C₃-C₁₁, a C₃-C₁₀, a C₃-C₈, a C₃-C₆, a C₆, a C₁₀, a C₁₁, a C₁₂, a C₁₃, a C₁₄, a C₁₅, a C₁₆, a C₁₇ or a C₁₈ aliphatic ring group, specifically, a cyclopentanyl group, indenyl group, tetralin group, a cyclohexanyl group, a norbornyl group, an adamantyl group, etc.

When at least one of Ar¹, Ar², Ar⁹ to Ar¹¹, Ar^{a}, Ar^{b}, R, R¹ is a fluorenyl group, or when at least one of L¹, L², L⁹ to L¹¹ is a fluorenylene group, the fluorenyl group or the fluorenylene group may be 9,9-dimethyl-9H-fluorene, 9,9-diphenyl-9H-fluorene, 9,9'-spirobifluorene, spiro[benzo[b]fluorene-11,9'-fluorene], benzo[b]fluorene, 11,11-diphenyl-11H-benzo[b]fluorene, or 9-(naphthalen-2-yl)-9-phenyl-9H-fluorene.

In the above Formulae 1 to 3, Ar¹, Ar², Ar⁶ to Ar¹¹, Ar^{a}, Ar^{b}, L¹, L², L⁶ to L¹², R, R₁, the ring formed by adjacent groups may each be substituted with substituent. For example, when at least one of Ar¹, Ar², Ar⁶ to Ar¹¹, Ar^{a}, Ar^{b}, L¹, L², L⁶ to L¹², R, R₁, the ring formed by adjacent groups is a substituent containing H, the H may be replaced with another substituent.

Ar¹, Ar², Ar⁹ to Ar¹¹, Ar^{a}, Ar^{b}, L¹, L², L⁹ to L¹², R, R₁, the ring formed by adjacent groups may be each substituted with one or more substituents selected from the group consisting of deuterium, halogen, a silane group unsubstituted or substituted with a C₁-C₂₀ alkyl group or a C₆-C₂₀ aryl group, a phosphine oxide substituted or unsubstituted with a C₁-C₂₀ alkyl group or a C₆-C₂₀ aryl group, siloxane group, a cyano group, a nitro group, a C₁-C₂₀ alkylthio group, a C₁-C₂₀ alkoxy group, a C₆-C₃₀ aryloxy group, a C₆-C₃₀ arylthio group, a C₁-C₂₀ alkyl halide group, a C₁-C₂₀ alkyl group, a C₂-C₂₀ alkenyl group, a C₂-C₂₀ alkynyl group, a C₆-C₃₀ aryl group, a C₆-C₃₀ aryl group substituted with deuterium, a fluorenyl group, a C₂-C₃₀ heterocyclic group comprising at least one heteroatom selected from the group consisting of O, N, S, Si and P, and a C₃-C₃₀ aliphatic ring group.

In addition, Ar⁶ to Ar⁸, L⁶ to L⁸ may be each substituted with one or more substituents selected from the group consisting of deuterium, a cyano group, a C₆-C₃₀ aryl group, and a C₆-C₃₀ aryl group substituted with deuterium.

When at least one of Ar¹, Ar², Ar⁶ to Ar¹¹, Ar^{a}, Ar^{b}, L¹, L², L⁶ to L¹², R, R₁, and the ring formed by adjacent groups is substituted with an aryl group, the aryl group may be, for example, a C₆-C₃₀, a C₆-C₂₉, a C₆-C₂₈, a C₆-C₂₇, a C₆-C₂₆, a C₆-C₂₅, a C₆-C₂₄, a C₆-C₂₃, a C₆-C₂₂, a C₆-C₂₁, a C₆-C₂₀, a C₆-C₁₉, a C₆-C₁₈, a C₆-C₁₇, a C₆-C₁₆, a C₆-C₁₅, a C₆-C₁₄, a C₆-C₁₃, a C₆-C₁₂, a C₆-C₁₁, a C₆-C₁₀, a C₆, a C₁₀, a C₁₂, a C₁₃, a C₁₄, a C₁₅, a C₁₆, a C₁₇, or a C₁₈ aryl group.

When at least one of Ar¹, Ar², Ar⁹ toAr¹¹, L¹, L², L⁹ to L¹¹, R, R₁, and the ring formed by adjacent groups is substituted with an aliphatic ring group, the aliphatic ring group may be, for example, a C₃-C₃₀, a C₃-C₂₉, a C₃-C₂₈, a C₃-C₂₇, a C₃-C₂₆, a C₃-C₂₅, a C₃-C₂₄, a C₃-C₂₃, a C₃-C₂₂, a C₃-C₂₁, a C₃-C₂₀, a C₃-C₁₉, a C₃-C₁₈, a C₃-C₁₇, a C₃-C₁₆, a C₃-C₁₅, a C₃-C₁₄, a C₃-C₁₃, a C₃-C₁₂, a C₃-C₁₁, a C₃-C₁₀, a C₃-C₈, a C₃-C₆, a C₆, a C₁₀, a C₁₁, a C₁₂, a C₁₃, a C₁₄, a C₁₅, a C₁₆, a C₁₇ or a C₁₈ aliphatic ring group.

When at least one of Ar¹, Ar², Ar⁹ to Ar¹¹, Ar^{a}, Ar^{b}, L¹, L², L⁹ to L¹², R, R₁, and the ring formed by adjacent groups is substituted with a heterocyclic group, the heterocyclic group may be, for example, a C₂-C₃₀, a C₂-C₂₉, a C₂-C₂₈, a C₂-C₂₇, a C₂-C₂₆, a C₂-C₂₅, a C₂-C₂₄, a C₂-C₂₃, a C₂-C₂₂, a C₂-C₂₁, a C₂-C₂₀, a C₂-C₁₉, a C₂-C₁₈, a C₂-C₁₇, a C₂-C₁₆, a C₂-C₁₅, a C₂-C₁₄, a C₂-C₁₃, a C₂-C₁₂, a C₂-C₁₁, a C₂-C₁₀, a C₂-C₉, a C₂-C₈, a C₂-C₇, a C₂-C₆, a C₂-C₅, a C₂-C₄, a C₂-C₃, a C₂, a C₃, a C₄, a C₅, a C₆, a C₇, a C₈, a C₉, a C₁₀, a C₁₁, a C₁₂, a C₁₃, a C₁₄, a C₁₅, a C₁₆, a C₁₇, a C₁₈, a C₁₉, a C₂₀, a C₂₁, a C₂₂, a C₂₃, a C₂₄, a C₂₅, a C₂₆, a C₂₇, a C₂₈, or a C₂₉ heterocyclic group.

When at least one of Ar¹, Ar², Ar⁹ toAr¹¹, L¹, L², L⁹ to L¹¹, R, R₁, and the ring formed by adjacent groups is substituted with a fluorenyl group, the fluorenyl group may be 9,9-dimethyl-9H-fluorene, 9,9-diphenyl-9H-fluorene, 9,9'-spirobifluorene, spiro[benzo[b]fluorene-11,9'-fluorene], benzo[b]fluorene, 11,11-diphenyl-11H-benzo[b]fluorene, or 9-(naphthalen-2-yl)-9-phenyl-9H-fluorene.

When at least one of Ar¹, Ar², Ar⁹ to Ar¹¹, L¹, L², L⁹ to L¹¹, R, R₁, and the ring formed by adjacent groups is substituted with an alkyl group, the alkyl group may be, for example, a C₁-C₂₀, a C₁-C₁₀, a C₁-C₄, a C₁, a C₂, a C₃, or a C₄ alkyl group, for example, methyl, ethyl, t-butyl, etc.

When at least one of Ar¹, Ar², Ar⁹ toAr¹¹, L¹, L², L⁹ to L¹¹, R, R₁, and the ring formed by adjacent groups is substituted with an alkyl halide group, the alkyl halide group may be, for example, a C₁-C₂₀, a C₁-C₁₀, a C₁-C₄, a C₁, a C₂, a C₃, or a C₄ alkyl halide group, for example, trifluoromethyl group.

When at least one of Ar¹, Ar², Ar⁹ to Ar¹¹, L¹, L², L⁹ to L¹¹, R, R₁, and the ring formed by adjacent groups is substituted with an alkoxy group, the alkoxy group may be, for example, a C₁-C₂₀, a C₁-C₁₀, a C₁-C₄, a C₁, a C₂, a C₃, or a C₄ alkoxy group, for example, methoxy, ethoxy, t-butoxy, etc.

When at least one of Ar¹, Ar², Ar⁹ toAr¹¹, L¹, L², L⁹ to L¹¹, R, R₁, and the ring formed by adjacent groups is substituted with an aryloxy group, the aryloxy group may be, for example, a C₆-C₃₀, a C₆-C₂₉, a C₆-C₂₈, a C₆-C₂₇, a C₆-C₂₆, a C₆-C₂₅, a C₆-C₂₄, a C₆-C₂₃, a C₆-C₂₂, a C₆-C₂₁, a C₆-C₂₀, a C₆-C₁₉, a C₆-C₁₈, a C₆-C₁₇, a C₆-C₁₆, a C₆-C₁₅, a C₆-C₁₄, a C₆-C₁₃, a C₆-C₁₂, a C₆-C₁₁, a C₆-C₁₀, a C₆, a C₁₀, a C₁₂, a C₁₃, a C₁₄, a C₁₅, a C₁₆, a C₁₇, or a C₁₈ aryloxy group.

Formula 1 may be represented by one of Formula 1-1 to Formula 1-16.

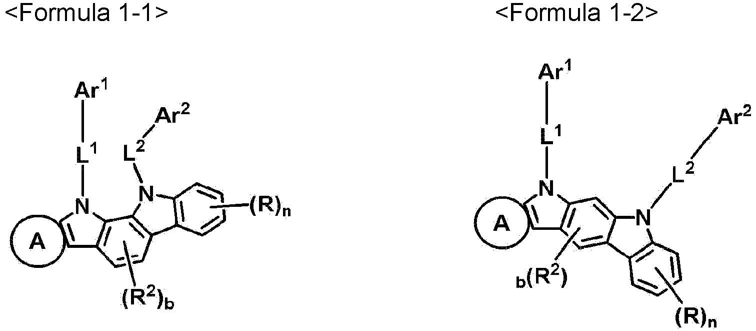

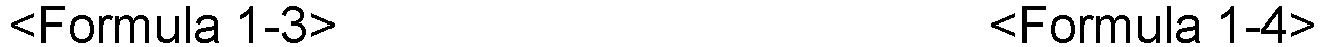

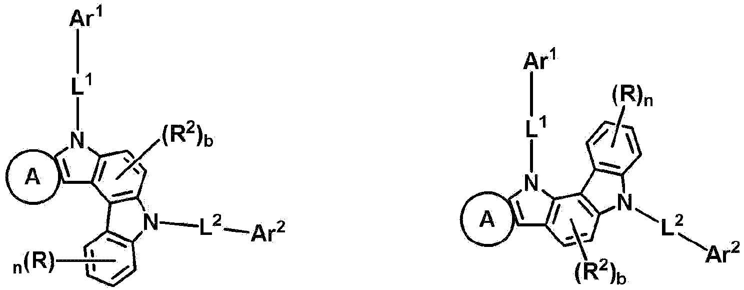

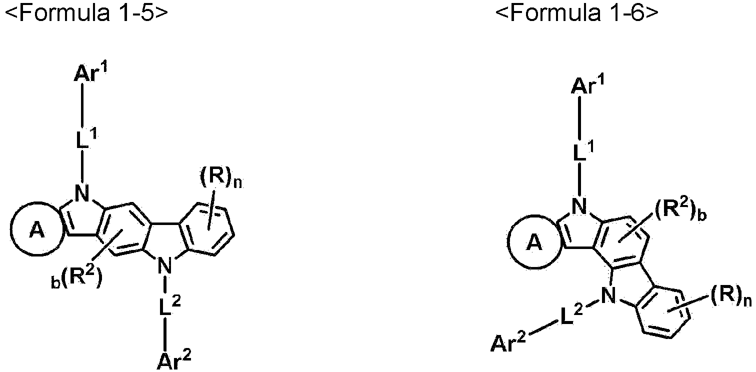

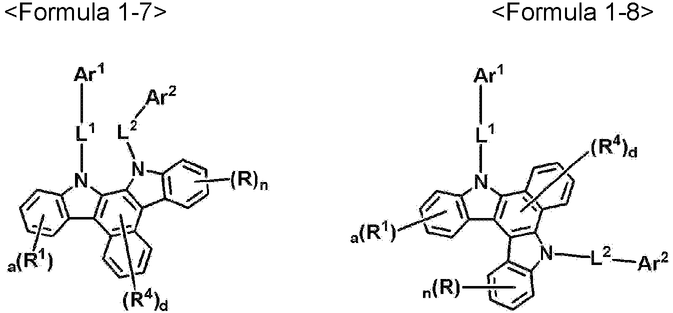

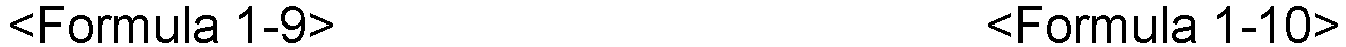

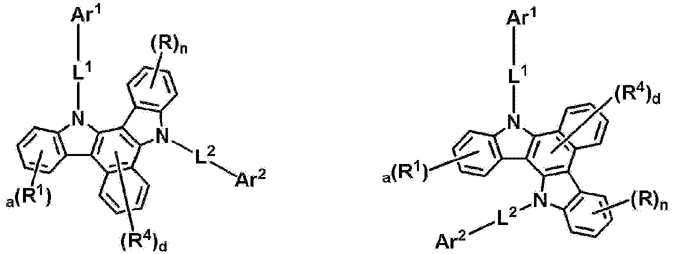

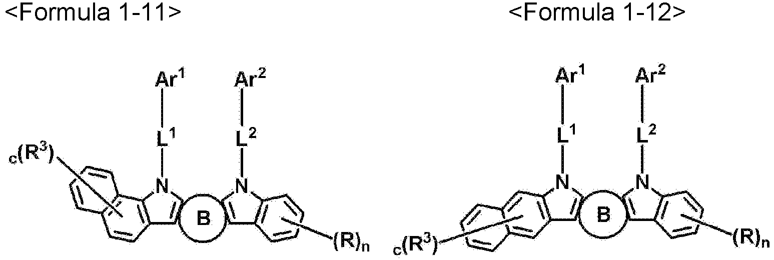

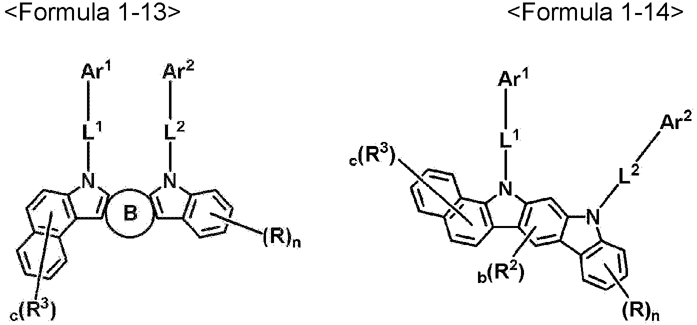

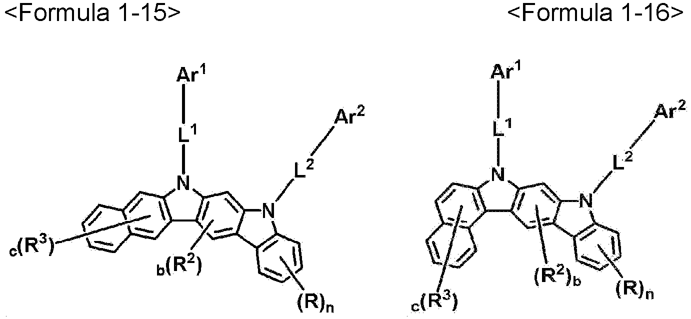

In Formula 1-1 to Formula 1-16, ring A, ring B, R, L¹, L², Ar¹, Ar², R, n are the same as defined for Formula 1, R¹ to R⁴ are the same as R¹ in Formula 1, b is an integer from 0 to 2, a and d are each integers from 0 to 4, and c is an integer from 0 to 6. When any of these are integers of 2 or more, each of the plurality of R¹, R², R³, and R⁴ may be the same as or different from one another.

In addition, in Formula 1-1, Formula 1-3 to Formula 1-6, adjacent R² groups, in Formula 1-7 to Formula 1-10, adjacent R¹ groups or adjacent R⁴ groups, and in Formula 1-11 to Formula 1-16, adjacent R³ groups may be bonded to each other to form a ring.

When adjacent groups are bonded to each other to form a ring, the ring may be selected from the group consisting of a C₆-C₆₀ aromatic ring group, a fluorenylene group, a C₃-C₆₀ heterocyclic group containing at least one heteroatom of O, **N,** S, Si, P and Se, and a C₆-C₆₀ aliphatic ring.

For example, when adjacent groups are bonded to each other to form an aromatic ring, the aromatic ring may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, or a C₁₈ aromatic ring, specifically, an aryl ring such as benzene, naphthalene, anthracene, phenanthrene, pyrene, etc.

In Formula 2, at least one of L⁶ to L⁸ may be represented by Formula L-1 or Formula L-2.

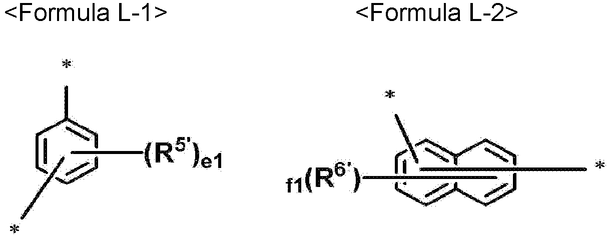

In Formula L-1 and L-2, each symbol may be defined as follows.

R^{5'} and R^{6'} are each independently selected from the group consisting of hydrogen, deuterium, a cyano group, a C₆-C₃₀ aryl group, and a C₆-C₃₀ aryl group substituted with deuterium, and adjacent groups may be bonded to each other to form an aromatic ring.

When adjacent groups are bonded to each other to form an aromatic ring, the aromatic ring group may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, a C₁₈ aromatic ring group, specifically, it may be an aryl ring such as benzene, naphthalene, anthracene, phenanthrene, pyrene, etc.

e1 is an integer from 0 to 4, and f1 is an integer from 0 to 6. When e1 and f1 are each an integer of 2 or more, each R^{5'} and each R^{6'} are the same as or different from one another.

Formula L-1 may be selected from the group consisting of Formula L-1-1 to Formula L-1-3.

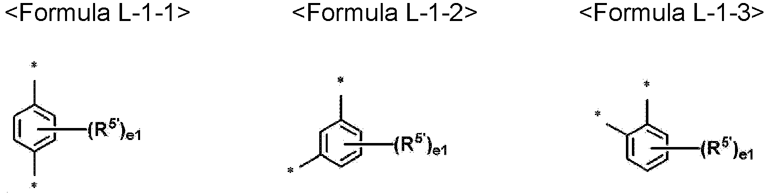

In Formula L-1-1 to Formula L-1-3, R^{5'} and e1 are the same as defined for Formula L-1.

Formula L-2 may be selected from the group consisting of Formula L-2-1 to Formula L-2-10.

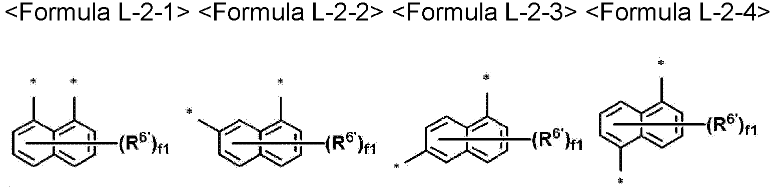

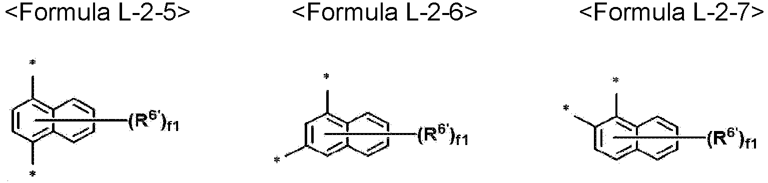

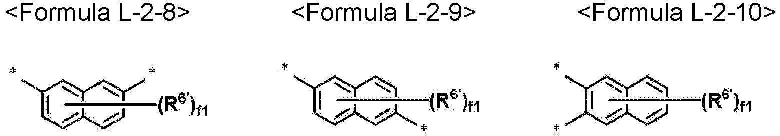

In Formula L-2-1 to Formula L-2-10, R^{6'} and f1 are the same as defined for Formula L-2.

In Formula 2, at least one of Ar⁶ to Ar⁸ may be selected from the group consisting of Formula Ar-1 to Formula Ar-8, but is not limited thereto.

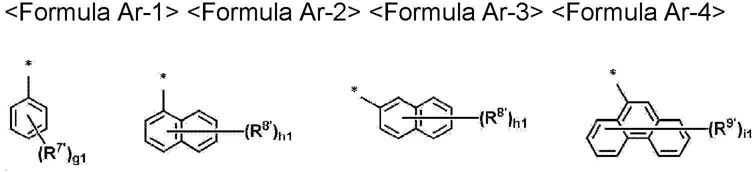

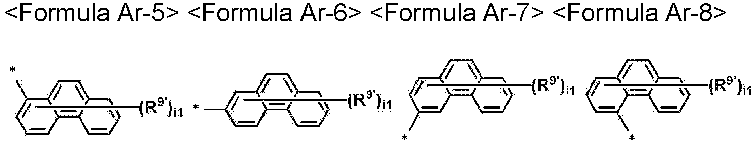

In Formula Ar-1 to Formula Ar-8, each symbol may be defined as follows.

R^{7'} to R^{9'} are each independently selected from the group consisting of hydrogen, deuterium, a cyano group, a C₆-C₃₀ aryl group, and a C₆-C₃₀ aryl group substituted with deuterium, and adjacent groups may be bonded to each other to form an aromatic ring.

When adjacent groups are bonded to each other to form an aromatic ring, the aromatic ring group may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, a C₁₈ aromatic ring group, specifically, it may be an aryl ring such as benzene, naphthalene, anthracene, phenanthrene, pyrene, etc.

g1 is an integer from 0 to 5, h1 is an integer from 0 to 7, i1 is an integer from 0 to 9, j1 is an integer from 0 to 4, and k1 is an integer from 0 to 3. When each of g1, h1, i1, j1, and k1 is an integer of 2 or more, each of the plurality of R^{7'}, R^{8'}, and R^{9'} is the same as or different from one another.

In Formula 3, at least one of Ar⁹ to Ar¹¹ may be selected from the group consisting of Formula Ar-9 to Formula Ar-32, but is not limited thereto.

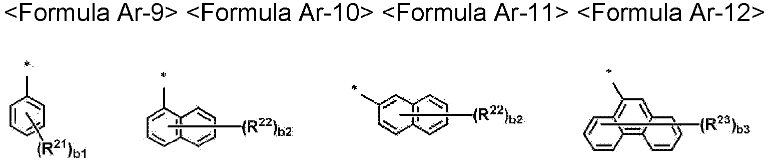

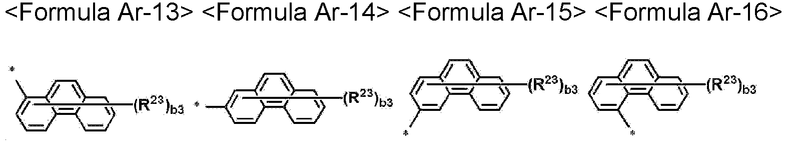

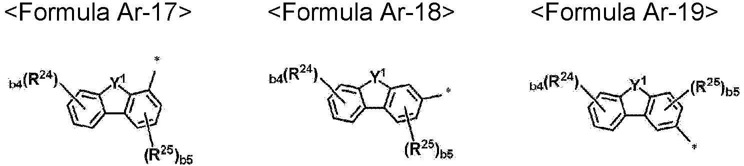

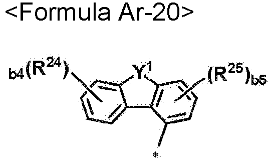

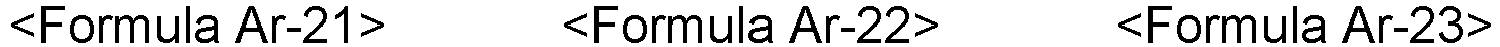

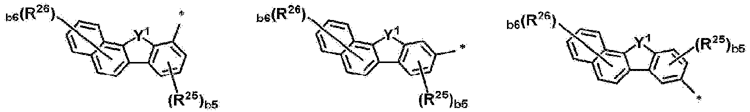

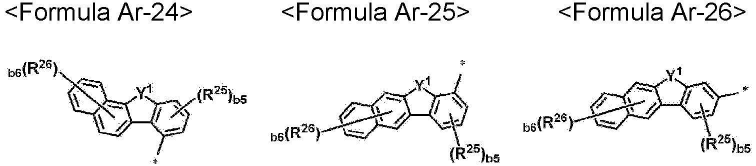

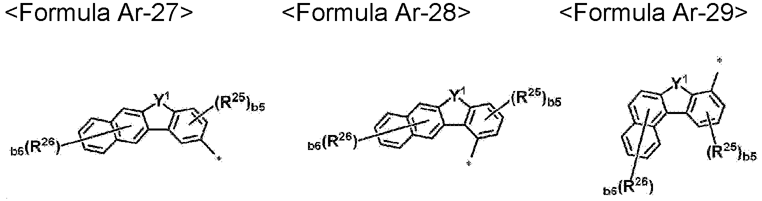

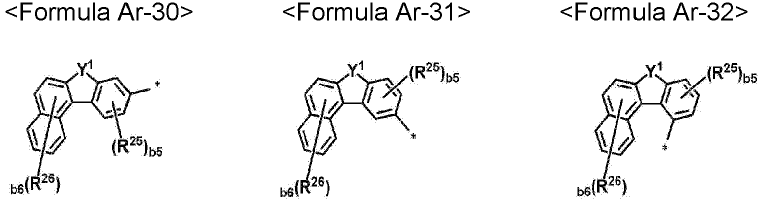

In Formula Ar-9 to Formula Ar-32, each symbol may be defined as follows.

Y' is O, S, N(R') or C(R')(R").

R²¹ to R²⁶, R', R" are each independently selected from the group consisting of hydrogen, deuterium, halogen, a silane group unsubstituted or substituted with a C₁-C₂₀ alkyl group or a C₆-C₂₀ aryl group, a phosphine oxide substituted or unsubstituted with a C₁-C₂₀ alkyl group or a C₆-C₂₀ aryl group, siloxane group, a cyano group, a nitro group, a C₁-C₂₀ alkylthio group, a C₁-C₂₀ alkoxy group, a C₆-C₃₀ aryloxy group, a C₆-C₃₀ arylthio group, a C₁-C₂₀ alkyl halide group, a C₁-C₂₀ alkyl group, a C₂-C₂₀ alkenyl group, a C₂-C₂₀ alkynyl group, a C₆-C₃₀ aryl group, a C₆-C₃₀ aryl group substituted with deuterium, a fluorenyl group, a C₂-C₃₀ heterocyclic group comprising at least one heteroatom selected from the group consisting of O, N, S, Si and P, and a C₃-C₃₀ aliphatic ring group, and adjacent groups may be bonded to each other to form a ring, and R' and R" may be bonded to each other to form a ring. When R' and R" are bonded to each other to form a ring, a spiro compound is formed. Although the same symbol R' is used in both N(R') and C(R')(R"), these R's may be the same as or different from each other.

When adjacent groups are bonded to each other to form an aromatic ring, the aromatic ring group may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, a C₁₈ aromatic ring group, specifically, it may be an aryl ring such as benzene, naphthalene, anthracene, phenanthrene, pyrene, etc.

b1 is an integer from 0 to 5, b2 is an integer from 0 to 7, b3 is an integer from 0 to 9, b4 is an integer from 0 to 4, b5 is an integer from 0 to 3, and b6 is an integer from 0 to 6, and when any of them is an integer of 2 or more, each of the plurality of R²¹, each of the plurality of R²², each of the plurality of R²³, each of the plurality of R²⁴, each of the plurality of R²⁶, and each of the plurality of R²⁶ may be the same as or different from one another.

When L⁹ is a single bond and Ar⁹ is -L¹²-N(Ar^{a})(Ar^{b}) in Formula 3, Formula 3 may be represented by Formula 3-1.

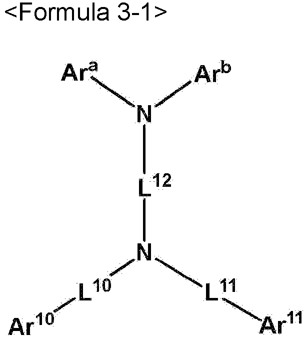

In Formula 3-1, Ar¹⁰ Ar¹¹, L¹⁰, L¹¹, L¹², Ar^{a}, Ar^{b} are the same as defined for Formula 3.

In Formula 3, L¹² may be selected from the group consisting of Formula L-3 to Formula L-6, but is not limited thereto.

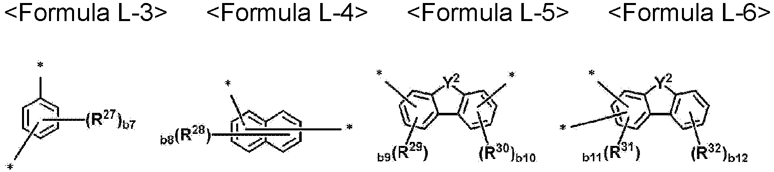

In Formula L-3 to Formula L-6, each symbol may be defined as follows.

Y² is O, S, N(R') or C(R')(R").

R²⁷ to R³², R', R" are each independently selected from the group consisting of hydrogen, deuterium, halogen, a silane group unsubstituted or substituted with a C₁-C₂₀ alkyl group or a C₆-C₂₀ aryl group, a phosphine oxide substituted or unsubstituted with a C₁-C₂₀ alkyl group or a C₆-C₂₀ aryl group, siloxane group, a cyano group, a nitro group, a C₁-C₂₀ alkylthio group, a C₁-C₂₀ alkoxy group, a C₆-C₃₀ aryloxy group, a C₆-C₃₀ arylthio group, a C₁-C₂₀ alkyl halide group, a C₁-C₂₀ alkyl group, a C₂-C₂₀ alkenyl group, a C₂-C₂₀ alkynyl group, a C₆-C₃₀ aryl group, a C₆-C₃₀ aryl group substituted with deuterium, a fluorenyl group, a C₂-C₃₀ heterocyclic group comprising at least one heteroatom selected from the group consisting of O, **N,** S, Si and P, and a C₃-C₃₀ aliphatic ring group, and adjacent groups may be bonded to each other to form an aromatic ring.

When adjacent groups are bonded to each other to form an aromatic ring, the aromatic ring group may be, for example, a C₆-C₂₀, a C₆-C₁₈, a C₆-C₁₆, a C₆-C₁₄, a C₆-C₁₃, a C₆-C₁₂, a C₆-C₁₀, a C₆, a C₁₀, a C₁₂, a C₁₄, a C₁₅, a C₁₆, a C₁₈ aromatic ring group, specifically, it may be an aryl ring such as benzene, naphthalene, anthracene, phenanthrene, pyrene, etc.

b7 and b12 are each an integer from 0 to 4, b8 is an integer from 0 to 6, b9 and b10 are each an integer from 0 to 3, and b11 is an integer from 0 to 2, and when any of them is an integer of 2 or more, each of the plurality of R²⁷ to each of the plurality of R³² may be the same as or different from one another.

Specifically, compound represented by Formula 1 may be one of the following compounds, but there is no limitation thereto.

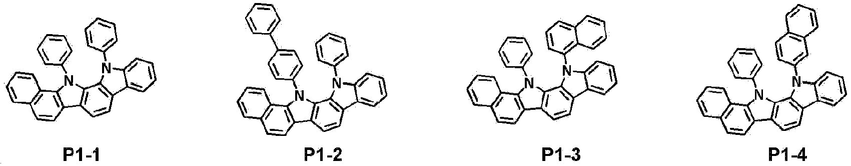

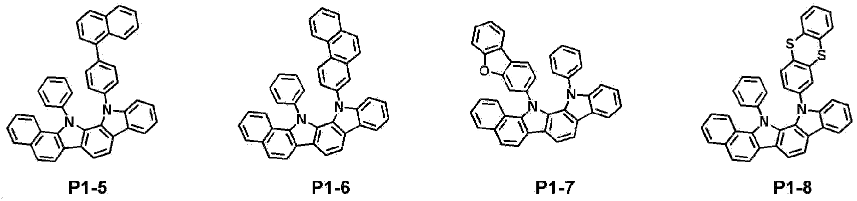

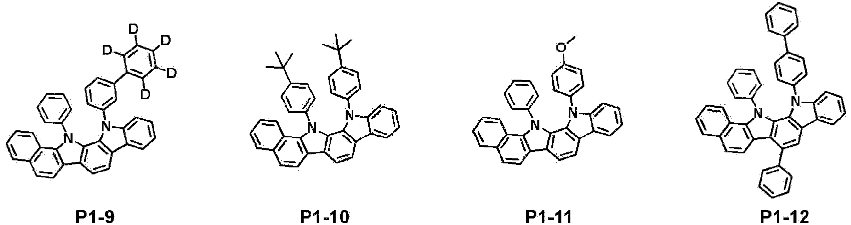

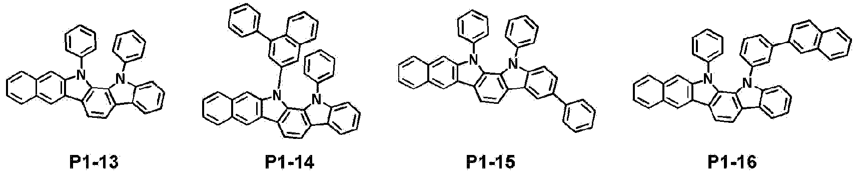

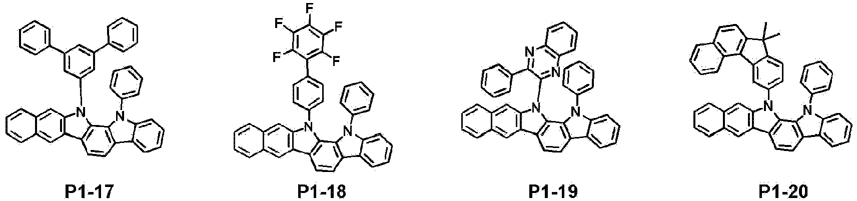

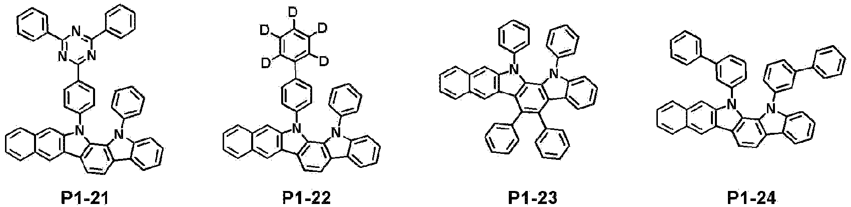

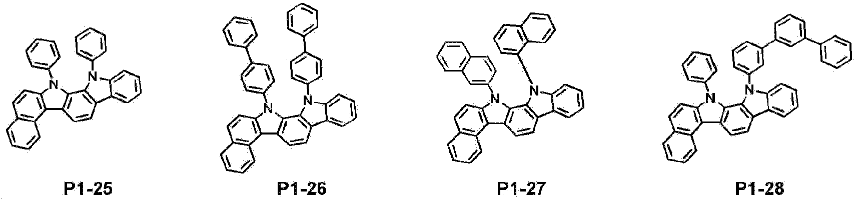

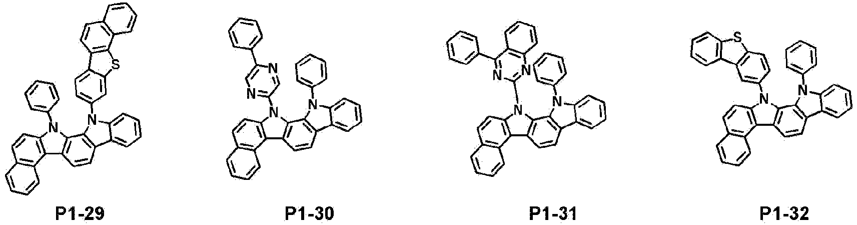

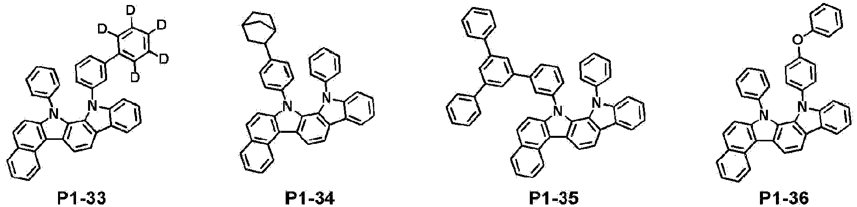

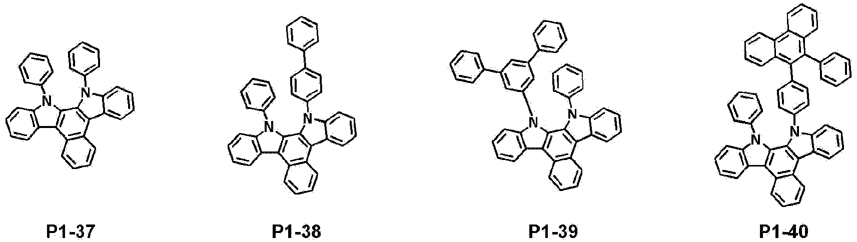

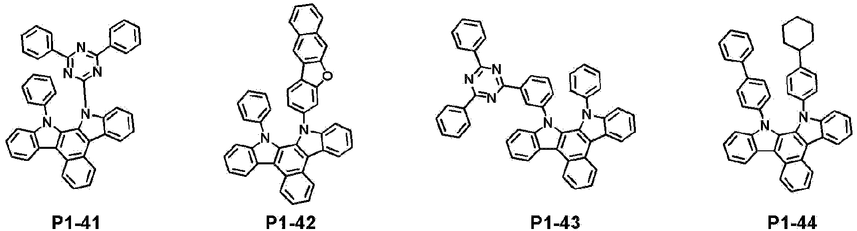

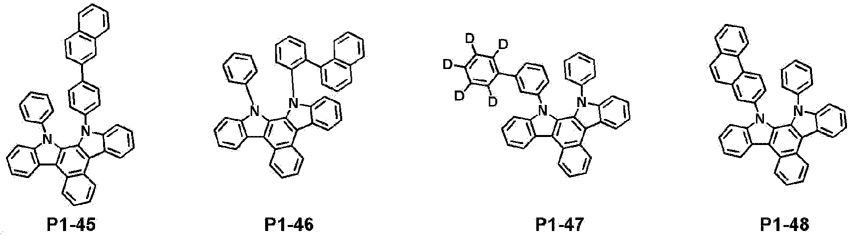

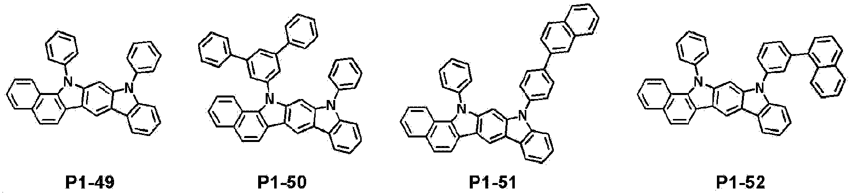

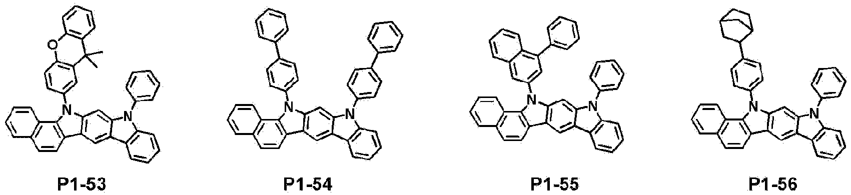

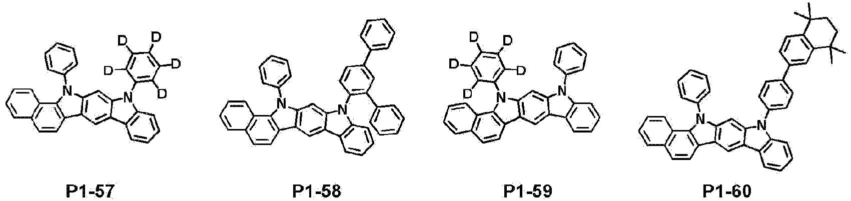

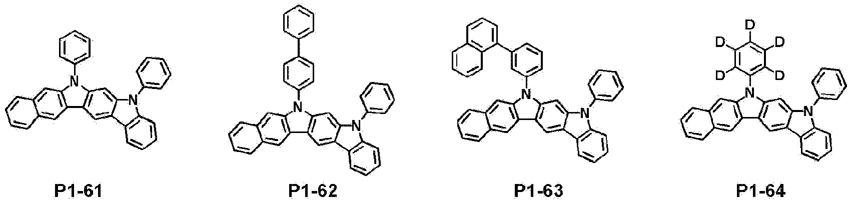

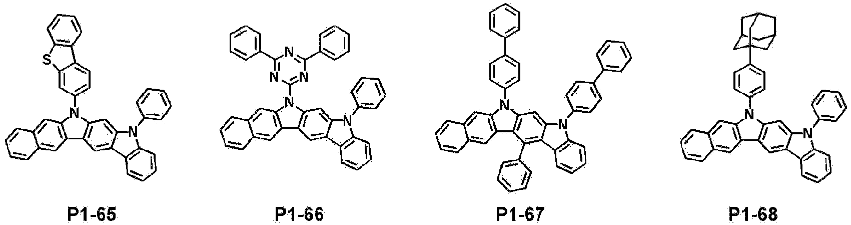

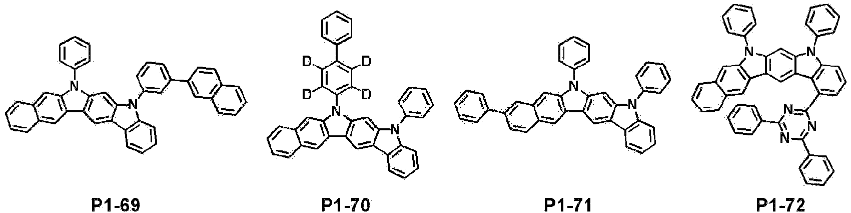

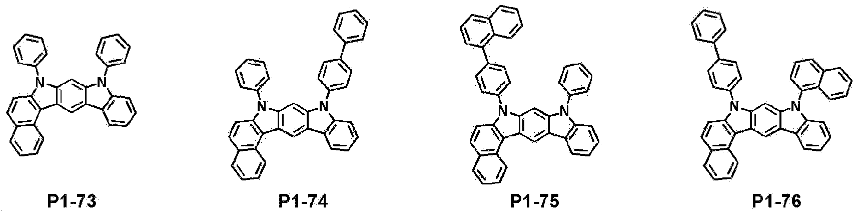

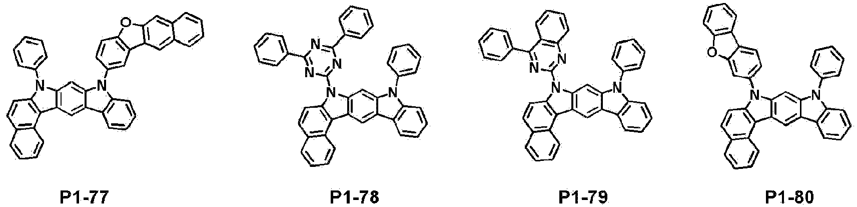

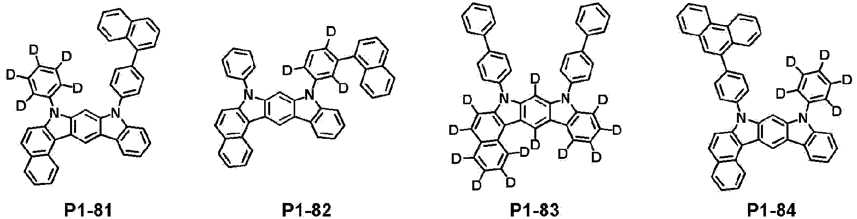

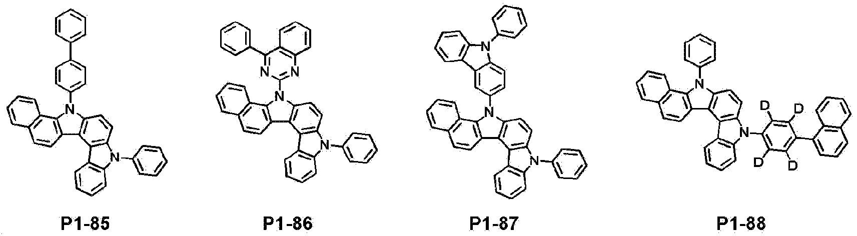

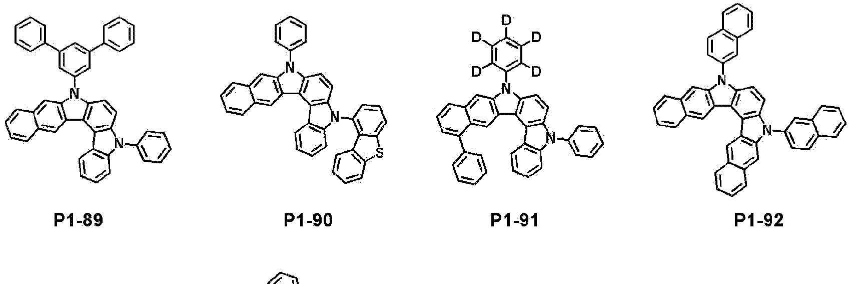

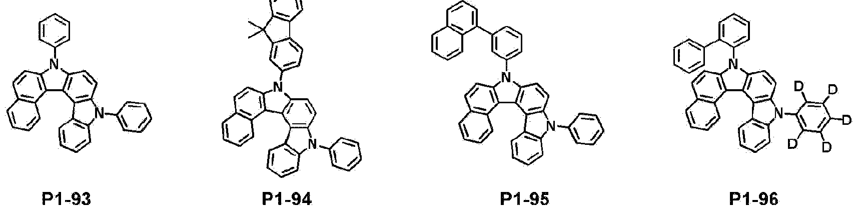

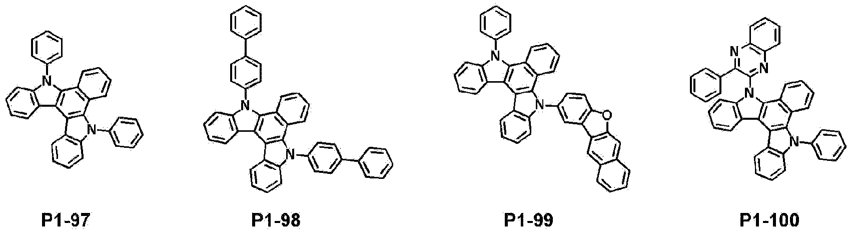

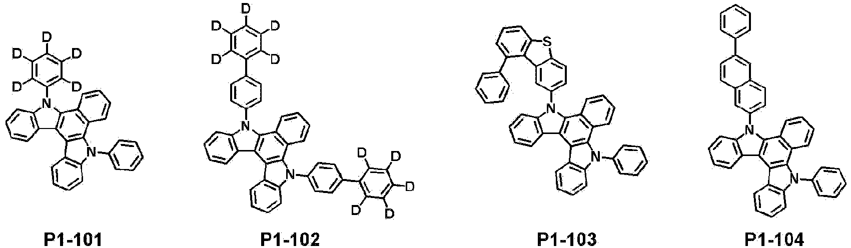

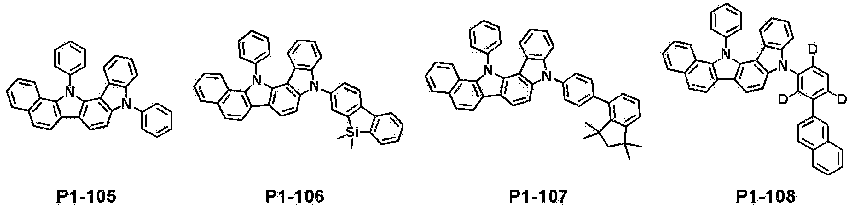

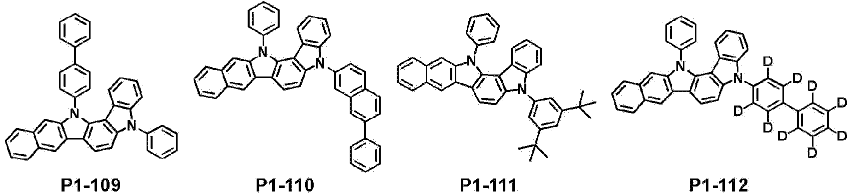

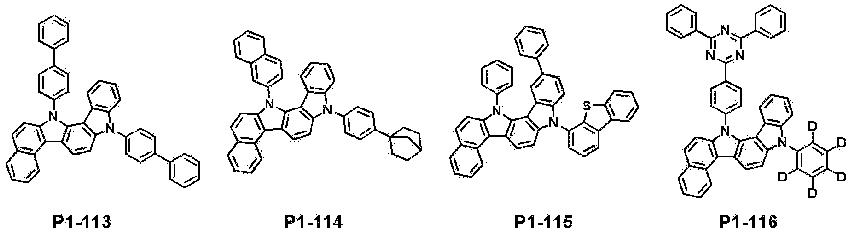

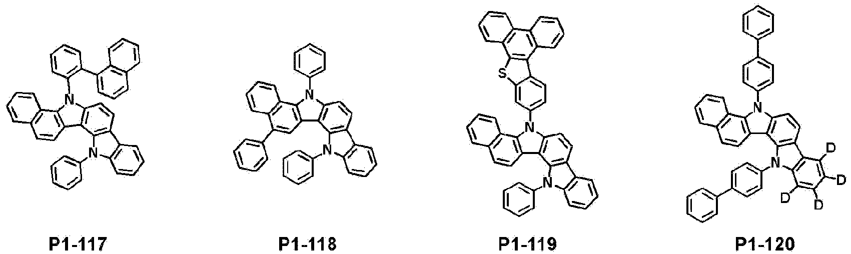

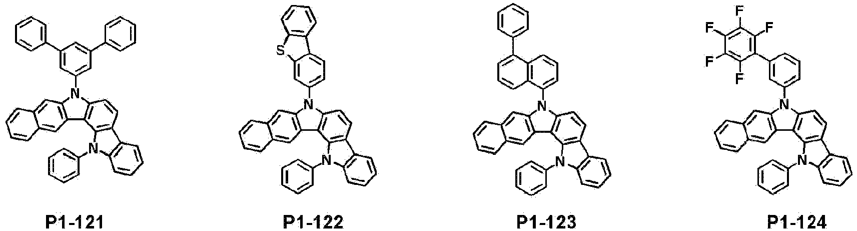

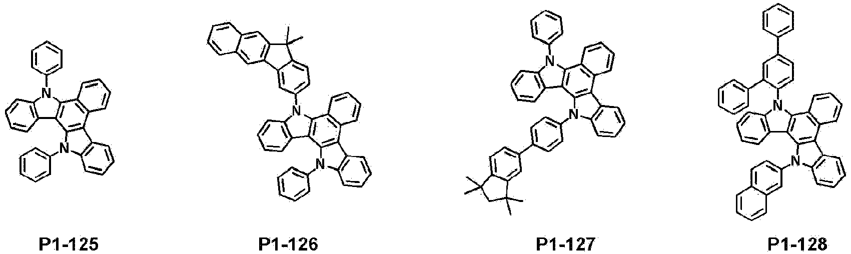

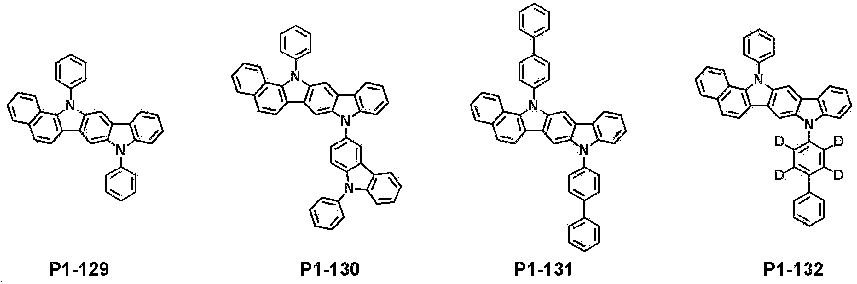

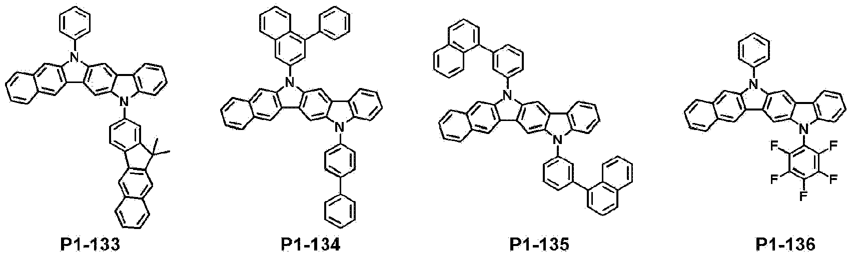

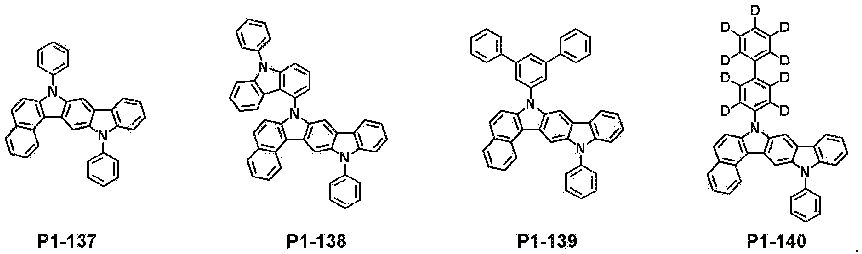

Specifically, compound represented by Formula 2 may be one of the following compounds, but there is no limitation thereto.

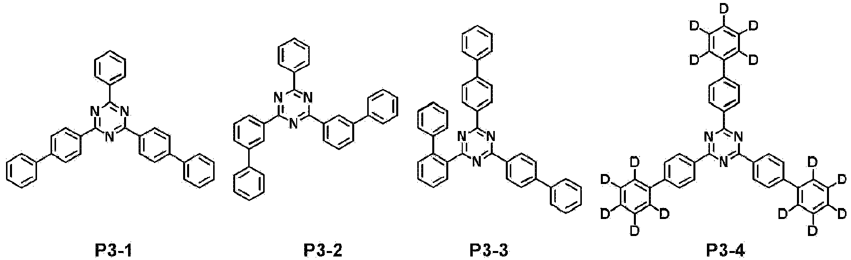

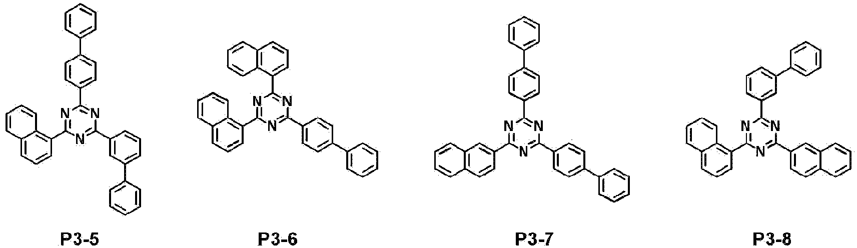

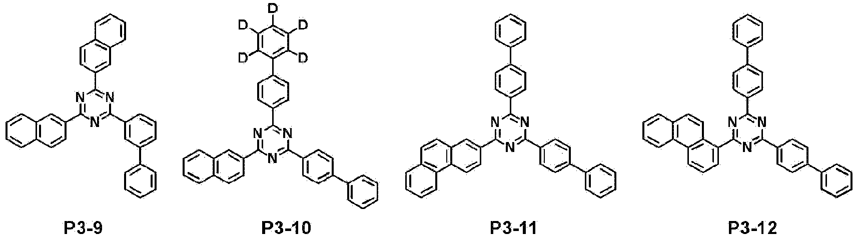

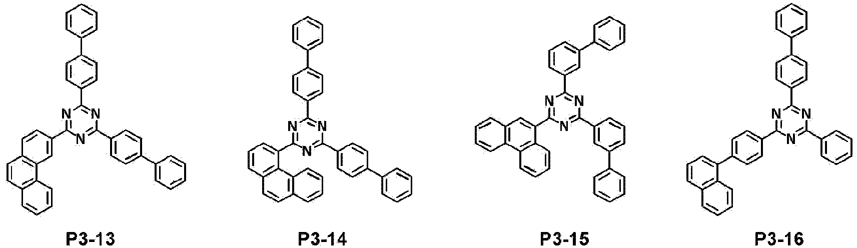

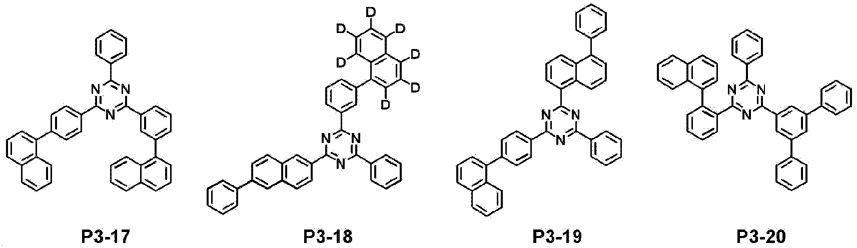

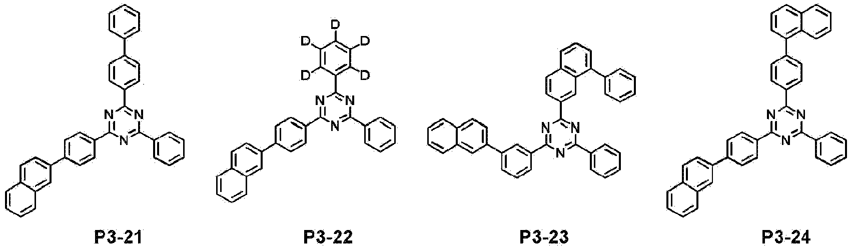

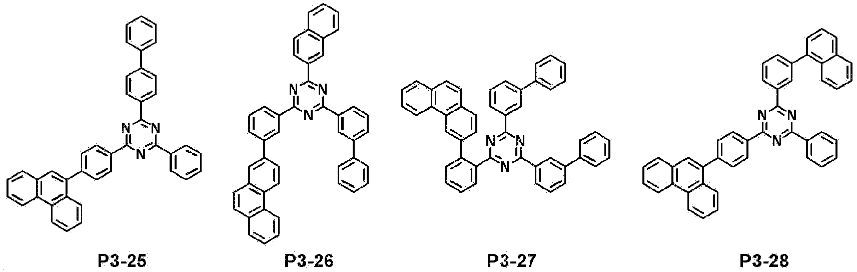

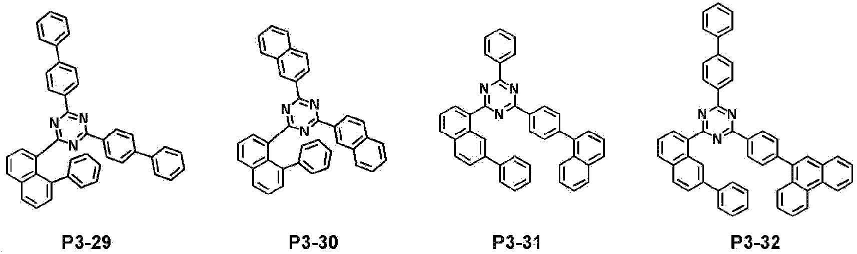

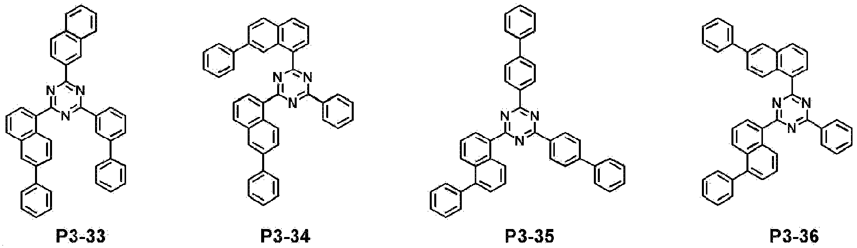

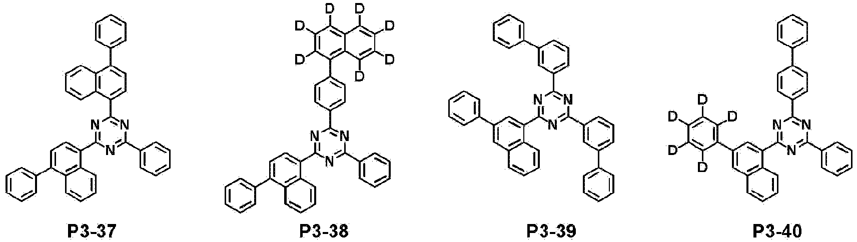

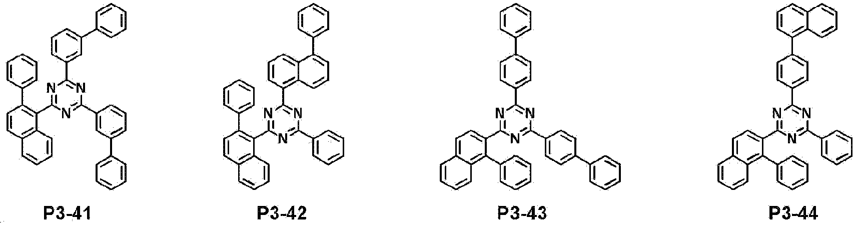

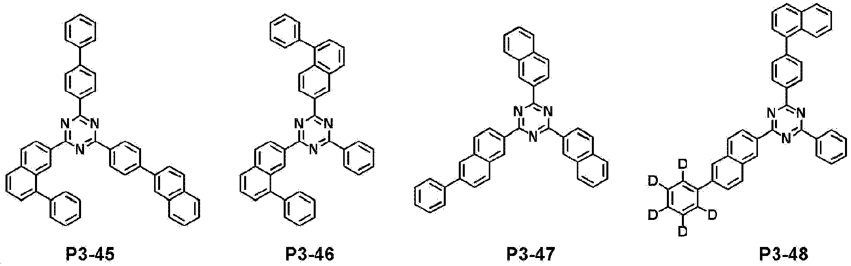

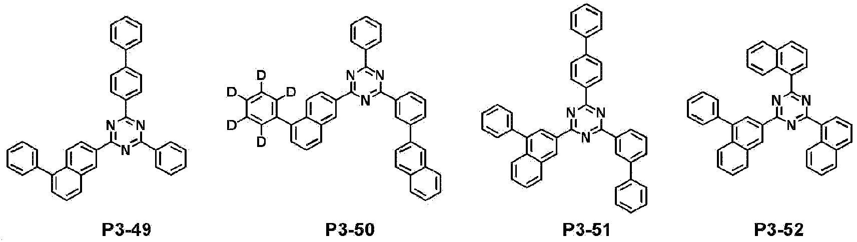

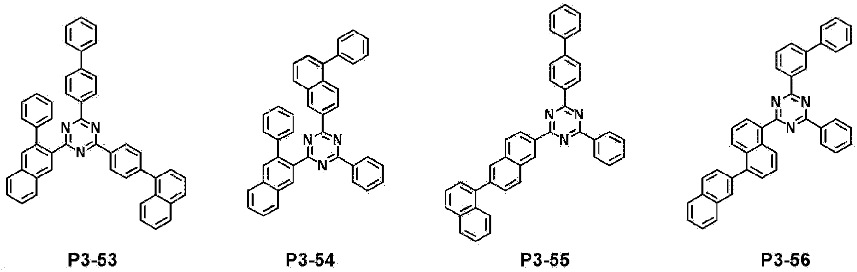

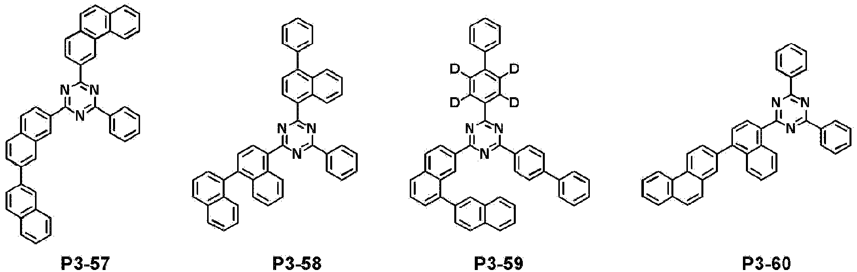

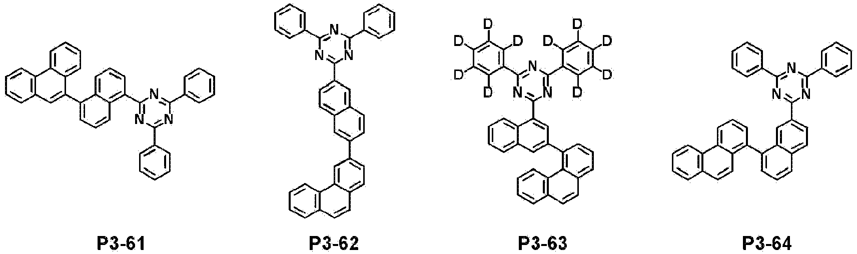

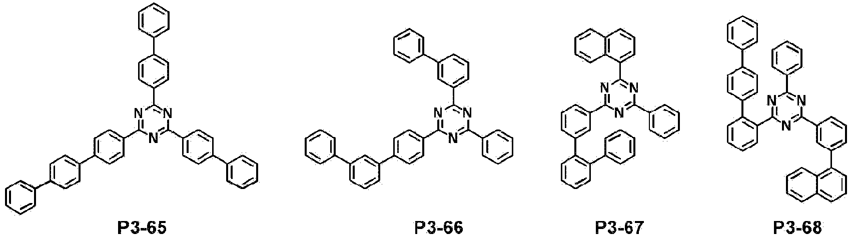

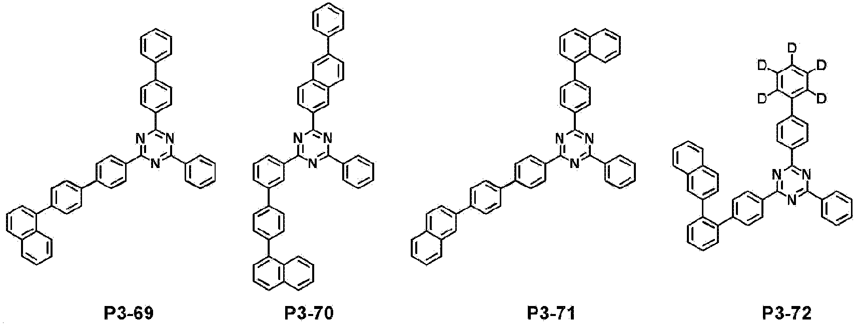

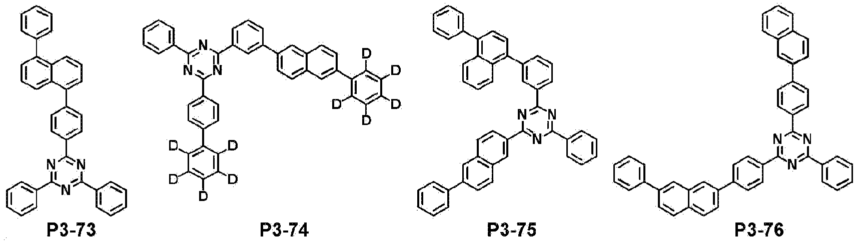

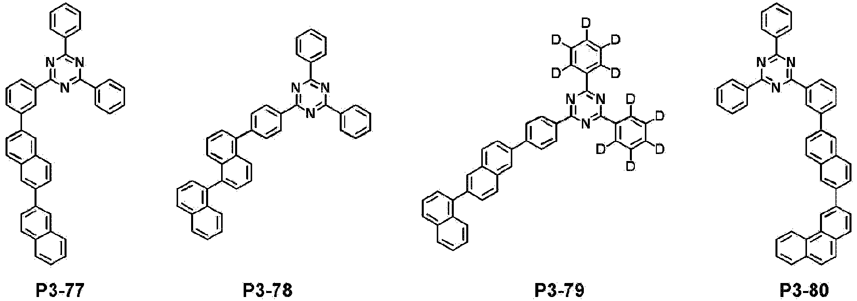

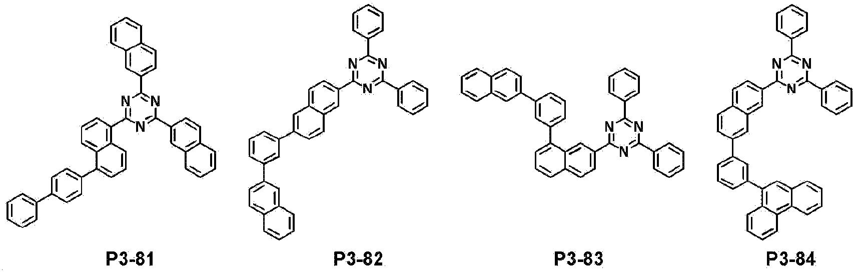

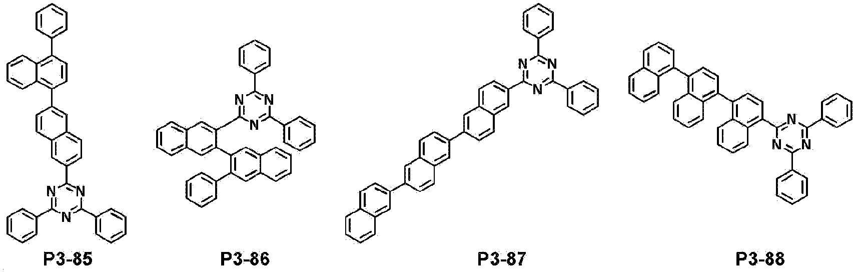

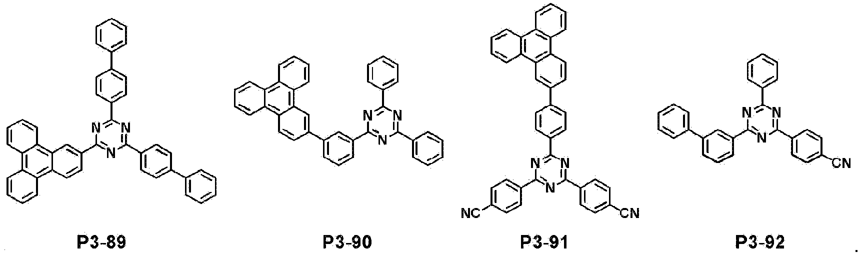

Specifically, compound represented by Formula 3 may be one of the following compounds, but there is no limitation thereto.

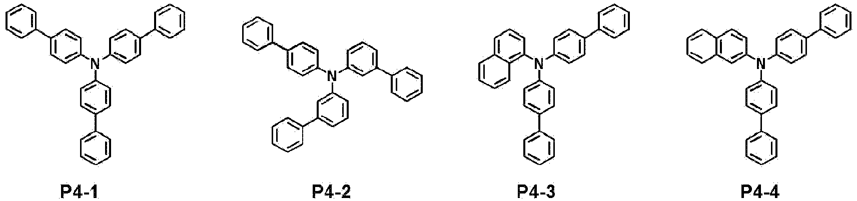

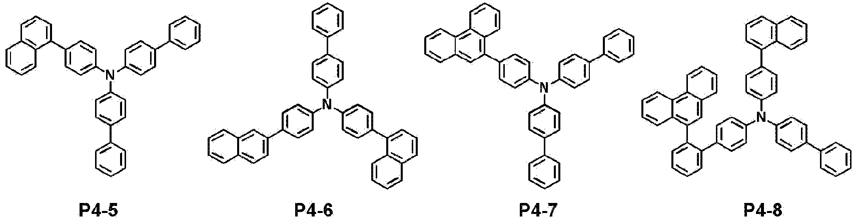

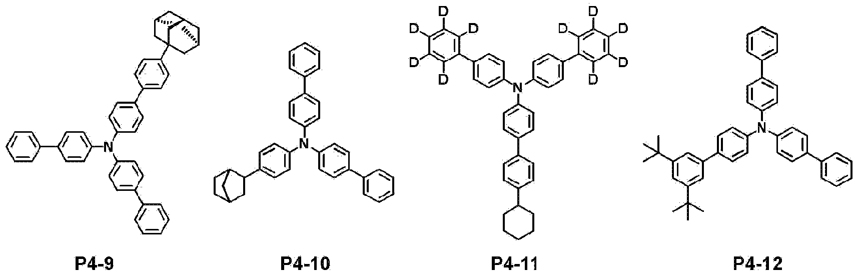

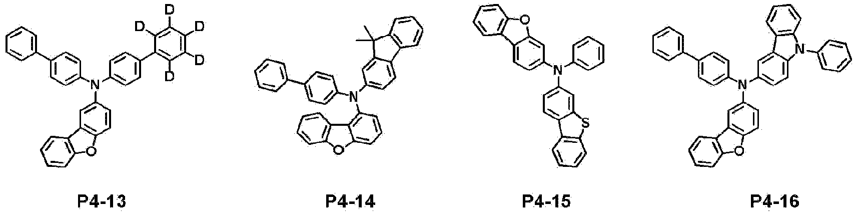

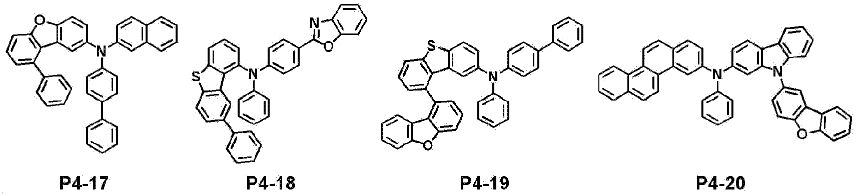

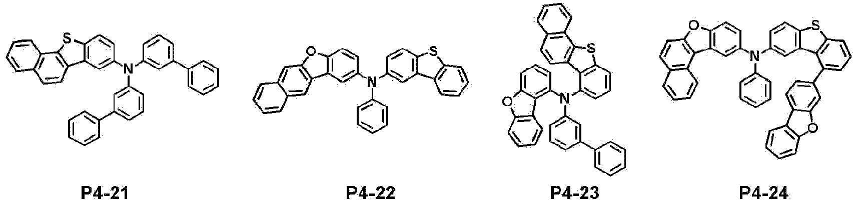

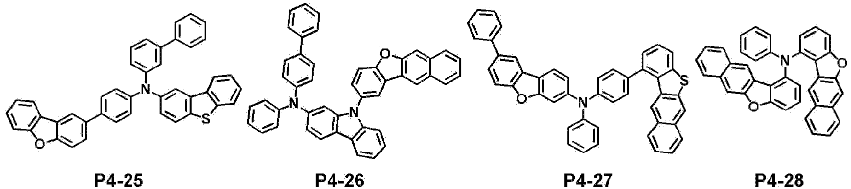

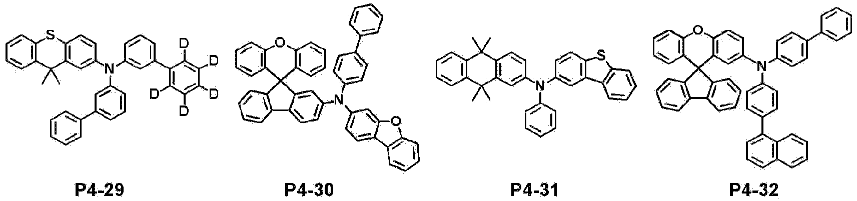

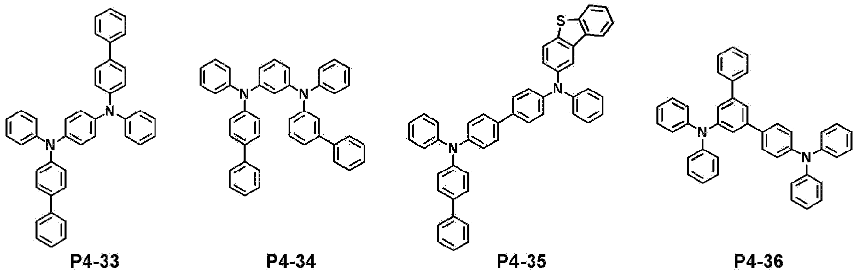

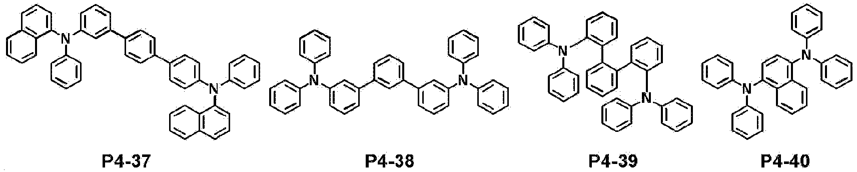

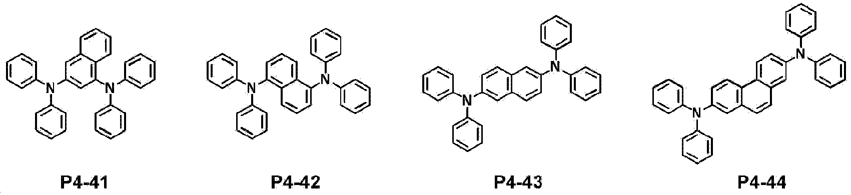

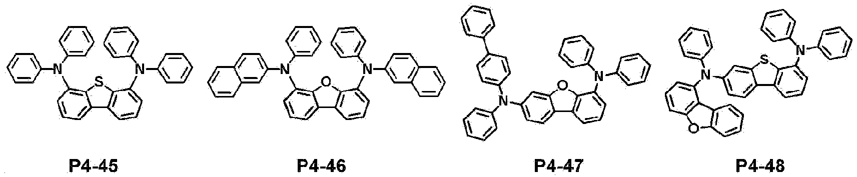

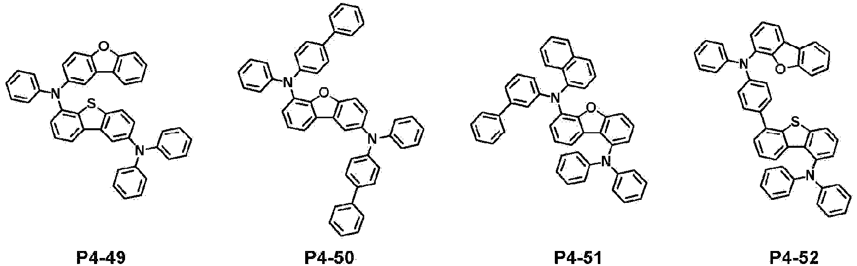

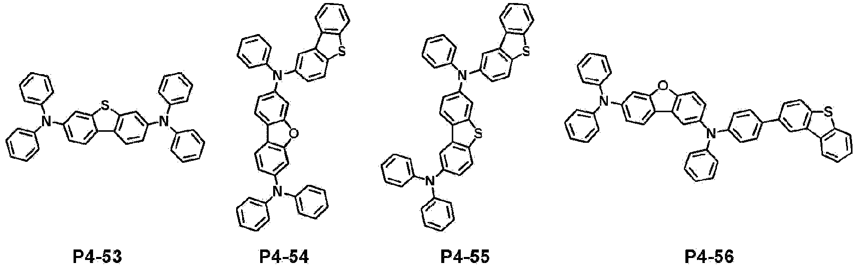

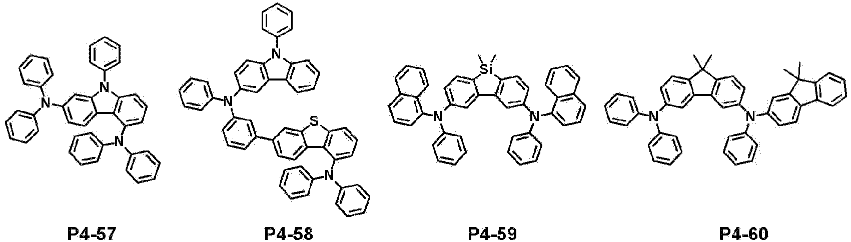

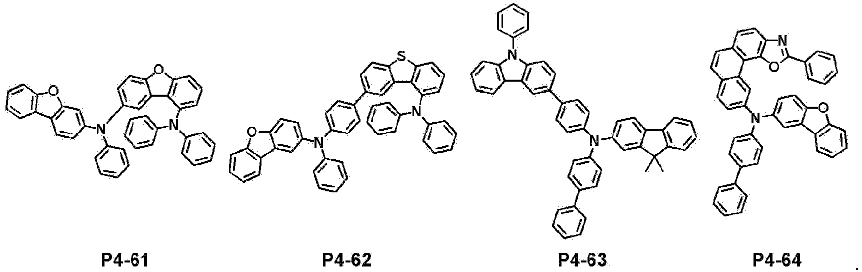

Hereinafter, the present invention will be described in further detail with reference to specific examples regarding the synthesis of compounds represented by Formula 1 to Formula 3 and the fabrication of an organic electronic device. However, the present invention is not limited to the following examples.

### [Synthesis example 1] Compound of Formula 1

Compound represented by Formula 1 (Final Product 1) according to the present invention may be synthesized as shown in Reaction Scheme 1 below, but is not limited thereto.

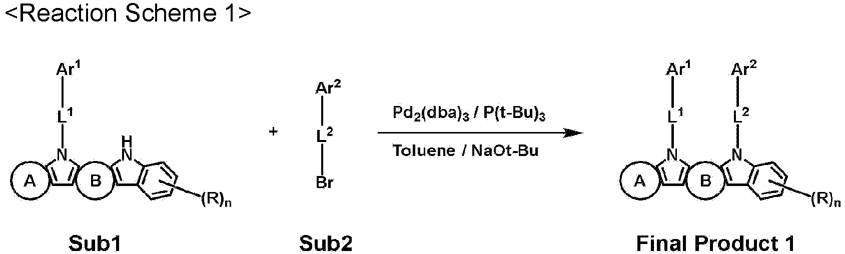

### 1. Synthesis example of P1-1

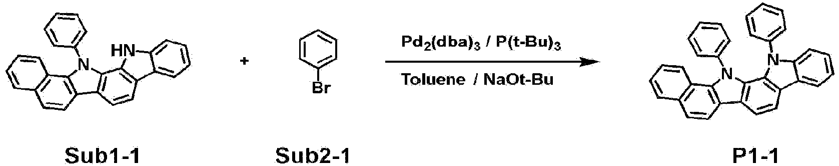

Sub1-1 (10.0 g, 26.1 mmol) was dissolved in toluene (131 mL), and Sub2-1 (4.1 g, 26.1 mmol), Pd₂(dba)₃ (0.72 g, 0.78 mmol), P(t-Bu)₃ (0.32 g, 1.57 mmol), and NaOt-Bu (5.0 g, 52.3 mmol) were added, and the reaction was carried out at 80 °C. Upon completion of the reaction, the mixture was extracted with CH₂Cl₂ and water. The organic layer was dried over MgSO₄ and concentrated. Then, the concentrate was purified by silica gel column chromatography and recrystallized to obtain 8.5 g of the product. (Yield: 71%)

### 2. Synthesis example of P1-41

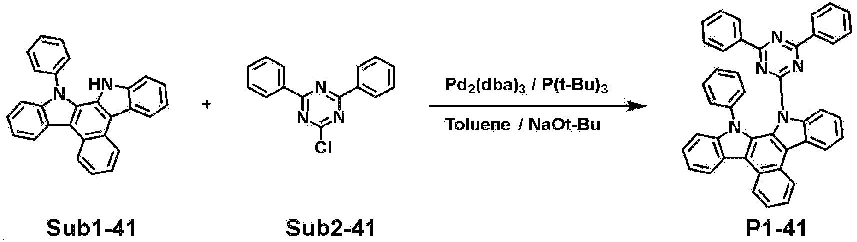

After dissolving Sub1-41 (10.0 g, 26.1 mmol) in toluene (131 mL), Sub2-41 (7.0 g, 26.1 mmol), Pd₂(dba)₃ (0.72 g, 0.78 mmol), P(t-Bu)₃ (0.32 g, 1.57 mmol), and NaOt-Bu (5.0 g, 52.3 mmol) were added, and the synthesis was carried out in the same manner as in the synthesis example of P1-1 to obtain 10.8 g of the product. (Yield: 67%)

### 3. Synthesis example of P1-81

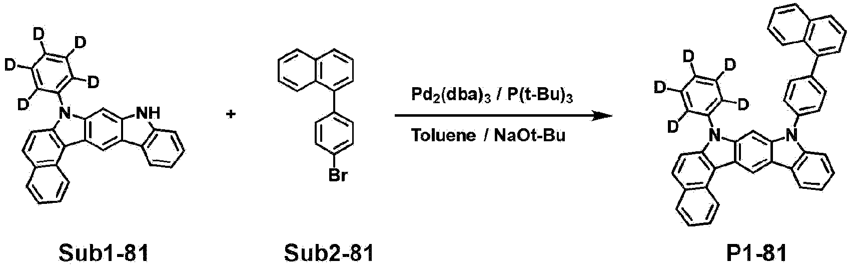

After dissolving Sub1-81 (10.0 g, 25.8 mmol) in toluene (129 mL), Sub2-81 (7.3 g, 25.8 mmol), Pd₂(dba)₃ (0.71 g, 0.77 mmol), P(t-Bu)₃ (0.31 g, 1.55 mmol), and NaOt-Bu (5.0 g, 51.6 mmol) were added, and the synthesis was carried out in the same manner as in the synthesis example of P1-1 to obtain 11.9 g of the product. (Yield: 78%)

### 4. Synthesis example of P1-99

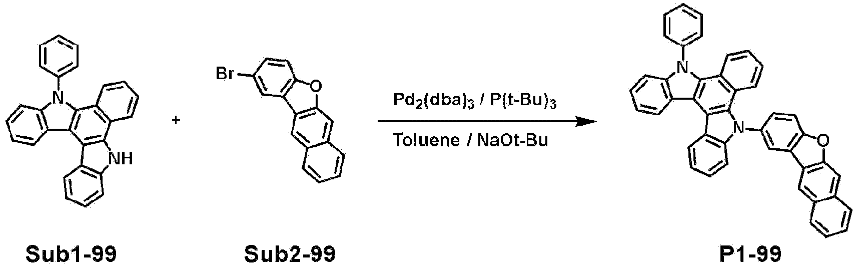

After dissolving Sub1-99 (10.0 g, 26.1 mmol) in toluene (131 mL), Sub2-99 (7.8 g, 26.1 mmol), Pd₂(dba)₃ (0.72 g, 0.78 mmol), P(t-Bu)₃ (0.32 g, 1.57 mmol), and NaOt-Bu (5.0 g, 52.3 mmol) were added, and the synthesis was carried out in the same manner as in the synthesis example of P1-1 to obtain 11.9 g of the product. (Yield: 76%)

### 5. Synthesis example of P1-130

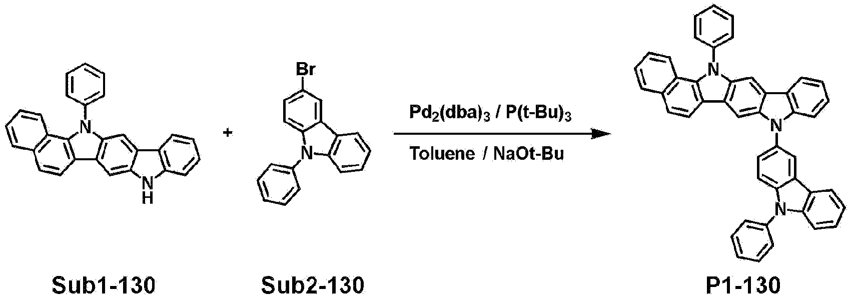

After dissolving Sub1-130 (10.0 g, 26.1 mmol) in toluene (131 mL), Sub2-130 (8.4 g, 26.1 mmol), Pd₂(dba)₃ (0.72 g, 0.78 mmol), P(t-Bu)₃ (0.32 g, 1.57 mmol), and NaOt-Bu (5.0 g, 52.3 mmol) were added, and the synthesis was carried out in the same manner as in the synthesis example of P1-1 to obtain 12.9 g of the product. (Yield: 79%)

The FD-MS (Field Desorption-Mass Spectrometry) values of the compound of Formula 1 of the present invention prepared according to the above synthesis example are shown in Table 1 below.

**[Table 1]**

| Compound | FD-MS | Compound | FD-MS |
|---|---|---|---|
| P1-1 | m/z=458.18(C₃₄H₂₂N₂=458.56) | P1-2 | m/z=534.21(C₄₀H₂₆N₂=534.66) |
| P1-3 | m/z=508.19(C₃₈H₂₄N₂=508.62) | P1-4 | m/z=508.19(C₃₈H₂₄N₂=508.62) |
| P1-5 | m/z=584.23(C₄₄H₂₈N₂=584.72) | P1-6 | m/z=558.21(C₄₂H₂₆N₂=558.68) |
| P1-7 | m/z=548.19(C₄₀H₂₄N₂O=548.64) | P1-8 | m/z=596.14(C₄₀H₂₄N₂S₂=596.77) |
| P1-9 | m/z=539.24(C₄₀H₂₁D₅N₂=539.69) | P1-10 | m/z=570.3(C₄₂H₃₈N₂=570.78) |
| P1-11 | m/z=488.19(C₃₅H₂₄N₂O=488.59) | P1-12 | m/z=610.24(C₄₆H₃₀N₂=610.76) |
| P1-13 | m/z=458.18(C₃₄H₂₂N₂=458.56) | P1-14 | m/z=584.23(C₄₄H₂₈N₂=584.72) |
| P1-15 | m/z=534.21(C₄₀H₂₆N₂=534.66) | P1-16 | m/z=584.23(C₄₄H₂₈N₂=584.72) |
| P1-17 | m/z=610.24(C₄₆H₃₀N₂=610.76) | P1-18 | m/z=624.16(C₄₀H₂₁F₅N₂=624.61) |
| P1-19 | m/z=586.22(C₄₂H₂₆N₄=586.7) | P1-20 | m/z=624.26(C₄₇H₃₂N₂=624.79) |
| P1-21 | m/z=689.26(C₄₉H₃₁ N₅=689.82) | P1-22 | m/z=539.24(C₄₀H₂₁D₅N₂=539.69) |
| P1-23 | m/z=610.24(C₄₆H₃₀N₂=610.76) | P1-24 | m/z=610.24(C₄₆H₃₀N₂=610.76) |
| P1-25 | m/z=458.18(C₃₄H₂₂N₂=458.56) | P1-26 | m/z=610.24(C₄₆H₃₀N₂=610.76) |
| P1-27 | m/z=558.21(C₄₂H₂₆N₂=558.68) | P1-28 | m/z=610.24(C₄₆H₃₀N₂=610.76) |
| P1-29 | m/z=614.18(C₄₄H₂₆N₂S=614.77) | P1-30 | m/z=536.2(C₃₃H₂₄N₄=536.64) |
| P1-31 | m/z=586.22(C₄₂H₂₆N₄=586.7) | P1-32 | m/z=564.17(C₄₀H₂₄N₂S=564.71) |
| P1-33 | m/z=539.24(C₄₀H₂₁D₅N₂=539.69) | P1-34 | m/z=552.26(C₄₁H₃₂N₂=552.72) |
| P1-35 | m/z=686.27(C₅₂H₃₄N₂=686.86) | P1-36 | m/z=550.2(C₄₀H₂₆N₂O=550.66) |
| P1-37 | m/z=458.18(C₃₄H₂₂N₂=458.56) | P1-38 | m/z=534.21(C₄₀H₂₆N₂=534.66) |
| P1-39 | m/z=610.24(C₄₆H₃₀N₂=610.76) | P1-40 | m/z=710.27(C₅₄H₃₄N₂=710.88) |
| P1-41 | m/z=613.23(C₄₃H₂₇N₅=613.72) | P1-42 | m/z=598.2(C₄₄H₂₆N₂O=598.7) |
| P1-43 | m/z=689.26(C₄₉H₃₁N₅=689.82) | P1-44 | m/z=616.29(C₄₆H₃₆N₂=616.81) |
| P1-45 | m/z=584.23(C₄₄H₂₈N₂=584.72) | P1-46 | m/z=584.23(C₄₄H₂₈N₂=584.72) |
| P1-47 | m/z=539.24(C₄₀H₂₁D₅N₂=539.69) | P1-48 | m/z=558.21(C₄₂H₂₆N₂=558.68) |
| P1-49 | m/z=458.18(C₃₄H₂₂N₂=458.56) | P1-50 | m/z=610.24(C₄₆H₃₀N₂=610.76) |
| P1-51 | m/z=584.23(C₄₄H₂₈N₂=584.72) | P1-52 | m/z=584.23(C₄₄H₂₈N₂=584.72) |
| P1-53 | m/z=590.24(C₄₃H₃₀N₂O=590.73) | P1-54 | m/z=610.24(C₄₆H₃₀N₂=610.76) |
| P1-55 | m/z=584.23(C₄₄H₂₈N₂=584.72) | P1-56 | m/z=552.26(C₄₁H₃₂N₂=552.72) |
| P1-57 | m/z=463.21(C₃₄H₁₇D₅N₂=463.59) | P1-58 | m/z=610.24(C₄₆H₃₀N₂=610.76) |
| P1-59 | m/z=463.21(C₃₄H₁₇D₅N₂=463.59) | P1-60 | m/z=644.32(C₄₈H₄₀N₂=644.86) |
| P1-61 | m/z=458.18(C₃₄H₂₂N₂=458.56) | P1-62 | m/z=534.21(C₄₀H₂₆N₂=534.66) |
| P1-63 | m/z=584.23(C₄₄H₂₈N₂=584.72) | P1-64 | m/z=463.21(C₃₄H₁₇D₅N₂=463.59) |
| P1-65 | m/z=564.17(C₄₀H₂₄N₂S=564.71) | P1-66 | m/z=613.23(C₄₃H₂₇N₅=613.72) |
| P1-67 | m/z=686.27(C₅₂H₃₄N₂=686.86) | P1-68 | m/z=592.29(C₄₄H₃₆N₂=592.79) |
| P1-69 | m/z=584.23(C₄₄H₂₈N₂=584.72) | P1-70 | m/z=538.23(C₄₀H₂₂D₄N₂=538.69) |
| P1-71 | m/z=534.21(C₄₀H₂₆N₂=534.66) | P1-72 | m/z=689.26(C₄₉H₃₁N₅=689.82) |
| P1-73 | m/z=458.18(C₃₄H₂₂N₂=458.56) | P1-74 | m/z=534.21(C₄₀H₂₆N₂=534.66) |
| P1-75 | m/z=584.23(C₄₄H₂₈N₂=584.72) | P1-76 | m/z=584.23(C₄₄H₂₈N₂=584.72) |
| P1-77 | m/z=598.2(C₄₄H₂₆N₂O=598.7) | P1-78 | m/z=613.23(C₄₃H₂₇N₅=613.72) |
| P1-79 | m/z=586.22(C₄₂H₂₆N₄=586.7) | P1-80 | m/z=548.19(C₄₀H₂₄N₂O=548.64) |
| P1-81 | m/z=589.26(C₄₄H₂₃D₅N₂=589.75) | P1-82 | m/z=587.24(C₄₄H₂₅D₃N₂=587.74) |
| P1-83 | m/z=622.32(C₄₆H₁₈D₁₂N₂=622.83) | P1-84 | m/z=639.27(C₄₈H₂₅D₅N₂=639.81) |
| P1-85 | m/z=534.21(C₄₀H₂₆N₂=534.66) | P1-86 | m/z=586.22(C₄₂H₂₆N₄=586.7) |
| P1-87 | m/z=623.24(C₄₆H₂₀N₃=623.76) | P1-88 | m/z=588.25(C₄₄H₂₄D₄N₂=588.75) |
| P1-89 | m/z=610.24(C₄₆H₃₀N₂=610.76) | P1-90 | m/z=564.17 (C₄₀H₂₄N₂S=564.71) |
| P1-91 | m/z=539.24(C₄₀H₂₁D₅N₂=539.69) | P1-92 | m/z=608.23(C₄₆H₂₈N₂=608.74) |
| P1-93 | m/z=458.18(C₃₄H₂₂N₂=458.56) | P1-94 | m/z=574.24(C₄₃H₃₀N₂=574.73) |
| P1-95 | m/z=584.23(C₄₄H₂₈N₂=584.72) | P1-96 | m/z=539.24(C₄₀H₂ D₅N₂=539.69) |
| P1-97 | m/z=458.18(C₃₄H₂₂N₂=458.56) | P1-98 | m/z=610.24(C₄₆H₃₀N₂=610.76) |
| P1-99 | m/z=598.2(C₄₄H₂₆N₂O=598.7) | P1-100 | m/z=586.22(C₄₂H₂₆N₄=586.7) |
| P1-101 | m/z=463.21(C₃₄H₁₇D₅N₂=463.59) | P1-102 | m/z=620.3(C₄₆H₂₀D₁₀N₂=620.82) |
| P1-103 | m/z=640.2(C₄₆H₂₈N₂S=640.8) | P1-104 | m/z=584.23(C₄₄H₂₈N₂=584.72) |
| P1-105 | m/z=458.18(C₃₄H₂₂N₂=458.56) | P1-106 | m/z=590.22(C₄₂H₃₀N₂Si=590.8) |
| P1-107 | m/z=630.3(C₄₇H₃₈N₂=630.83) | P1-108 | m/z=587.24(C₄₄H₂₅D₃N₂=587.74) |
| P1-109 | m/z=534.21(C₄₀H₂₆N₂=534.66) | P1-110 | m/z=584.23(C₄₄H₂₈N₂=584.72) |
| P1-111 | m/z=570.3(C₄₂H₃₈N₂=570.78) | P1-112 | m/z=543.27(C₄₀H₁₇D₉N₂=543.72) |
| P1-113 | m/z=610.24(C₄₆H₃₀N₂=610.76) | P1-114 | m/z=602.27(C₄₅H₃₄N₂=602.78) |
| P1-115 | m/z=640.2(C₄₆H₂₈N₂S=640.8) | P1-116 | m/z=694.29(C₄₉H₂₆D₅N₅=694.85) |
| P1-117 | m/z=584.23(C₄₄H₂₈N₂=584.72) | P1-118 | m/z=534.21(C₄₀H₂₆N₂=534.66) |
| P1-119 | m/z=664.2(C₄₈H₂₈N₂S=664.83) | P1-120 | m/z=614.27(C₄₆H₂₆D₄N₂=614.78) |
| P1-121 | m/z=610.24(C₄₆H₃₀N₂=610.76) | P1-122 | m/z=564.17(C₄₀H₂₄N₂S=564.71) |
| P1-123 | m/z=584.23(C₄₄H₂₈N₂=584.72) | P1-124 | m/z=624.16(C₄₀H₂₁F₅N₂=624.61) |
| P1-125 | m/z=458.18(C₃₄H₂₂N₂=458.56) | P1-126 | m/z=624.26(C₄₇H₃₂N₂=624.79) |
| P1-127 | m/z=630.3(C₄₇H₃₈N₂=630.83) | P1-128 | m/z=660.26(C₅₀H₃₂N₂=660.82) |
| P1-129 | m/z=458.18(C₃₄H₂₂N₂=458.56) | P1-130 | m/z=623.24(C₄₆H₂₉N₃=623.76) |
| P1-131 | m/z=610.24(C₄₆H₃₀N₂=610.76) | P1-132 | m/z=538.23(C₄₀H₂₂D₄N₂=538.69) |
| P1-133 | m/z=624.26(C₄₇H₃₂N₂=624.79) | P1-134 | m/z=660.26(C₅₀H₃₂N₂=660.82) |
| P1-135 | m/z=710.27(C₅₄H₃₄N₂=710.88) | P1-136 | m/z=548.13(C₃₄H₁₇F₅N₂=548.52) |
| P1-137 | m/z=458.18(C₃₄H₂₂N₂=458.56) | P1-138 | m/z=623.24(C₄₆H₂₉N₃=623.76) |
| P1-139 | m/z=610.24(C₄₆H₃₀N₂=610.76) | P1-140 | m/z=543.27(C₄₀H₁₇D₉N₂=543.72) |

### [Synthesis example 2] Compound of Formula 2

Compound represented by Formula 2 (Final Product 3) according to the present invention may be synthesized as shown in Reaction Scheme 2 below, but is not limited thereto.

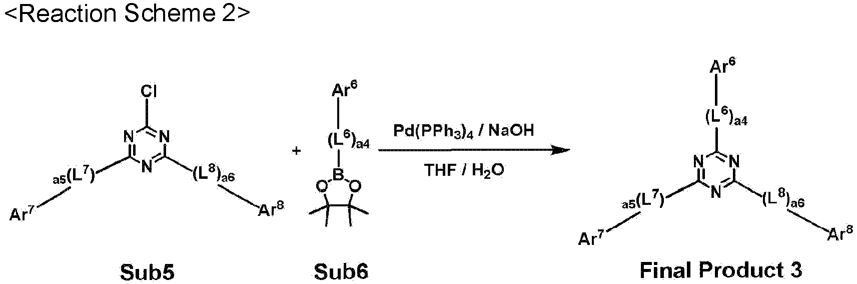

### 1. Synthesis example of P3-1

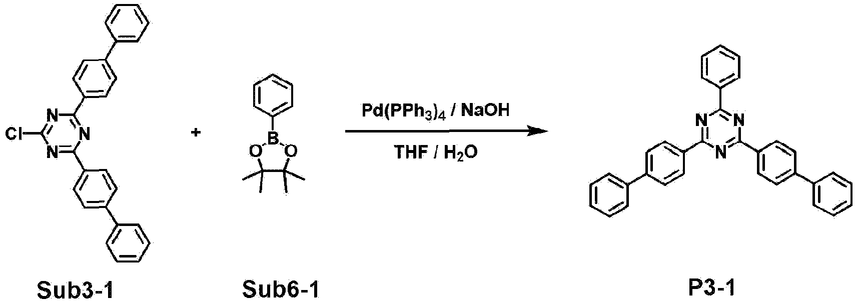

Sub3-1 (5.0 g, 24.5 mmol) was dissolved in tetrahydrofuran (THF) (123 mL), and Sub6-1 (10.3 g, 24.5 mmol), NaOH (2.9 g, 73.5 mmol), Pd(PPh₃)₄ (1.70 g, 1.47 mmol), and water (61 mL) were added thereto. The mixture was stirred at 80°C. After completion of the reaction, the mixture was extracted with CH₂Cl₂ and water. The organic layer was dried over MgSO₄ and concentrated. Then, the concentrate was purified by silica gel column chromatography and recrystallized to obtain 10.1 g of the product. (Yield: 89%)

### 2. Synthesis example of P3-25

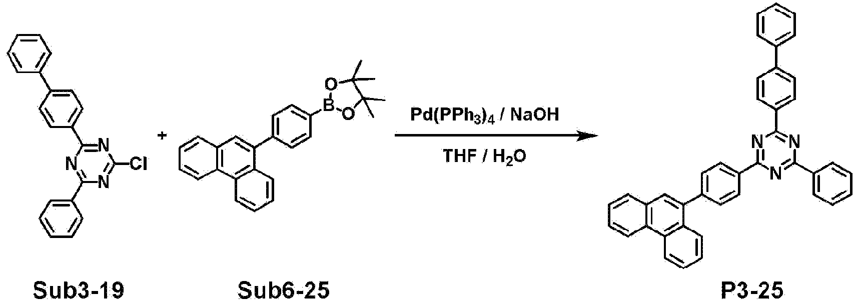

Sub3-19 (9.0 g, 26.3 mmol) was dissolved in THF (131 mL), and Sub6-25 (10.0 g, 26.3 mmol), NaOH (3.2 g, 78.9 mmol), Pd(PPh₃)₄ (1.82 g, 1.58 mmol), and water (66 mL) were added thereto. The synthesis was carried out in the same manner as in the synthesis example of P3-1 to obtain 10.2 g of the product. (Yield: 84%)

### 3. Synthesis example of P3-48

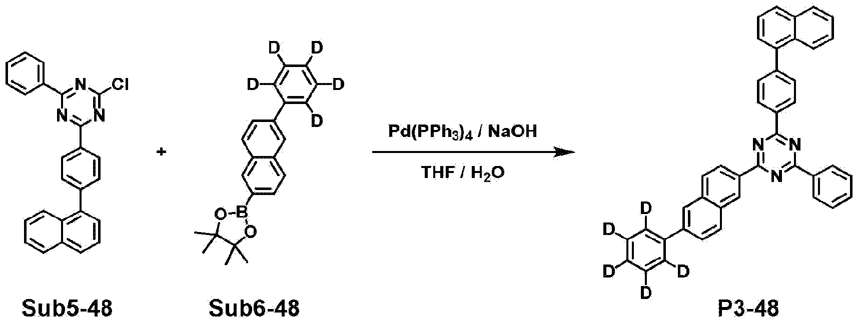

Sub5-48 (11.7 g, 29.8 mmol) was dissolved in THF (149 mL), and Sub6-48 (10.0 g, 29.8 mmol), NaOH (3.6 g, 89.5 mmol), Pd(PPh₃)₄ (2.07 g, 1.79 mmol), and water (75mL) were added thereto. The synthesis was carried out in the same manner as in the synthesis example of P3-1 to obtain 13.4 g of the product. (Yield: 79%)

### 4. Synthesis example of P3-75

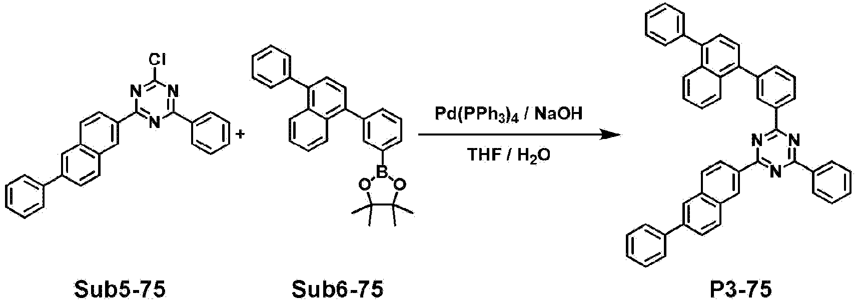

Sub5-75 (9.7 g, 24.6 mmol) was dissolved in THF (123 mL), and Sub6-75 (10.0 g, 24.6 mmol), NaOH (3.0 g, 73.8 mmol), Pd(PPh₃)₄ (1.71 g, 1.48 mmol), and water (62 mL) were added thereto. The synthesis was carried out in the same manner as in the synthesis example of P3-1 to obtain 12.9 g of the product. (Yield: 82%)

### 5. Synthesis example of P3-91

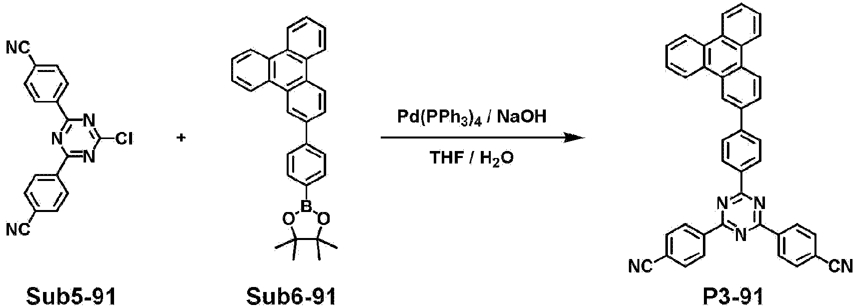

Sub5-91 (7.4 g, 23.2 mmol) was dissolved in THF (116 mL), and Sub6-91 (10.0 g, 23.2 mmol), NaOH (2.8 g, 69.7 mmol), Pd(PPh₃)₄ (1.61 g, 1.39 mmol), and water (58 mL) were added thereto. The synthesis was carried out in the same manner as in the synthesis example of P3-1 to obtain 11.6 g of the product. (Yield: 85%)

The FD-MS (Field Desorption-Mass Spectrometry) values of the compound of Formula 2 of the present invention prepared according to the above synthesis example are shown in Table 2 below.

**[Table 2]**

| Compound | FD-MS | Compound | FD-MS |
|---|---|---|---|
| P3-1 | m/z=461.19(C₃₃H₂₃N₃=461.57) | P3-2 | m/z=461.19(C₃₃H₂₃N₃=461.57) |
| P3-3 | m/z=537.22(C₃₉H₂₇N₃=537.67) | P3-4 | m/z=552.31(C₃₉H₁₂D₁₅N₃=552.76) |
| P3-5 | m/z=511.2(C₃₇H₂₅N₃=511.63) | P3-6 | m/z=485.19(C₃₅H₂₃N₃=485.59) |
| P3-7 | m/z=511.2(C₃₇H₂₅N₃=511.63) | P3-8 | m/z=485.19(C₃₅H₂₃N₃=485.59) |
| P3-9 | m/z=485.19(C₃₅H₂₃N₃=485.59) | P3-10 | m/z=516.24(C₃₇H₂₀D₅N₃=516.66) |
| P3-11 | m/z=561.22(C₄₁H₂₇N₃=561.69) | P3-12 | m/z=561.22(C₄₁H₂₇N₃=561.69) |
| P3-13 | m/z=561.22(C₄₁H₂₇N₃=561.69) | P3-14 | m/z=561.22(C₄₁H₂₇N₃=561.69) |
| P3-15 | m/z=561.22(C₄₁H₂₇N₃=561.69) | P3-16 | m/z=511.2(C₃₇H₂₅N₃=511.63) |
| P3-17 | m/z=511.2(C₃₇H₂₅N₃=511.63) | P3-18 | m/z=568.26(C₄₁H₂₀D₇N₃=568.73) |
| P3-19 | m/z=561.22(C₄₁H₂₇N₃=561.69) | P3-20 | m/z=587.24(C₄₃H₂₉N₃=587.73) |
| P3-21 | m/z=511.2(C₃₇H₂₅N₃=511.63) | P3-22 | m/z=440.2(C₃₁H₁₆D₅N₃=440.56) |
| P3-23 | m/z=561.22(C₄₁H₂₇N₃=561.69) | P3-24 | m/z=561.22(C₄₁H₂₇N₃=561.69) |
| P3-25 | m/z=561.22(C₄₁H₂₇N₃=561.69) | P3-26 | m/z=611.24(C₄₅H₂₉N₃=611.75) |
| P3-27 | m/z=637.25(C₄₇H₃₁N₃=637.79) | P3-28 | m/z=611.24(C₄₅H₂₉N₃=611.75) |
| P3-29 | m/z=587.24(C₄₃H₂₀N₃=587.73) | P3-30 | m/z=535.2(C₃₉H₂₅N₃=535.65) |
| P3-31 | m/z=561.22(C₄₁H₂₇N₃=561.69) | P3-32 | m/z=687.27(C₅₁H₃₃N₃=687.85) |
| P3-33 | m/z=561.22(C₄₁H₂₇N₃=561.69) | P3-34 | m/z=561.22(C₄₁H₂₇N₃=561.69) |
| P3-35 | m/z=587.24(C₄₃H₂₀N₃=587.73) | P3-36 | m/z=561.22(C₄₁H₂₇N₃=561.69) |
| P3-37 | m/z=561.22(C₄₁H₂₇N₃=561.69) | P3-38 | m/z=568.26(C₄₁H₂₀D₇N₃=568.73) |
| P3-39 | m/z=587.24(C₄₃H₂₉N₃=587.73) | P3-40 | m/z=516.24(C₃₇H₂₀D₅N₃=516.66) |
| P3-41 | m/z=587.24(C₄₃H₂₀N₃=587.73) | P3-42 | m/z=561.22(C₄₁H₂₇N₃=561.69) |
| P3-43 | m/z=587.24(C₄₃H₂₀N₃=587.73) | P3-44 | m/z=561.22(C₄₁H₂₇N₃=561.69) |
| P3-45 | m/z=637.25(C₄₇H₃₁N₃=637.79) | P3-46 | m/z=561.22(C₄₁H₂₇N₃=561.69) |
| P3-47 | m/z=535.2(C₃₉H₂₅N₃=535.65) | P3-48 | m/z=566.25(C₄₁ H₂₂D₅N₃=566.72) |
| P3-49 | m/z=511.2(C₃₇H₂₅N₃=511.63) | P3-50 | m/z=566.25(C₄₁H₂₂D₅N₃=566.72) |
| P3-51 | m/z=587.24(C₄₃H₂₉N₃=587.73) | P3-52 | m/z=535.2(C₃₉H₂₅N₃=535.65) |
| P3-53 | m/z=637.25(C₄₇H₃₁N₃=637.79) | P3-54 | m/z=561.22(C₄₁H₂₇N₃=561.69) |
| P3-55 | m/z=561.22(C₄₁H₂₇N₃=561.69) | P3-56 | m/z=561.22(C₄₁H₂₇N₃=561.69) |
| P3-57 | m/z=585.22(C₄₃H₂₇N₃=585.71) | P3-58 | m/z=611.24(C₄₅H₂₉N₃=611.75) |
| P3-59 | m/z=641.28(C₄₇H₂₇D₄N₃=641.81) | P3-60 | m/z=535.2(C₃₉H₂₅N₃=535.65) |
| P3-61 | m/z=535.2(C₃₉H₂₅N₃=535.65) | P3-62 | m/z=535.2(C₃₉H₂₅N₃=535.65) |
| P3-63 | m/z=545.27(C₃₉H₁₅D₁₀N₃=545.71) | P3-64 | m/z=535.2(C₃₉H₂₅N₃=535.65) |
| P3-65 | m/z=613.25(C₄₅H₃₁N₃=613.76) | P3-66 | m/z=537.22(C₃₉H₂₇N₃=537.67) |
| P3-67 | m/z=511.2(C₃₇H₂₅N₃=511.63) | P3-68 | m/z=587.24(C₄₃H₂₉N₃=587.73) |
| P3-69 | m/z=587.24(C₄₃H₂₉N₃=587.73) | P3-70 | m/z=637.25(C₄₇H₃₁N₃=637.79) |
| P3-71 | m/z=637.25(C₄₇H₃₁N₃=637.79) | P3-72 | m/z=592.27(C₄₃H₂₄D₅N₃=592.76) |
| P3-73 | m/z=511.2(C₃₇H₂₅N₃=511.63) | P3-74 | m/z=597.3(C₄₃H₁₉D₁₀N₃=597.79) |
| P3-75 | m/z=637.25(C₄₇H₃₁N₃=637.79) | P3-76 | m/z=637.25(C₄₇H₃₁N₃=637.79) |
| P3-77 | m/z=561.22(C₄₁H₂₇N₃=561.69) | P3-78 | m/z=561.22(C₄₁H₂₇N₃=561.69) |
| P3-79 | m/z=571.28(C₄₁H₁₇D₁₀N₃=571.75) | P3-80 | m/z=611.24(C₄₅H₂₉N₃=611.75) |
| P3-81 | m/z=611.24(C₄₅H₂₉N₃=611.75) | P3-82 | m/z=561.22(C₄₁ H₂₇N₃=561.69) |
| P3-83 | m/z=561.22(C₄₁H₂₇N₃=561.69) | P3-84 | m/z=611.24(C₄₅H₂₉N₃=611.75) |
| P3-85 | m/z=561.22(C₄₁H₂₇N₃=561.69) | P3-86 | m/z=561.22(C₄₁H₂₇N₃=561.69) |
| P3-87 | m/z=611.24(C₄₅H₂₉N₃=611.75) | P3-88 | m/z=611.24(C₄₅H₂₉N₃=611.75) |
| P3-89 | m/z=611.24(C₄₅H₂₉N₃=611.75) | P3-90 | m/z=535.2(C₃₉H₂₅N₃=535.65) |
| P3-91 | m/z=585.2(C₄₁ H₂₃N₅=585.67) | P3-92 | m/z=410.15(C₂₈H₁₈N₄=410.48) |

### [Synthesis example of 3] Compound of Formula 3

Compound represented by Formula 3 (Final Product 4) according to the present invention may be synthesized as shown in Reaction Scheme below, but is not limited thereto.

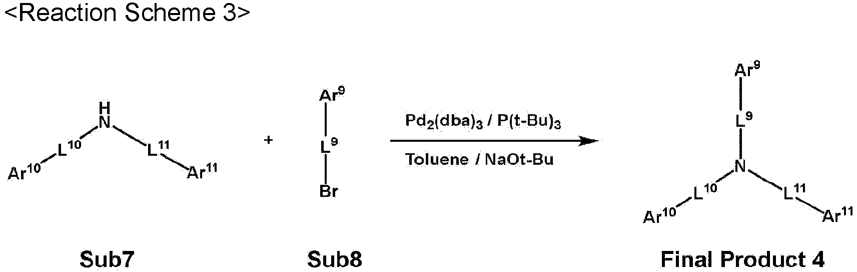

### 1. Synthesis example of P4-1

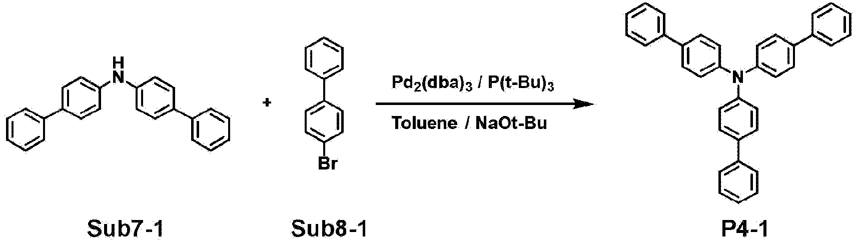

Sub7-1 (10.0 g, 31.1 mmol) was dissolved in toluene (156 mL), and Sub8-1 (7.3 g, 31.1 mmol) Pd₂(dba)₃ (0.85 g, 0.93 mmol), P(t-Bu)₃ (0.38 g, 1.87 mmol), and NaOt-Bu (6.0 g, 62.2 mmol) were added thereto, and the reaction was carried out at 80 °C.

Upon completion of the reaction, the mixture was extracted with CH₂Cl₂ and water. The organic layer was dried over MgSO₄ and concentrated. Then, the concentrate was purified by silica gel column chromatography and recrystallized to obtain 11.5 g of the product. (Yield: 78%)

### 2. Synthesis example of P4-20

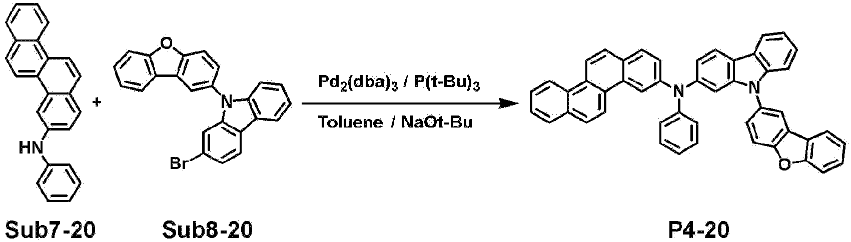

Sub7-20 (10.0 g, 31.3 mmol) was dissolved in toluene (157 mL), and Sub8-20 (12.9 g, 31.3 mmol), Pd₂(dba)₃ (0.86 g, 0.94 mmol), P(t-Bu)₃ (0.38 g, 1.88 mmol), and NaOt-Bu (6.0 g, 62.6 mmol) were added thereto. The synthesis was carried out in the same manner as in the synthesis example of P4-1 to obtain 15.3 g of the product. (Yield: 75%)

### 3. Synthesis example of P4-22

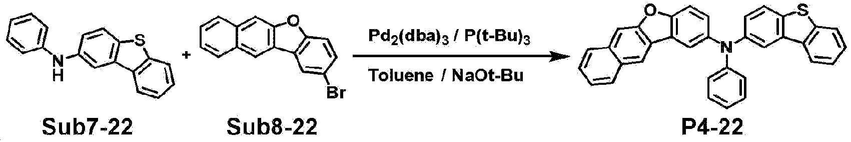

Sub7-22 (10.0 g, 36.3 mmol) was dissolved in toluene (182 mL), and Sub8-22 (10.8 g, 36.3 mmol), Pd₂(dba)₃ (1.0 g, 1.09 mmol), P(t-Bu)₃ (0.44 g, 2.18 mmol), NaOt-Bu (7.0 g, 72.6 mmol) were added thereto. The synthesis was carried out in the same manner as in the synthesis example of P4-1 to obtain 13.0 g of the product. (Yield: 73%)

### 4. Synthesis example of P4-43

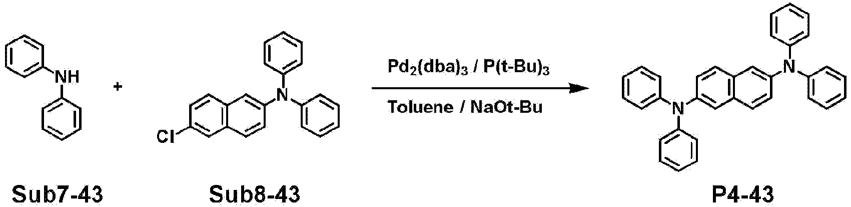

Sub7-43 (5.0 g, 29.5 mmol) was dissolved in toluene (148 mL), and Sub8-43 (9.7 g, 29.5 mmol), Pd₂(dba)₃ (0.81 g, 0.89 mmol), P(t-Bu)₃ (0.36 g, 1.77 mmol), NaOt-Bu (5.7 g, 59.1 mmol) were added thereto. The synthesis was carried out in the same manner as in the synthesis example of P4-1 to obtain 10.5 g of the product. (Yield: 77%)

### 5. Synthesis example of P4-61

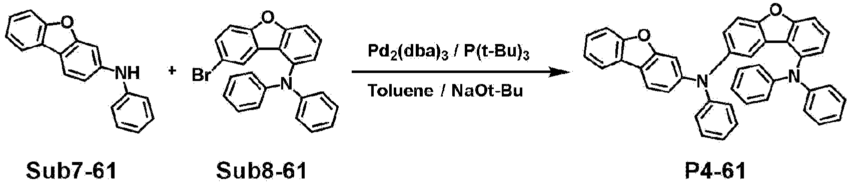

Sub7-61 (10.0 g, 38.6 mmol)was dissolved in toluene (193 mL), and Sub8-61 (16.0 g, 38.6 mmol), Pd₂(dba)₃ (1.06 g, 1.16 mmol), P(t-Bu)₃ (0.47 g, 2.31 mmol), NaOt-Bu (7.4 g, 77.1 mmol) were added thereto. The synthesis was carried out in the same manner as in the synthesis example of P4-1 to obtain 16.0 g of the product. (Yield: 70%)

The FD-MS (Field Desorption-Mass Spectrometry) values of the compound of Formula 3 of the present invention prepared according to the above synthesis example are shown in Table 3 below.

**[Table 3]**

| Compound | FD-MS | Compound | FD-MS |
|---|---|---|---|
| P4-1 | m/z=473.21(C₃₆H₂₇N=473.62) | P4-2 | m/z=473.21(C₃₆H₂₇N=473.62) |
| P4-3 | m/z=447.2(C₃₄H₂₅N=447.58) | P4-4 | m/z=447.2(C₃₄H₂₅N=447.58) |
| P4-5 | m/z=523.23(C₄₀H₂₉N=523.68) | P4-6 | m/z=573.25(C₄₄H₃₁N=573.74) |
| P4-7 | m/z=573.25(C₄₄H₃₁N=573.74) | P4-8 | m/z=699.29(C₅₄H₃₇N=699.9) |
| P4-9 | m/z=607.32(C₄₆H₄₁N=607.84) | P4-10 | m/z=491.26(C₃₇H₃₃N=491.68) |
| P4-11 | m/z=565.36(C₄₂H₂₇D₁₀N=565.83) | P4-12 | m/z=585.34(C₄₄H₁₃N=585.83) |
| P4-13 | m/z=492.22(C₃₆H₂₀D₅NO=492.63) | P4-14 | m/z=527.22(C₃₉H₂₉NO=527.67) |
| P4-15 | m/z=441.12(C₃₀H₁₉NOS=441.55) | P4-16 | m/z=576.22(C₄₂H₂₈N₂O=576.7) |
| P4-17 | m/z=537.21(C₄₀H₂₇NO=537.66) | P4-18 | m/z=544.16(C₃₇H₂₄N₂OS=544.67) |
| P4-19 | m/z=593.18(C₄₂H₂₇NOS=593.74) | P4-20 | m/z=650.24(C₄₈H₃₀N₂O=650.78) |
| P4-21 | m/z=553.19(C₄₀H₂₇NS=553.72) | P4-22 | m/z=491.13(C₃₄H₂₁NOS=491.61) |
| P4-23 | m/z=567.17(C₄₀H₂₅NOS=567.71) | P4-24 | m/z=657.18(C₄₆H₂₇NO₂S=657.79) |
| P4-25 | m/z=593.18(C₄₂H₂₇NOS=593.74) | P4-26 | m/z=626.24(C₄₆H₃₀N₂O=626.76) |
| P4-27 | m/z=643.2(C₄₆H₂₉NOS=643.8) | P4-28 | m/z=525.17(C₃₈H₂₃NO₂=525.61) |
| P4-29 | m/z=550.25(C₃₉H₂₆D₅NS=550.77) | P4-30 | m/z=665.24(C₄₉H₃₁NO₂=665.79) |
| P4-31 | m/z=509.22(C₃₆H₃₁NS=509.71) | P4-32 | m/z=701.27(C₅₃H₃₅NO=701.87) |
| P4-33 | m/z=564.26(C₄₂H₃₂N₂=564.73) | P4-34 | m/z=564.26(C₄₂H₃₂N₂=564.73) |
| P4-35 | m/z=670 .24(C₄₈H₃₄N₂S=670.87) | P4-36 | m/z=564.26(C₄₂H₃₂N₂=564.73) |
| P4-37 | m/z=664.29(C₅₀H₃₆N₂=664.85) | P4-38 | m/z=564.26(C₄₂H₃₂N₂=564.73) |
| P4-39 | m/z=564.26(C₄₂H₃₂N₂=564.73) | P4-40 | m/z=462.21(C₃₄H₂₆N₂=462.6) |
| P4-41 | m/z=462.21(C₃₄H₂₆N₂=462.6) | P4-42 | m/z=462.21(C₃₄H₂₆N₂=462.6) |
| P4-43 | m/z=462.21(C₃₄H₂₆N₂=462.6) | P4-44 | m/z=512.23(C₃₈H₂₈N₂=512.66) |
| P4-45 | m/z=518.18(C₃₆Hz₆N₂S=518.68) | P4-46 | m/z=602.24(C₄₄H₃₀N₂O=602.74) |
| P4-47 | m/z=578.24(C₄₂H₃₀N₂O=578.72) | P4-48 | m/z=608.19(C₄₂H₂₈N₂OS=608.76) |
| P4-49 | m/z=608.19(C₄₂H₂₈N₂OS=608.76) | P4-50 | m/z=654.27(C₄₈H₃₄N₂O=654.81) |
| P4-51 | m/z=628.25(C₄₆H₃₂N₂O=628.77) | P4-52 | m/z=684.22(C₄₈H₃₂N₂OS=684.86) |
| P4-53 | m/z=518.18(C₃₆H₂₆N₂S=518.68) | P4-54 | m/z=608.19(C₄₂H₂₈N₂OS=608.76) |
| P4-55 | m/z=624.17(C₄₂H₂₈N₂S₂=624.82) | P4-56 | m/z=684.22(C₄₈H₃₂N₂OS=684.86) |
| P4-57 | m/z=577.25(C₄₂H₃₁N₃=577.73) | P4-58 | m/z=759.27(C₅₄H₃₇N₃S=759.97) |
| P4-59 | m/z=644.26(C₄₆H₃₆N₂Si=644.89) | P4-60 | m/z=644.32(C₄₈H₄₀N₂=644.86) |
| P4-61 | m/z=592.22(C₄₂H₂₈N₂O₂=592.7) | P4-62 | m/z=684.22(C₄₈H₃₂N₂OS=684.86) |
| P4-63 | m/z=678.30(C₅₁H₃₈N₂=678.88) | P4-64 | m/z=628.22(C₄₅H₂₈N₅O₂=628.73) |

### Manufacturing and Evaluation of organic electronic device

### [Test Example 1] Red organic electroluminescent device (phosphorescent host)

A hole injection layer having a thickness of 70 nm was formed by vacuum-depositing N¹-(naphthalen-2-yl)-N⁴,N⁴-bis(4-(naphthalen-2-yl(phenyl)amino)phenyl)-N¹-phenylbenzene-1,4-diamine (hereinafter abbreviated as 2-TNATA) on an ITO layer (anode) formed on a glass substrate, and then a hole transport layer was formed by vacuum-depositing N,N'-bis(1-naphthalenyl)-N,N'-bis-phenyl-(1,1'-biphenyl)-4,4'-diamine (hereinafter abbreviated as NPB) to a thickness of 70 nm on the hole injection layer.

Next, a emission-auxiliary layer was formed by vacuum-depositing tris(4-(9H-carbazol-9-yl)phenyl)amine (hereinafter abbreviated as TCTA) to a thickness of 30 nm on the hole transport layer.

Subsequently, an emission layer having a thickness of 30 nm was deposited on the emission-auxiliary layer using a mixture of the inventive compounds P1-41 (first host), P3-16 (second host), and P4-24 (third host) as hosts in a weight ratio of 3:5:2, and bis(1-phenylisoquinolyl)iridium(III) acetylacetonate (hereinafter abbreviated as (piq)₂Ir(acac)) as a dopant, wherein the dopant was doped into the host mixture at a weight ratio of 95:5 between the host and the dopant.

Next, a hole blocking layer having a thickness of 10 nm was formed by vacuum-depositing (1,1'-bisphenyl-4-yl oleato)bis(2-methyl-8-quinolinolato)aluminum (hereinafter abbreviated as BAlq) on the emission layer, and an electron transport layer was formed by vacuum-depositing bis(10-hydroxybenzo[h]quinolinato)beryllium (hereinafter abbreviated as BeBq₂) to a thickness of 40 nm on the hole blocking layer.

Subsequently, an electron injection layer having a thickness of 0.2 nm was formed by depositing LiF on the electron transporting layer, followed by deposition of Al to form a cathode having a thickness of 150 nm.

### [Test Example 2] to [Test Example 45]

Organic electroluminescent devices were fabricated in the same manner as in Test Example 1, except that a mixture of the first host, second host, and third host as listed in Table 4 was used as the host material.

### [Comparative Example 1]

Organic electroluminescent devices were fabricated in the same manner as in the Test Example 1, except that a mixture of Comparative compound A (first host), Comparative compound B (second host), compound P4-63 (third host) as listed in Table 4 was used as the host material.

### [Comparative Example 2]

Organic electroluminescent devices were fabricated in the same manner as in the Test Example 1, except that a mixture of Comparative compound A (first host), Comparative compound B (second host), compound P4-35 (third host) as listed in Table 4 was used as the host material.

### [Comparative Example 3]

Organic electroluminescent devices were fabricated in the same manner as in the Test Example 1, except that a mixture of Comparative compound A (first host), compound P3-90 (second host), compound P4-63 (third host) as listed in Table 4 was used as the host material.

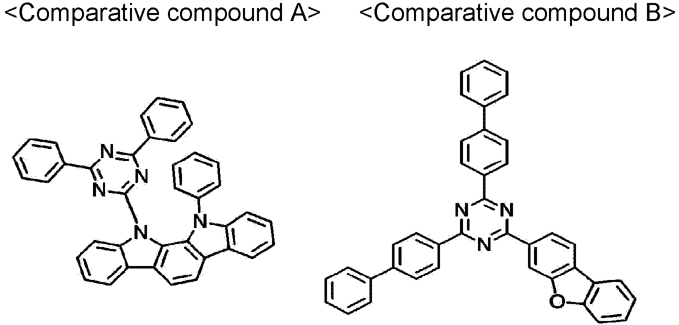

The electroluminescent (EL) characteristics of the organic electroluminescent devices fabricated according to the Test Examples of the present invention and Comparative Examples were measured by applying a forward DC voltage using a PR-650 photometer from Photo Research. The T95 lifetime was measured at a standard luminance of 2500 cd/m² using a lifetime measurement system manufactured by Mc Science. The measurement results are shown in Table 4 below.

**[Table 4]**

| | first host | second host | third host | Voltage (V) | Current Density (mA/cm²) | Efficiency (cd/A) | Lifetime T(95) |
|---|---|---|---|---|---|---|---|
| comp.Ex(1) | Comp. compd A | Comp. compd B | P4-63 | 5.3 | 10.2 | 24.5 | 97.2 |
| comp.Ex(2) | Comp. compd A | Comp. compd B | P4-35 | 5.2 | 10.3 | 24.2 | 96.3 |
| comp.Ex(3) | Comp. compd A | P3-90 | P4-63 | 5.1 | 9.9 | 25.3 | 98.3 |
| Test Ex.(1) | P1-41 | P3-16 | P4-24 | 4.8 | 7.4 | 33.9 | 119.4 |
| Test Ex.(2) | P1-41 | P3-16 | P4-35 | 4.9 | 7.3 | 34.2 | 116.2 |
| Test Ex.(3) | P1-41 | P3-16 | P4-63 | 4.9 | 7.6 | 33.0 | 111.4 |
| Test Ex.(4) | P1-41 | P3-25 | P4-24 | 4.7 | 7.0 | 35.6 | 128.0 |
| Test Ex.(5) | P1-41 | P3-25 | P4-35 | 4.8 | 7.0 | 35.9 | 124.6 |
| Test Ex.(6) | P1-41 | P3-25 | P4-63 | 4.8 | 7.2 | 34.7 | 119.4 |
| Test Ex.(7) | P1-41 | P3-48 | P4-24 | 4.8 | 7.1 | 35.0 | 124.3 |
| Test Ex.(8) | P1-41 | P3-48 | P4-35 | 4.8 | 7.1 | 35.3 | 121.0 |
| Test Ex.(9) | P1-41 | P3-48 | P4-63 | 4.9 | 7.3 | 34.1 | 116.0 |
| Test Ex.(10) | P1-41 | P3-75 | P4-24 | 4.8 | 7.1 | 35.1 | 126.9 |
| Test Ex.(11) | P1-41 | P3-75 | P4-35 | 4.8 | 7.1 | 35.4 | 123.5 |
| Test Ex.(12) | P1-41 | P3-75 | P4-63 | 4.9 | 7.3 | 34.2 | 118.4 |
| Test Ex.(13) | P1-41 | P3-90 | P4-24 | 4.8 | 7.3 | 34.4 | 120.6 |
| Test Ex.(14) | P1-41 | P3-90 | P4-35 | 4.8 | 7.2 | 34.7 | 117.4 |
| Test Ex.(15) | P1-41 | P3-90 | P4-63 | 4.9 | 7.5 | 33.5 | 112.5 |
| Test Ex.(16) | P1-81 | P3-16 | P4-24 | 4.8 | 7.1 | 35.3 | 123.4 |
| Test Ex.(17) | P1-81 | P3-16 | P4-35 | 4.8 | 7.0 | 35.6 | 120.0 |
| Test Ex.(18) | P1-81 | P3-16 | P4-63 | 4.9 | 7.3 | 34.4 | 115.1 |
| Test Ex.(19) | P1-81 | P3-25 | P4-24 | 4.7 | 6.7 | 37.1 | 132.2 |
| Test Ex.(20) | P1-81 | P3-25 | P4-35 | 4.7 | 6.7 | 37.4 | 128.7 |
| Test Ex.(21) | P1-81 | P3-25 | P4-63 | 4.8 | 6.9 | 36.1 | 123.4 |
| Test Ex.(22) | P1-81 | P3-48 | P4-24 | 4.7 | 6.9 | 36.5 | 128.4 |
| Test Ex.(23) | P1-81 | P3-48 | P4-35 | 4.8 | 6.8 | 36.8 | 124.9 |
| Test Ex.(24) | P1-81 | P3-48 | P4-63 | 4.8 | 7.0 | 35.5 | 119.8 |
| Test Ex.(25) | P1-81 | P3-75 | P4-24 | 4.7 | 6.8 | 36.6 | 131.1 |
| Test Ex.(26) | P1-81 | P3-75 | P4-35 | 4.8 | 6.8 | 36.9 | 127.6 |
| Test Ex.(27) | P1-81 | P3-75 | P4-63 | 4.8 | 7.0 | 35.7 | 122.3 |
| Test Ex.(28) | P1-81 | P3-90 | P4-24 | 4.7 | 7.0 | 35.8 | 124.6 |
| Test Ex.(29) | P1-81 | P3-90 | P4-35 | 4.8 | 6.9 | 36.1 | 121.2 |
| Test Ex.(30) | P1-81 | P3-90 | P4-63 | 4.8 | 7.2 | 34.9 | 116.2 |
| Test Ex.(31) | P1-99 | P3-16 | P4-24 | 4.8 | 7.2 | 34.7 | 121.9 |
| Test Ex.(32) | P1-99 | P3-16 | P4-35 | 4.8 | 7.1 | 35.0 | 118.6 |
| Test Ex.(33) | P1-99 | P3-16 | P4-63 | 4.9 | 7.4 | 33.8 | 113.7 |
| Test Ex.(34) | P1-99 | P3-25 | P4-24 | 4.7 | 6.8 | 36.5 | 130.7 |
| Test Ex.(35) | P1-99 | P3-25 | P4-35 | 4.8 | 6.8 | 36.8 | 127.2 |
| Test Ex.(36) | P1-99 | P3-25 | P4-63 | 4.8 | 7.0 | 35.6 | 121.9 |
| Test Ex.(37) | P1-99 | P3-48 | P4-24 | 4.8 | 7.0 | 35.9 | 126.9 |
| Test Ex.(38) | P1-99 | P3-48 | P4-35 | 4.8 | 6.9 | 36.2 | 123.5 |
| Test Ex.(39) | P1-99 | P3-48 | P4-63 | 4.9 | 7.2 | 34.9 | 118.4 |
| Test Ex.(40) | P1-99 | P3-75 | P4-24 | 4.7 | 6.9 | 36.0 | 129.6 |
| Test Ex.(41) | P1-99 | P3-75 | P4-35 | 4.8 | 6.9 | 36.3 | 126.1 |
| Test Ex.(42) | P1-99 | P3-75 | P4-63 | 4.8 | 7.1 | 35.1 | 120.9 |
| Test Ex.(43) | P1-99 | P3-90 | P4-24 | 4.8 | 7.1 | 35.3 | 123.1 |
| Test Ex.(44) | P1-99 | P3-90 | P4-35 | 4.8 | 7.0 | 35.5 | 119.8 |
| Test Ex.(45) | P1-99 | P3-90 | P4-63 | 4.9 | 7.3 | 34.3 | 114.9 |

As shown in Table 4, it can be seen that when a first to a third hosts are used in a mixture, the driving voltage of an organic electroluminescent device can be reduced, and the efficiency and lifespan of an organic electroluminescent device are significantly improved when a mixture of the compounds of Formulae 1 to 3 of the present invention is used as a mixed-host, compared to the case where a first host is Comparative Compound A, a second host is Comparative Compound B, and a third host is a compound of Formula 3 of the present invention (Comparative Examples 1 and 2), or the case where a first host is Comparative Compound A, a second host is a compound of Formula 2 of the present invention, and a third host is a host of Formula 3 of the present invention (Comparative Example 3). In particular, Comparative Examples 1 to 3 use Comparative Compound A as a first host of the mixed host, and Comparative Example 3 differs from the present invention only in a first host. Comparative Compound A has a five-ring structure of the indolocarbazole type, whereas the compound represented by Formula 1 has a structure comprising six or more rings. When one or more benzene rings or the like are fused to a compound having a five-ring core such as Comparative Compound A, resulting in a six-ring or larger core as in Formula 1 of the present invention, the physical properties of the compound, particularly the energy level, are altered. It appears that such changes in physical properties have affected the overall performance of the device.

The HOMO values of Comparative Compound A and P1-41 measured using the DFT method (B3LYP/6-31g(D)) in the Gaussian program are shown in Table 5 below.

**[Table 5]**

| Compound | G.HOMO |
|---|---|
| Comp. compd A | -5.131 |
| P1-41 | -5.038 |

As shown in Table 5, it can be seen that compound P1-41 of the present invention has a higher HOMO value compared to Comparative Compound A. This indicates that when a compound of Formula 1 of the present invention is used as one component of the mixed host, holes transported from the hole transport region can be more effectively injected into the emission layer, and the holes injected into the emission layer can be more efficiently injected into the dopant. Therefore, it can be seen that using a mixture of the compounds represented by Formulae 1 to 3 of the present invention as the host can improve the performance of the device.

The foregoing description is merely illustrative of the present invention and various modifications may be made by those of ordinary skill in the art without departing from the essential characteristics of the invention. The scope of protection of the present invention should be interpreted based on the following claims, and all technical equivalents thereof should be construed as falling within the scope of the invention.

## Claims

1. An organic electronic device comprising a first electrode, a second electrode, and an organic layer formed between the first electrode and the second electrode,
wherein the organic layer comprises an emission layer, and the emission layer comprises compound represented by Formula 1, compound represented by Formula 2 and compound represented by Formula 3: 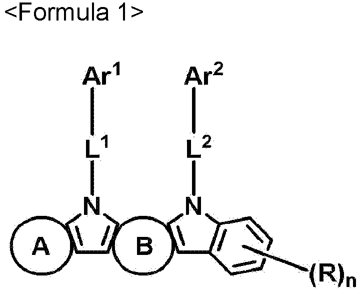 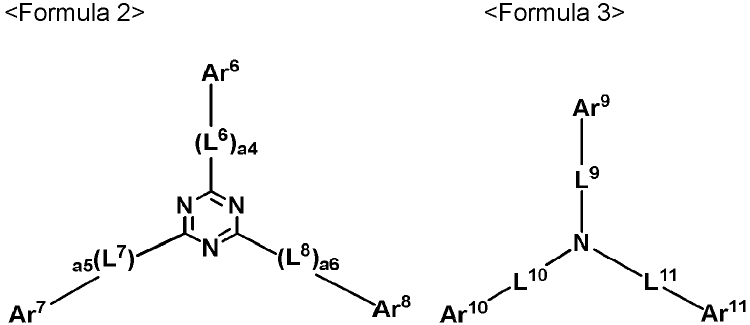 wherein:
ring A and ring B are each independently a C₆-C₂₀ aryl ring, wherein at least one of ring A and ring B is a C₁₀ or greater aryl ring, and ring A and ring B may each be substituted with one or more R₁,
R and R₁ are each independently selected from the group consisting of hydrogen; deuterium; halogen; a cyano group; a nitro group; a C₆-C₆₀ aryl group; a fluorenyl group; a C₂-C₆₀ heterocyclic group containing at least one heteroatom of O, N, S, Si and P; a C₃-C₆₀ aliphatic ring group; a C₁-C₂₀ alkyl group; a C₂-C₂₀ alkenyl group; a C₂-C₂₀ alkynyl group; a C₁-C₂₀ alkoxyl group; and a C₆-C₆₀ aryloxy group, and adjacent groups may be bonded to each other to form a ring, n is an integer of 0 to 4,
Ar¹ and Ar² are each independently selected from the group consisting of a C₆-C₆₀ aryl group; a fluorenyl group; a C₃-C₆₀ aliphatic ring group; and a C₂-C₆₀ heterocyclic group containing at least one heteroatom of O, N, S, Si and P,
L¹ and L² are each independently selected from the group consisting of a single bond; a C₆-C₆₀ arylene group; a fluorenylene group; a C₃-C₆₀ aliphatic ring group; and a C₂-C₆₀ heterocyclic group containing at least one heteroatom of O, N, S, Si and P,
Ar⁶ to Ar⁸ are each independently a C₆-C₆₀ aryl group,
L⁶ to L⁸ are each independently a single bond; or a C₆-C₆₀ arylene group,
a4 to a6 are each an integer of 0 to 3,
Ar⁹ to Ar¹¹ each independently selected from the group consisting of a C₆-C₆₀ aryl group; a fluorenyl group; a C₃-C₆₀ aliphatic ring group; a C₂-C₃₀ heterocyclic group containing at least one heteroatom of O, N, S, Si and P; a C₁-C₂₀ alkyl group; and -L¹²-N(Ar^{a})(Ar^{b}),
L⁹ to L¹² are each independently selected from the group consisting of a single bond; a C₆-C₆₀ arylene group; a fluorenylene group; a C₃-C₆₀ aliphatic ring group; and a C₂-C₆₀ heterocyclic group containing at least one heteroatom of O, N, S, Si and P,
Ar^{a} and Ar^{b} are each independently selected from the group consisting of a C₆-C₆₀ aryl group; a fluorenyl group; a C₃-C₆₀ aliphatic ring group; and a C₂-C₆₀ heterocyclic group containing at least one heteroatom of O, N, S, Si and P,
Ar¹, Ar², Ar⁹ to Ar¹¹, Ar^{a}, Ar^{b}, L¹, L², L⁹ to L¹², R, R₁, and the ring formed by adjacent groups may be each substituted with one or more substituents selected from the group consisting of deuterium; halogen; a silane group unsubstituted or substituted with a C₁-C₂₀ alkyl group or a C₆-C₂₀ aryl group; a phosphine oxide substituted or unsubstituted with a C₁-C₂₀ alkyl group or a C₆-C₂₀ aryl group; siloxane group; a cyano group; a nitro group; a C₁-C₂₀ alkylthio group; a C₁-C₂₀ alkoxy group; a C₆-C₃₀ aryloxy group; a C₆-C₃₀ arylthio group; a C₁-C₂₀ alkyl halide group; a C₁-C₂₀ alkyl group; a C₂-C₂₀ alkenyl group; a C₂-C₂₀ alkynyl group; a C₆-C₃₀ aryl group; a fluorenyl group; a C₂-C₃₀ heterocyclic group comprising at least one heteroatom selected from the group consisting of O, N, S, Si and P; and a C₃-C₃₀ aliphatic ring group, and
Ar⁶ to Ar⁸, L⁶ to L⁸ may be each substituted with one or more substituents selected from the group consisting of deuterium; a cyano group; a C₆-C₃₀ aryl group; and a C₆-C₃₀ aryl group substituted with deuterium.

2. The organic electronic device of claim 1, wherein Formula 1 is represented by one of Formula 1-1 to Formula 1-6: 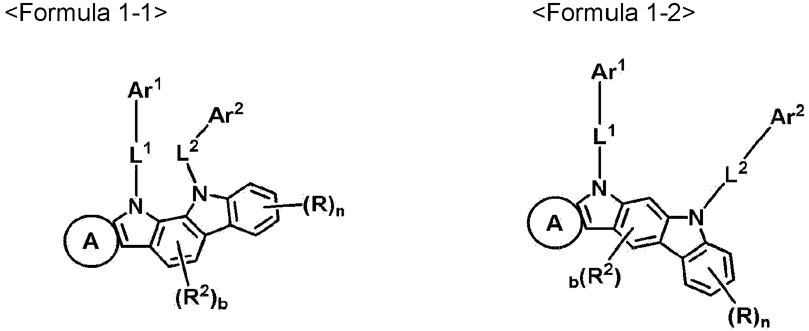 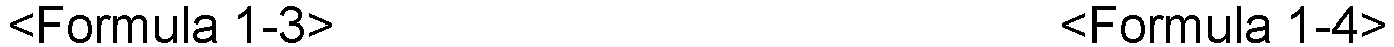 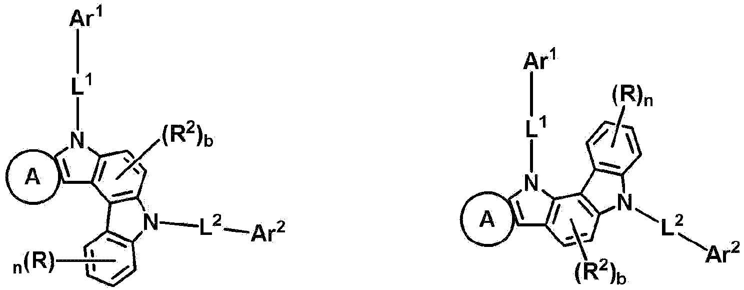 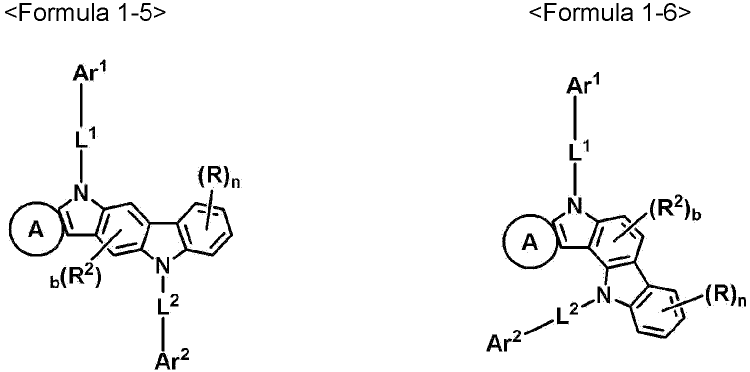 wherein ring A, L¹, L², Ar¹, Ar², R, n are the same as defined in claim 1, R² is the same as R₁ in claim 1, and b is an integer of 0 to 2.

3. The organic electronic device of claim 1, wherein Formula 1 is represented by one of Formula 1-11 to Formula 1-13: 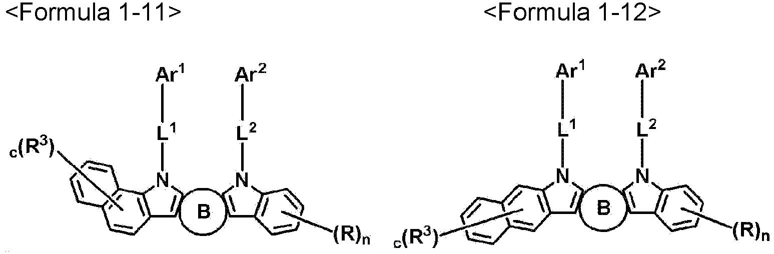 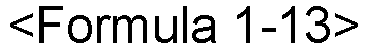 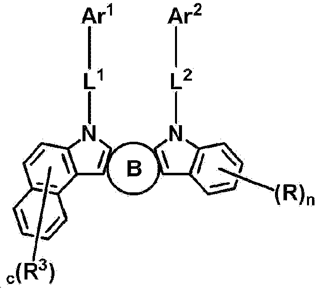 wherein ring B, L¹, L², Ar¹, Ar², R, n are the same as defined in claim 1, R³ is the same as R₁ in claim 1, and c is an integer of 0 to 6.

4. The organic electronic device of claim 1, wherein compound represented by Formula 1 is one of the following compounds:

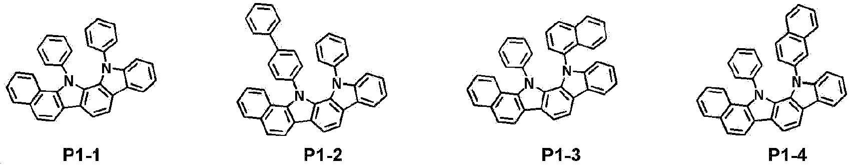

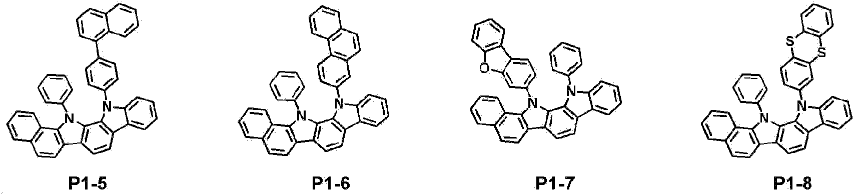

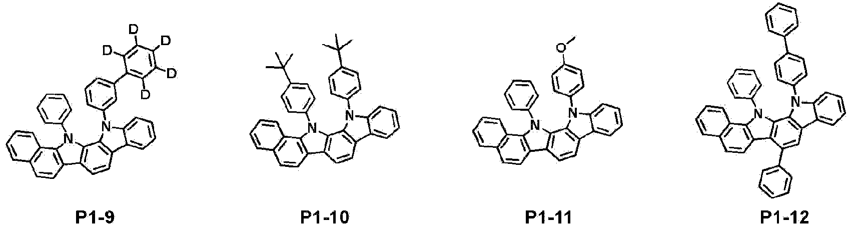

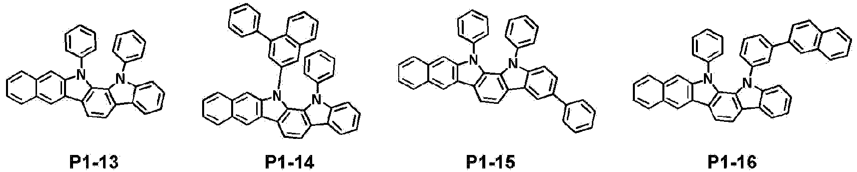

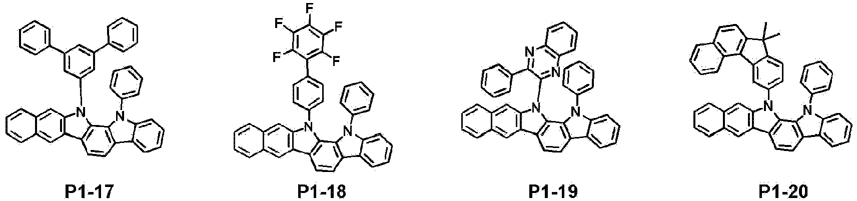

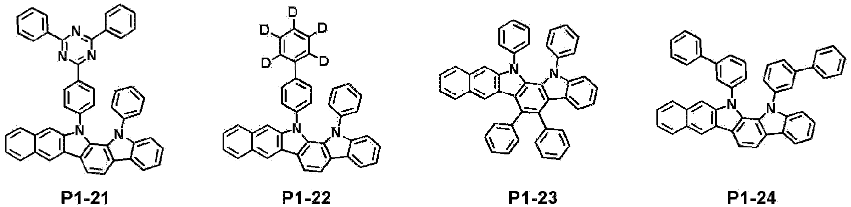

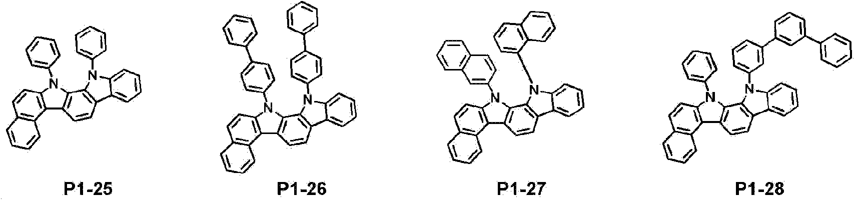

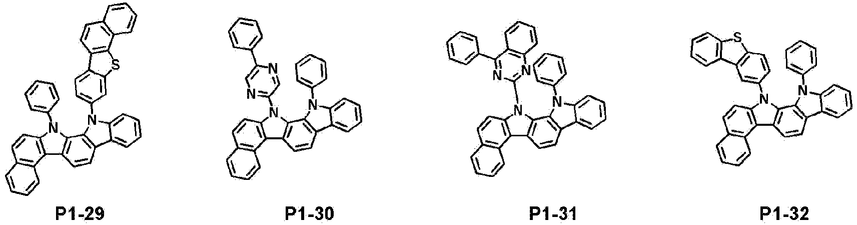

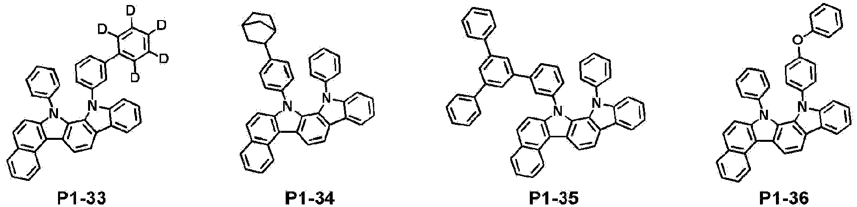

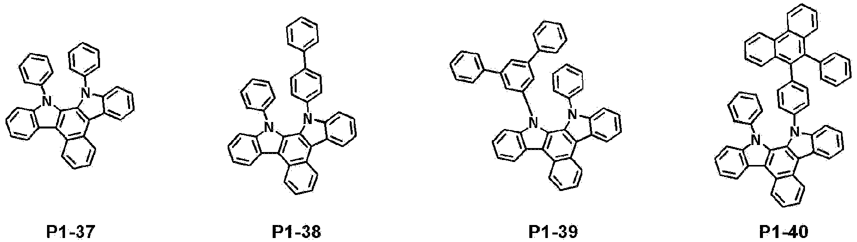

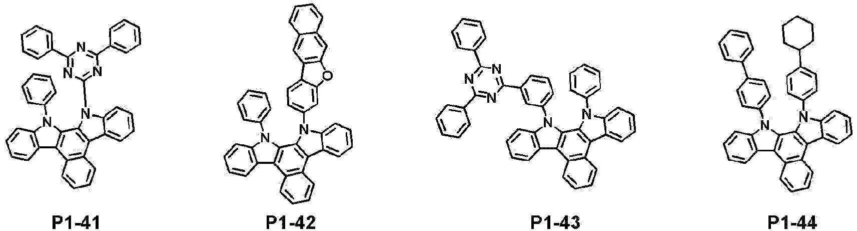

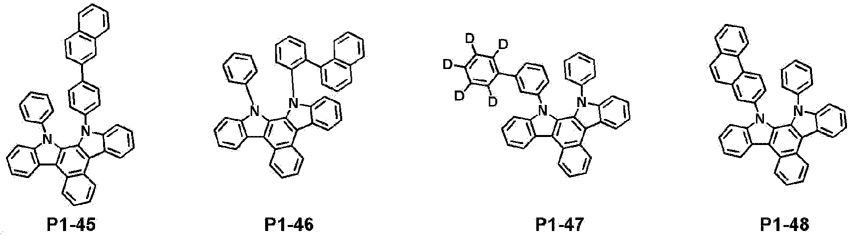

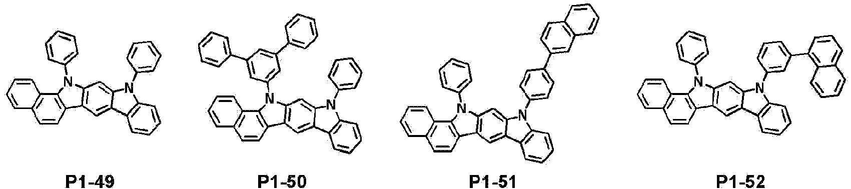

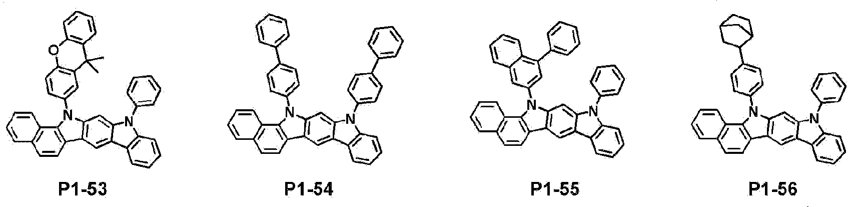

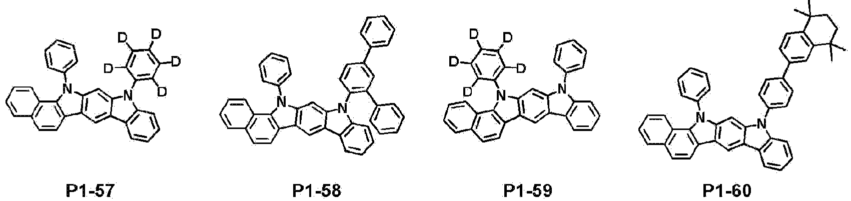

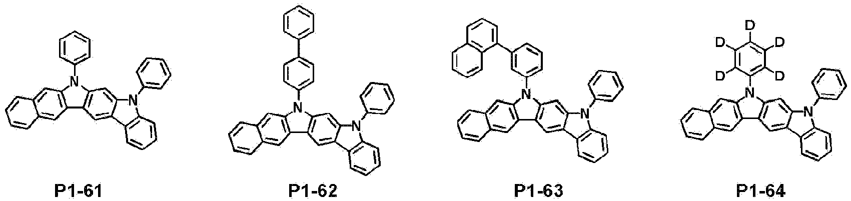

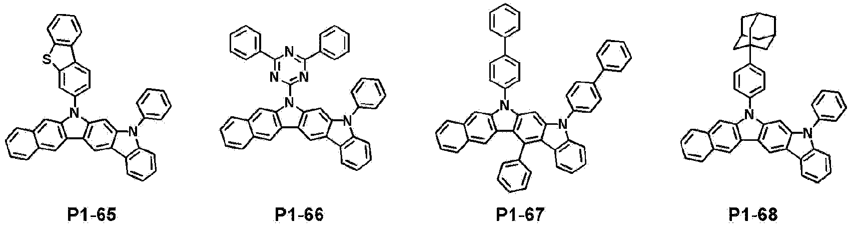

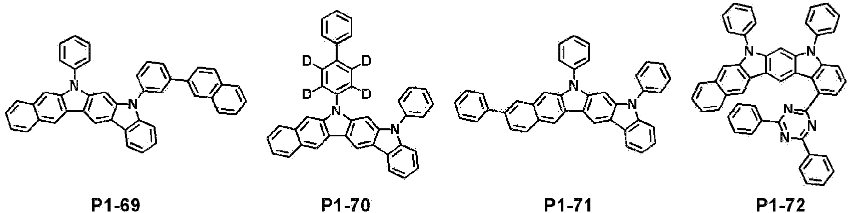

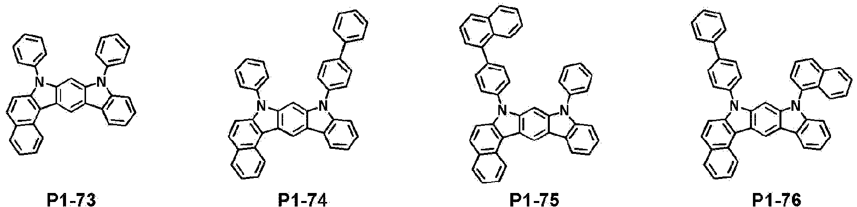

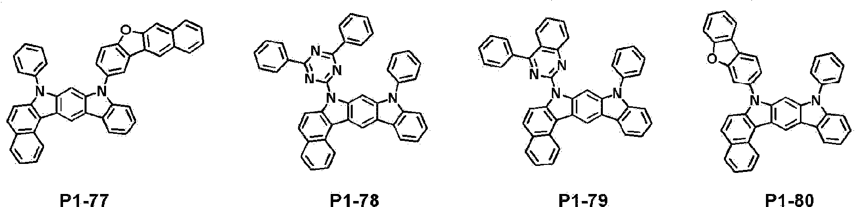

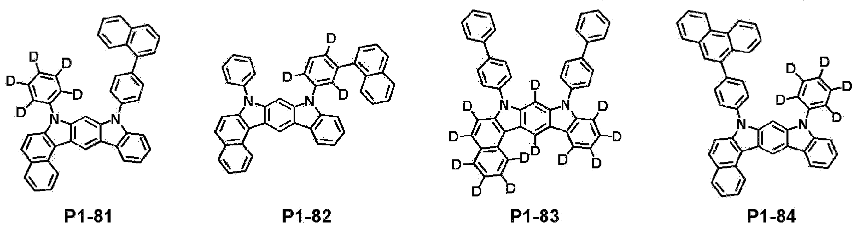

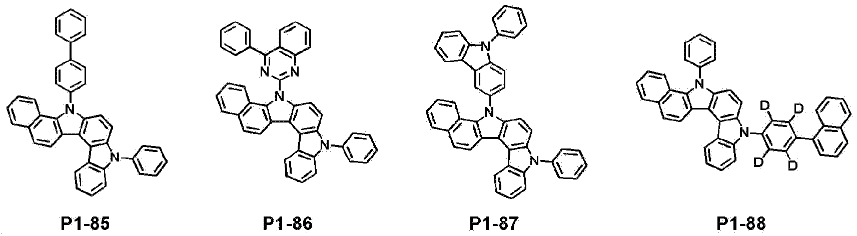

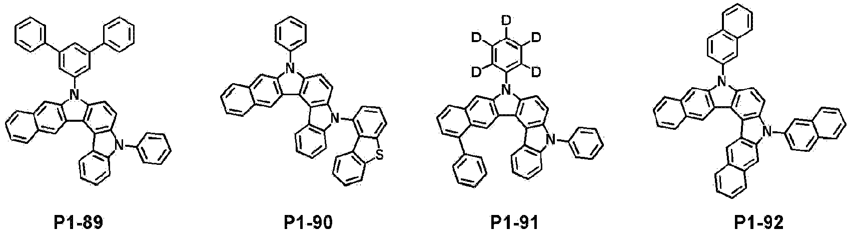

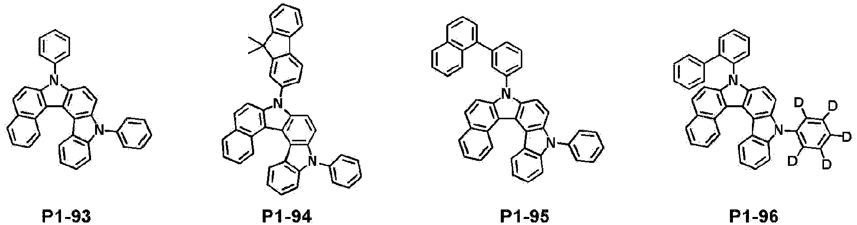

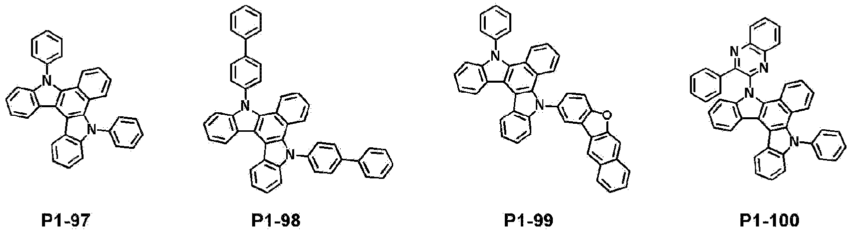

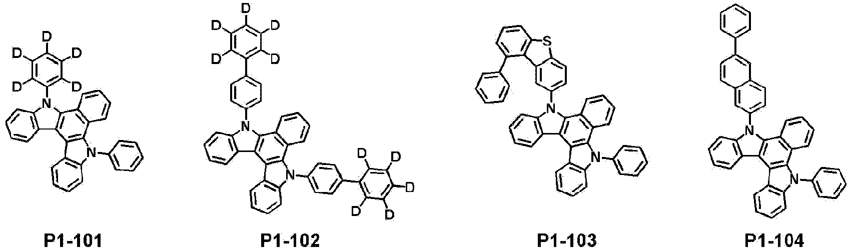

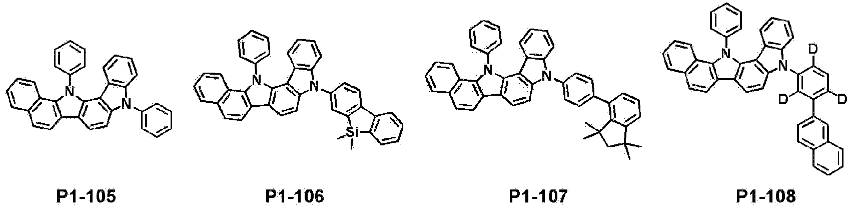

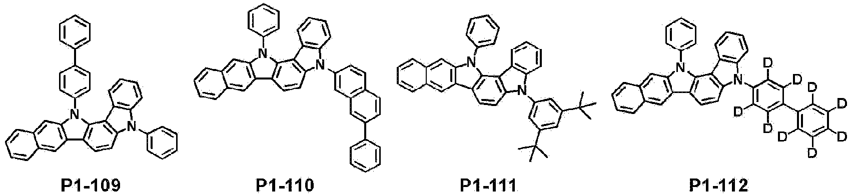

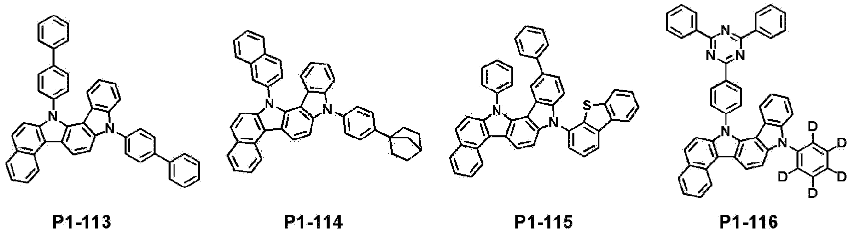

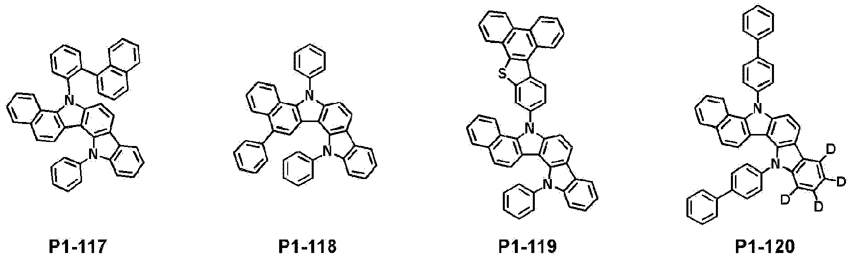

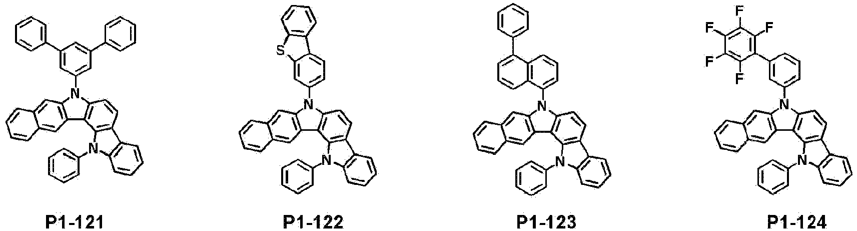

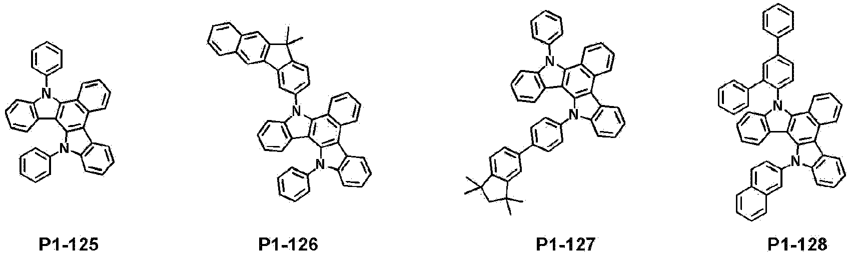

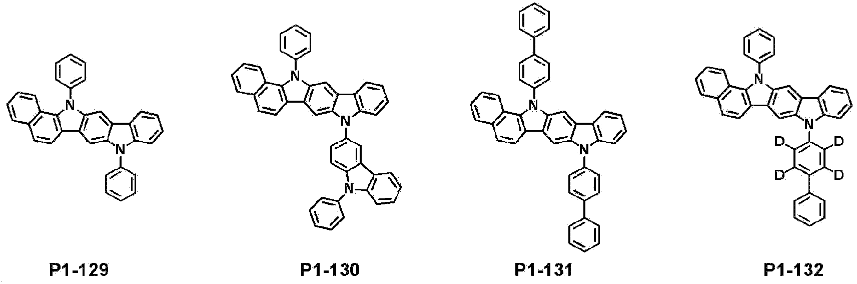

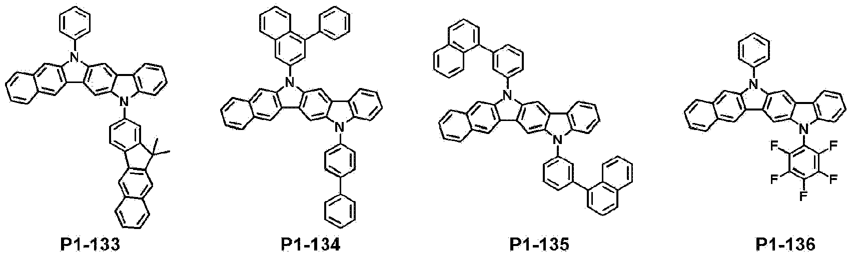

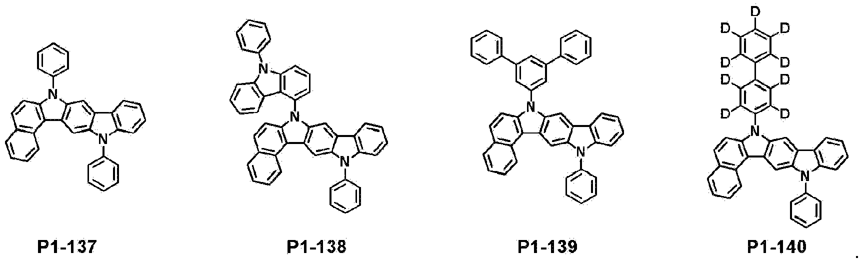

5. The organic electronic device of claim 2, wherein compound represented by Formula 1 is one of the following compounds:

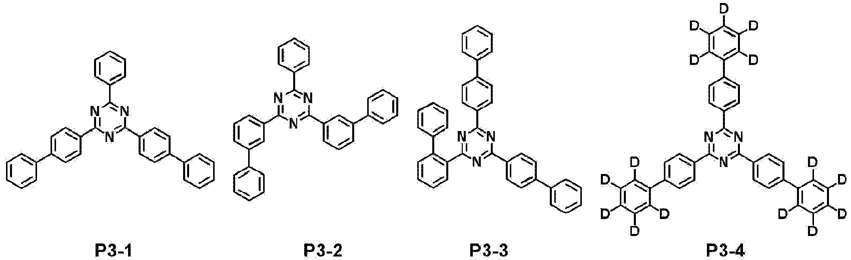

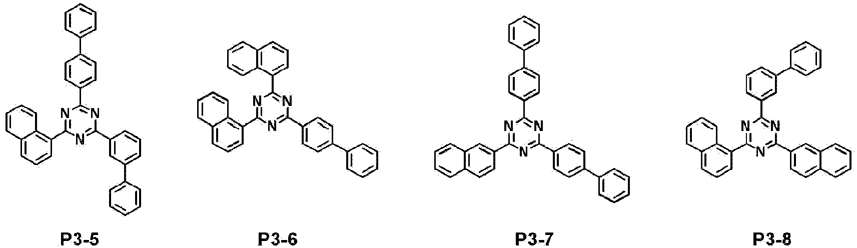

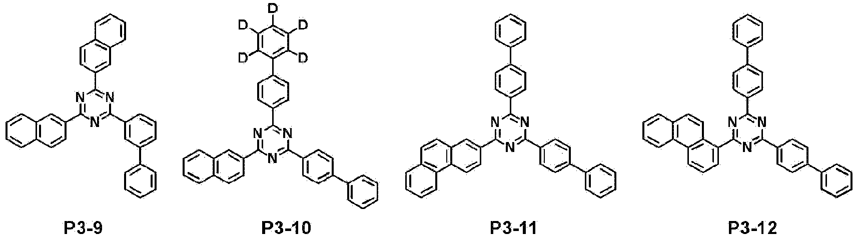

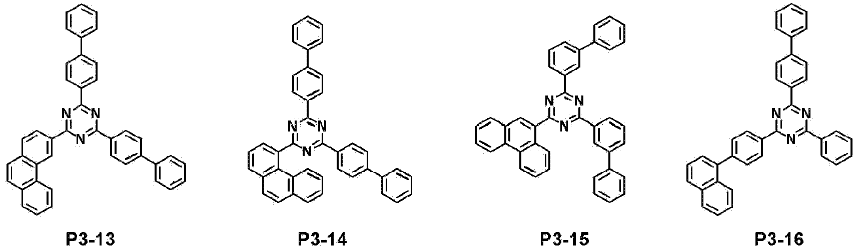

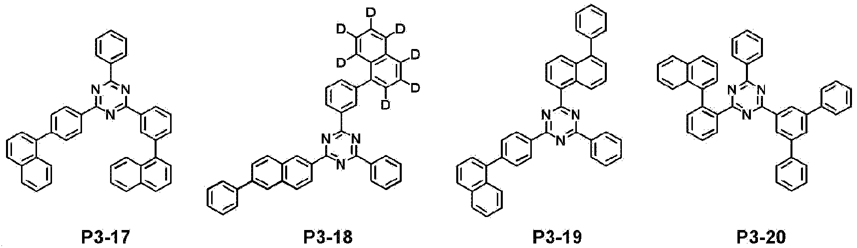

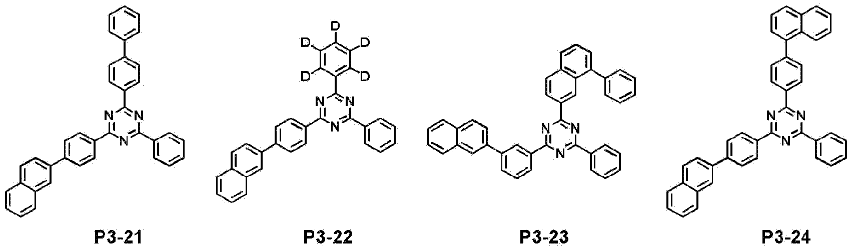

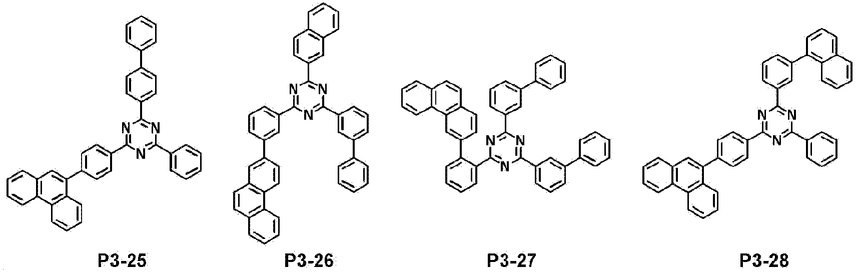

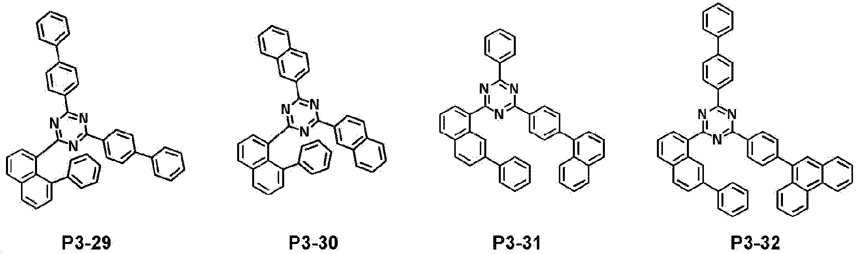

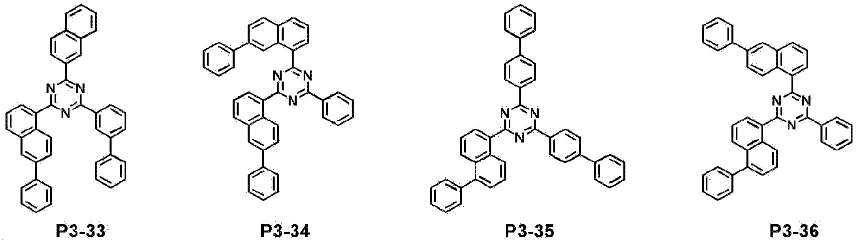

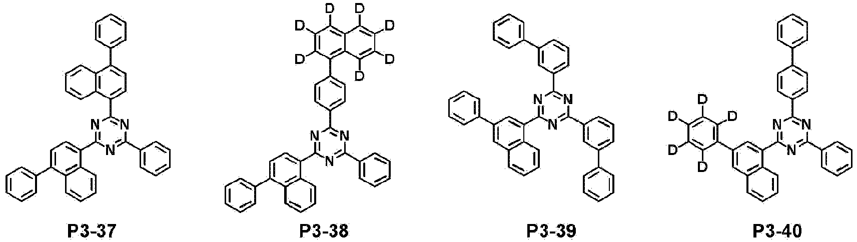

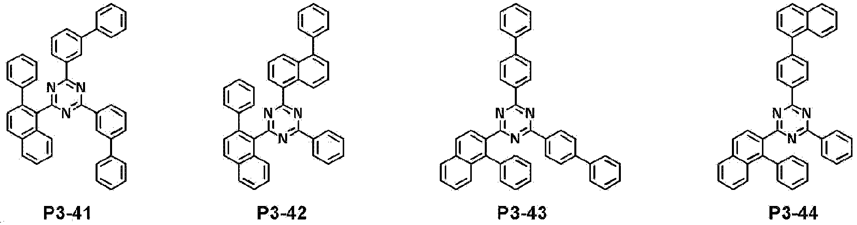

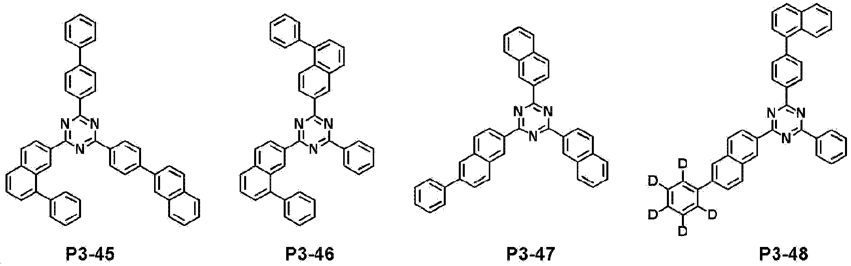

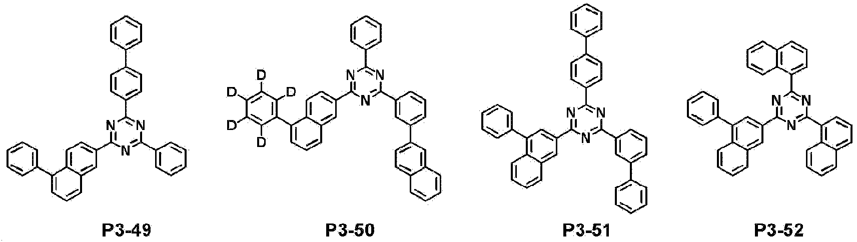

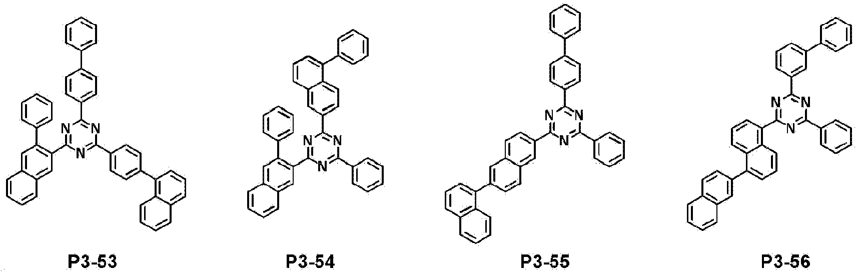

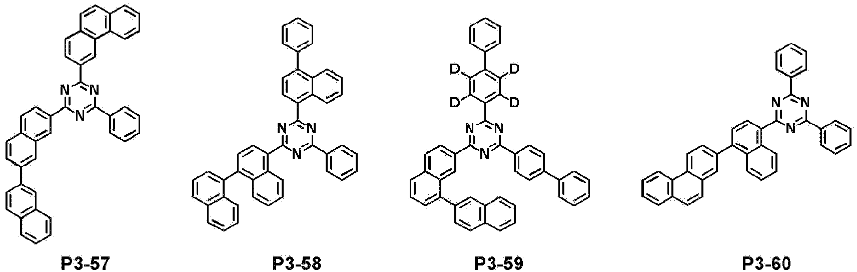

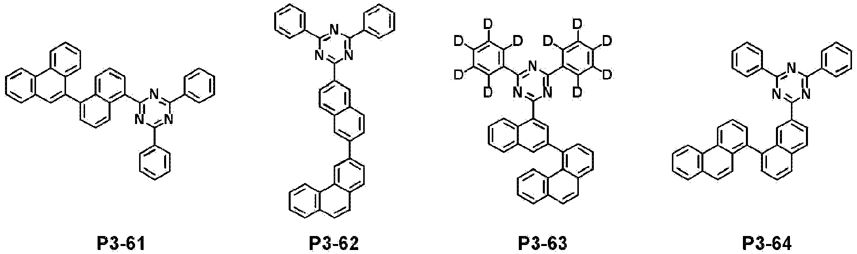

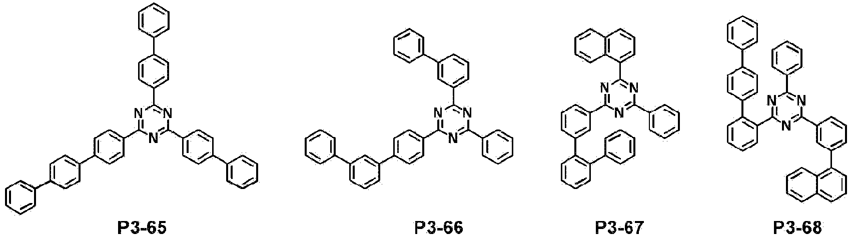

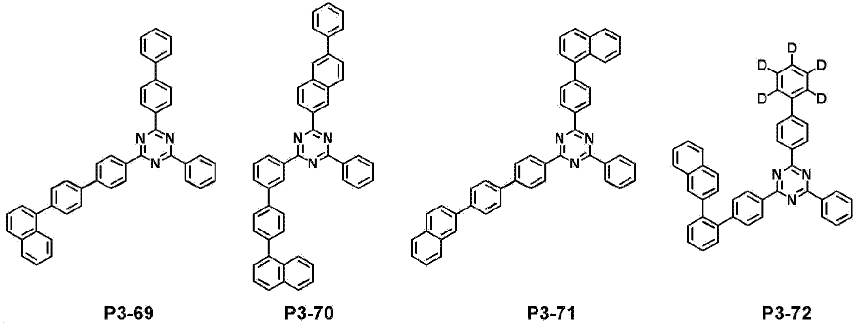

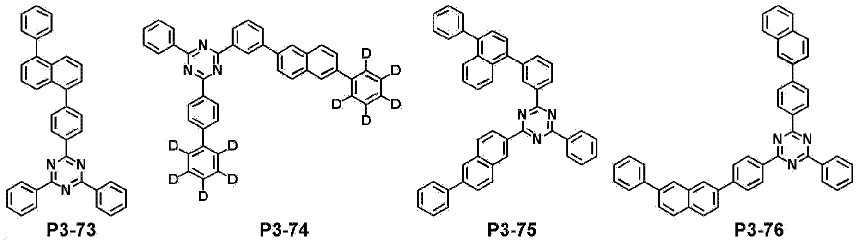

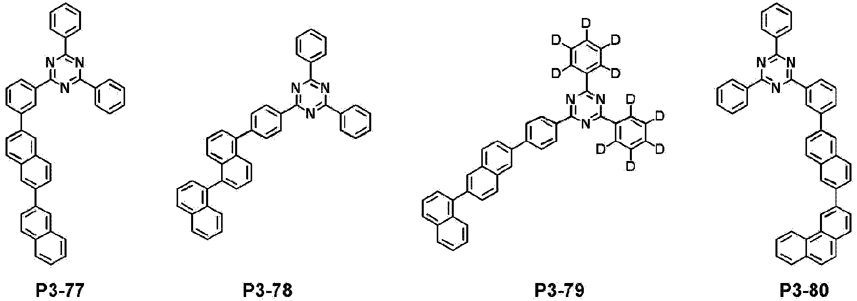

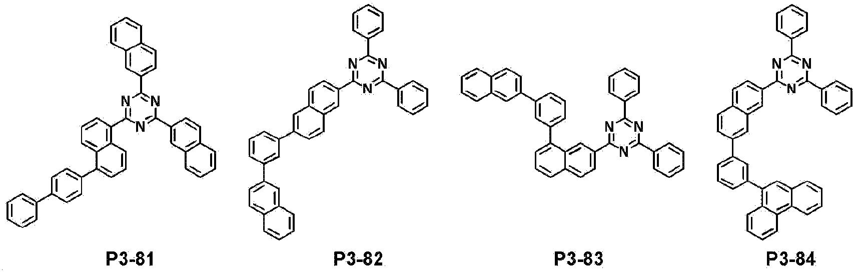

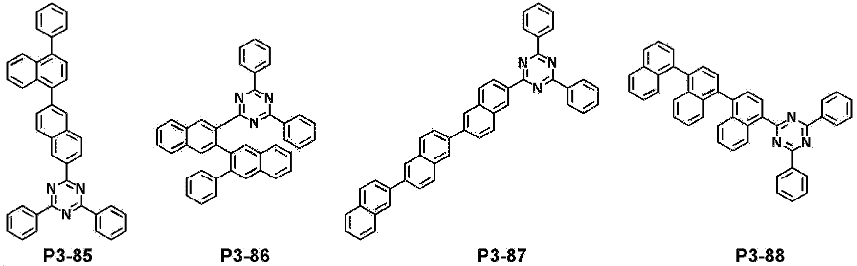

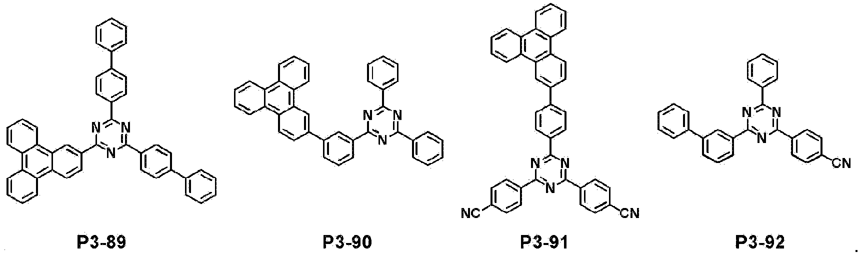

6. The organic electronic device of claim 1, wherein compound represented by Formula 3 is one of the following compounds:

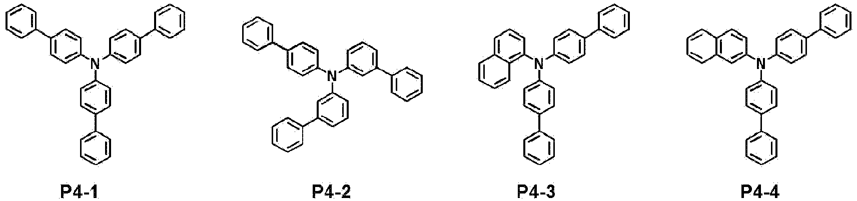

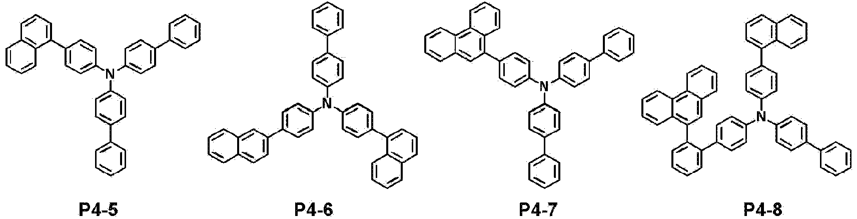

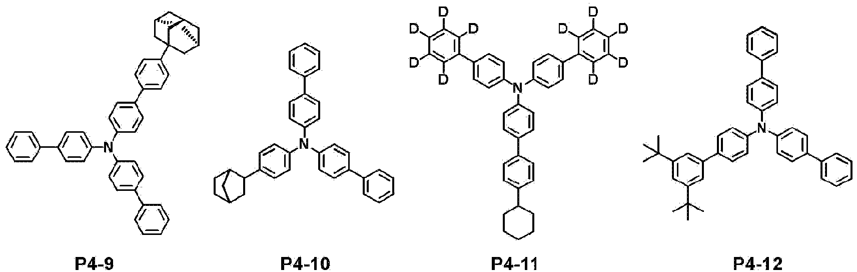

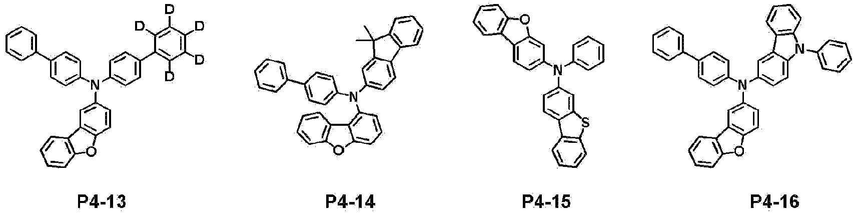

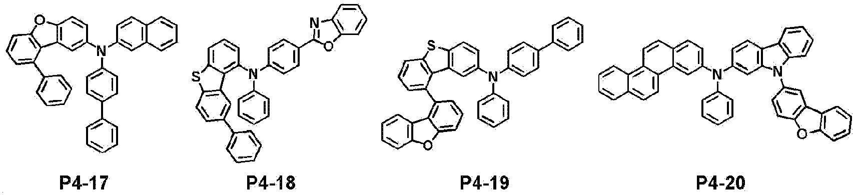

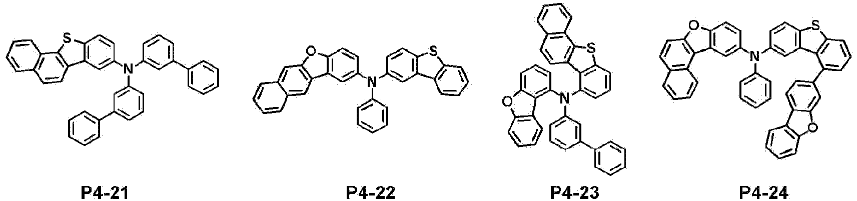

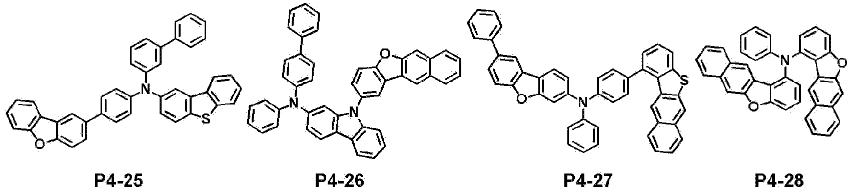

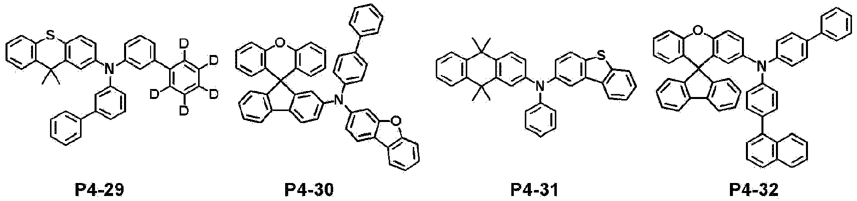

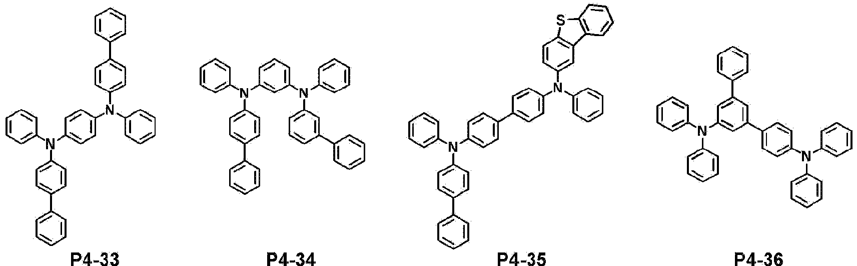

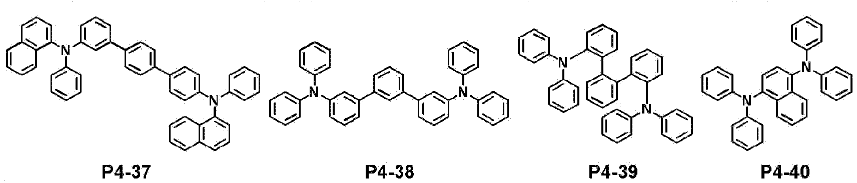

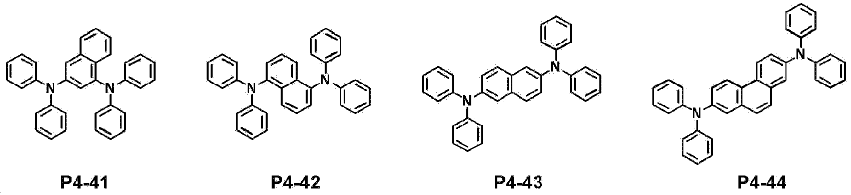

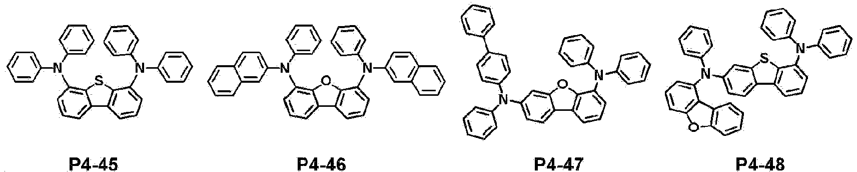

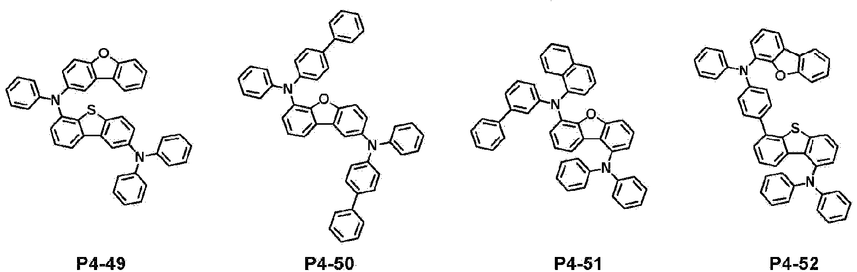

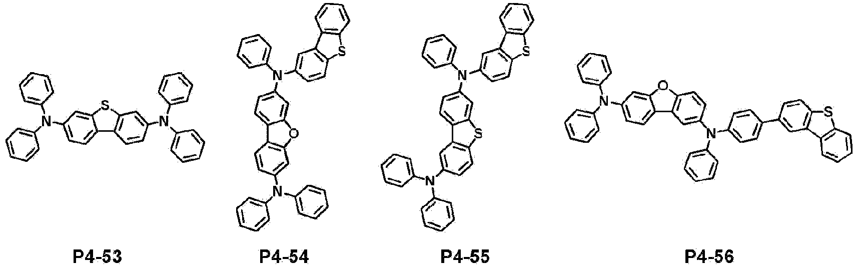

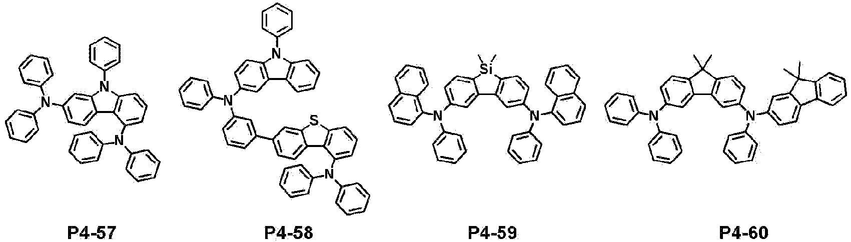

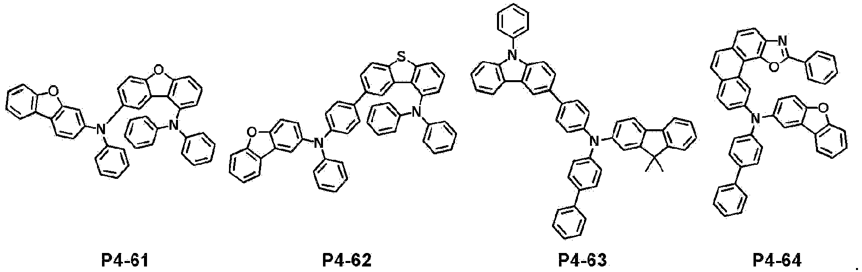

7. The organic electronic device of claim 1, wherein the organic electronic device further comprises a layer for improving luminous efficiency, and the layer for improving luminous efficiency is formed on one side of both sides of the anode or the cathode, wherein the one side is not facing the organic layer.

8. The organic electronic device of claim 1, wherein the organic layer comprises a hole transport region and an electron transport region.

9. The organic electronic device of claim 8, wherein the organic layer comprises two or more stacks comprising the hole transport region and the electron transport region.

10. The organic electronic device of claim 9, wherein the organic layer further comprises a charge generation layer formed between the two or more stacks.

11. An electronic apparatus including a display device and a control unit for driving the display device, wherein the display device includes the organic electronic device of claim 1.

12. The electronic device of claim 11, wherein the organic electronic device is selected from the group consisting of an organic electroluminescent element, an organic transistor, an element for monochromatic illumination and a quantum dot display.
